(19) Europäisches Patentamt / European Patent Office / Office européen des brevets

(11) **EP 2 555 261 A1**

(12) # EUROPEAN PATENT APPLICATION
published in accordance with Art. 153(4) EPC

(43) Date of publication:
06.02.2013 Bulletin 2013/06

(51) Int Cl.:
*H01L 33/50* (2010.01)

(21) Application number: **11762879.2**

(22) Date of filing: **30.03.2011**

(86) International application number:
**PCT/JP2011/057976**

(87) International publication number:
**WO 2011/122655 (06.10.2011 Gazette 2011/40)**

(84) Designated Contracting States:
**AL AT BE BG CH CY CZ DE DK EE ES FI FR GB GR HR HU IE IS IT LI LT LU LV MC MK MT NL NO PL PT RO RS SE SI SK SM TR**

(30) Priority: 27.04.2010 JP 2010102632
30.03.2010 JP 2010079349
30.03.2010 JP 2010079253

(71) Applicant: **Mitsubishi Chemical Corporation Chiyoda-ku Tokyo 100-8251 (JP)**

(72) Inventors:
- **KIJIMA, Naoto**
  **Tokyo 194-0031 (JP)**
- **KATSUMOTO, Tadahiro**
  **Aoba-ku, Yokohama-shi, Kanagawa 227-8502 (JP)**

- **YOYASU, Fumiko**
  **Aoba-ku, Yokohama-shi, Kanagawa 227-8502 (JP)**
- **KODAMA, Hiroya**
  **Aoba-ku, Yokohama-shi, Kanagawa 227-8502 (JP)**
- **YOKOO, Toshiaki**
  **Aoba-ku, Yokohama-shi, Kanagawa 227-8502 (JP)**
- **TAKEDA, Toru**
  **Tokyo 100-8251 (JP)**
- **ONAKA, Shuuji**
  **Tokyo 100-8251 (JP)**

(74) Representative: **HOFFMANN EITLE Patent- und Rechtsanwälte Arabellastrasse 4 81925 München (DE)**

(54) ## LIGHT-EMITTING DEVICE

(57)     An object of the present invention is to provide a light emitting device exhibiting a superior emission efficiency which enables easy adjustment of an emission spectrum.

The above object is achieved by a light emitting device comprising a semiconductor light emitting element and a phosphor layer, which has an area A and an area B of different emission spectra, and in which a plurality of phosphor portions are disposed on a plane such that identical phosphor portions do not adjoin one another, and the surface area occupied by specific phosphor portions in the phosphor layer is different in area A and area B.

Fig. 1－1

EP 2 555 261 A1

Fig. 1−2

Fig. 1−3

Fig. 1−4

Fig. 1−5

**Description**

TECHNICAL FIELD

The present invention relates to a light emitting device and, more particularly, to a light emitting device exhibiting a superior emission efficiency which enables easy adjustment of an emission spectrum.

BACKGROUND ART

A light emitting device which uses a semiconductor light emitting element is relatively costly in comparison with a fluorescent lamp, and changing the color temperature of the emission color of a light emitting device according to the environment or season, just as a fluorescent lamp is replaced in summer and winter, is not economically viable. It is desirable to be able to change the color temperature, where necessary, of a single light emitting device.

In order to meet this requirement, Japanese Patent Application Publication No. 2009-245712 discloses a light emitting device in which phosphor of different emission colors is applied to a central portion and outer periphery of a transparent disk, in which the irradiation angle is changed by modifying the distance between the semiconductor light emitting element and the phosphor applied portions, and in which the color temperature can be modified by changing the size of the irradiation part. However, such a light emitting device has low light rendering properties, forming white light from the blue light which is emitted by the light emitting element and yellow light which is emitted by the phosphor through excitation with the light which is emitted from the light emitting element.

Patent Document 1: Japanese Patent Application Laid-open No. 2009-245712

However, there is a problem in that, in the light emitting device according to Japanese Patent Application Publication No. 2009-245712, in a case where a plurality of phosphor of different emission colors is contained mixed in the phosphor layer in order to raise the color rendering properties, a phenomenon arises whereby phosphor of another type absorbs the fluorescent light emitted by a certain type of phosphor, that is, cascade excitation arises, and the light emission efficiency of the phosphor layer is low (first problem).

Further, in the light emitting device according to Japanese Patent Application Publication No. 2009-245712, the way in which the distance between the phosphor layer and the semiconductor light emitting device is configured is not defined, and when there is an inadequate separation distance between the phosphor layer and the semiconductor light emitting element, an increasingly high light output from the light emitting element leads not only to an increase in the temperature of the light emitting element but also an increase in the temperature of the phosphor due to the heat arising from the loss when phosphor color conversion takes place and, as a result, there is a loss in the light emission efficiency of the semiconductor light emitting element and phosphor layer (second problem).

Furthermore, in a case where a light emitting device is configured by using a semiconductor light emitting element which emits light in the ultraviolet to near-ultraviolet range and phosphor which emits visible light which is excited by the light from the semiconductor light emitting element, there is a problem in that, when a high proportion of the light from the semiconductor light emitting element is light which is emitted as is without conversion to visible light in the phosphor layer, the light emission efficiency of the phosphor layer is low (third problem).

In addition, in a case where a light emitting device is configured by using a semiconductor light emitting element which emits light in the ultraviolet to near-ultraviolet range and phosphor which emits visible light which is excited by the light from the semiconductor light emitting element, there is a problem in that, when a high proportion of the visible light emitted from the phosphor layer is light which is emitted toward the semiconductor light emitting element, the light emission efficiency of the phosphor layer is low (fourth problem).

The present inventors discovered, based on extensive research aimed at solving the first problem above, that the problem could be solved with a light emitting device which is configured having a phosphor layer having at least an area A and an area B of different emission spectra and in which a plurality of phosphor portions are arranged in planar fashion, and by adjustably configuring the proportion of light irradiated onto area A and area B from the semiconductor light emission device, and thus completed the invention.

The present invention is a light emitting device which is configured comprising a semiconductor light emitting element and a phosphor layer which has an area A and an area B with different emission spectra, wherein

(i) the semiconductor light emitting element emits light of a wavelength of 350 nm or more and 520 nm or less,
(ii) the area A includes two or more 1Ath phosphor portions and two or more 2Ath phosphor portions, and the area B includes two or more 1Bth phosphor portions and two or more 2Bth phosphor portions,
(iii) the 1Ath phosphor portions and the 2Ath phosphor portions which adjoin one another in the area A are disposed in a direction perpendicular to the thickness direction of the phosphor layer at the interface between the 1Ath and 2Ath phosphor portions, and the 1Ath phosphor portions and the 2Ath phosphor portions which adjoin one another in the area B are disposed in a direction perpendicular to the thickness direction of the phosphor layer at the interface between the 1Ath and 2Ath phosphor portions,

(iv) the 1Ath phosphor portions include a 1Ath phosphor which is able to emit light having a longer wavelength light than the light emitted by the semiconductor light emitting element, by being excited by the light emitted by the semiconductor light emitting element,

(v) the 2Ath phosphor portions include a 2Ath phosphor which is able to emit light having a longer wavelength light than the light emitted by the first phosphor, by being excited by the light emitted by the semiconductor light emitting element,

(vi) the 1Bth phosphor portions include a 1Bth phosphor which is able to emit light having a longer wavelength light than the light emitted by the semiconductor light emitting element, by being excited by the light emitted by the semiconductor light emitting element,

(vii) the 2Bth phosphor portions include a 2Bth phosphor which is able to emit light having a longer wavelength light than the light emitted by the semiconductor light emitting element, by being excited by the light emitted by the semiconductor light emitting element, and

(viii) a proportion of the light which is irradiated onto area A and area B from the semiconductor light emitting element can be adjusted.

Furthermore, it is preferable that the proportion of the light which is irradiated onto area A and area B from the semiconductor light emitting element can be adjusted by moving the phosphor layer or the semiconductor light emitting element in order to change relative positions of the phosphor layer and the semiconductor light emitting element.

Moreover, it is preferable that the phosphor layer fulfill the condition of formula [1] below when, at a light emission-side face of the light emitting device, a sum total of the surface area occupied by the 1Ath phosphor portions of area A is $S_{A1}$, a sum total of the surface area occupied by the 2Ath phosphor portions of area A is $S_{A2}$, a sum total of the surface area occupied by the 1Bth phosphor portions of area B is $S_{B1}$, and a sum total of the surface area occupied by the 2Bth phosphor portions of area B is $S_{B2}$.

$$S_{A2}/S_{A1} \neq S_{B2}/S_{B1} \ldots [1]$$

Further, it is preferable that the phosphor layer fulfill the condition of formula [2] below when a sum total of the thickness of the 1Ath phosphor portions of area A is $T_{A1}$, a sum total of the thickness of the 2Ath phosphor portions of area A is $T_{A2}$, a sum total of the thickness of the 1Bth phosphor portions of area B is $T_{B1}$, and the sum total of the thickness of the 1Bth phosphor portions of area B is $T_{B2}$.

$$T_{A2}/T_{A1} \neq T_{B2}/T_{B1} \ldots [2]$$

In the phosphor layer, it is preferable that the 1Ath phosphor be of a different type from the 1Bth phosphor and/or that the 2Ath phosphor be of a different type from the 2Bth phosphor.

It is preferable that a proportion of the surface area of a part of the phosphor layer where there is a plurality of types of phosphor in the thickness direction of the phosphor layer be between 0% and 20% of the light emission surface area of the light emitting device.

It is preferable that the phosphor layer comprise a light shielding portion and that the light shielding portion be disposed so as to prevent light, which is emitted from the 1Ath phosphor portion between the 1Ath phosphor portion and the 2Ath phosphor portion, from entering the 2Ath phosphor portion and/or disposed so as to prevent light, which is emitted from the 1Bth phosphor portion between the 1Bth phosphor portion and the 2Bth phosphor portion, from entering the 2Bth phosphor portion.

It is preferable that an area X be further provided between the area A and the area B, wherein

(i) the area X has two or more 1Xth phosphor portions and two or more 2Xth phosphor portions,

(ii) in the area X, the 1Xth phosphor portions and the 2Xth phosphor portions which adjoin each other are disposed in a direction perpendicular to the thickness direction of the phosphor layer at the interface between the adjoining 1Xth phosphor portions and 2Xth phosphor portions,

(iii) the 1Xth phosphor portions include a 1Xth phosphor which is able to emit light having a longer wavelength light than the light emitted by the semiconductor light emitting element, by being excited by the light emitted by the semiconductor light emitting element,

(iv) the 2Xth phosphor portions include a 2Xth phosphor which is able to emit light having a longer wavelength light than the light emitted by the first phosphor, by being excited by the light emitted by the semiconductor light emitting element, and

(v) conditions of formulae [3] and [4] below are preferably satisfied when a sum total of the surface area occupied by the 1Xth phosphor portions in the area X is $S_{X1}$, and a sum total of the surface area occupied by the 2Xth phosphor portions in the area X is $S_{X2}$.

$$S_{A2}/S_{A1} \neq S_{X2}/S_{X1} \ldots [3]$$

$$S_{B2}/S_{B1} \neq S_{X2}/S_{X1} \ldots [4]$$

The light emitting device is preferably configured comprising a phosphor layer disposed such that, by adjusting a proportion of light which is irradiated onto the area A and the area B from the semiconductor light emitting element, the light emitted by the light emitting device can be adjusted to an optional chromaticity which is located on a straight line, in the chromaticity diagram, linking a chromaticity A $(x_A, y_A)$ of the light emitted from the area A to a chromaticity X $(x_X, y_X)$ of the light emitted from the area X, or adjusted to an optional chromaticity which is located on a straight line linking a chromaticity B $(x_B, y_B)$ of the light emitted from the area B to the chromaticity X $(x_X, y_X)$ of the light emitted from the area X.

It is preferable that the chromaticity X $(x_X, y_X)$ be located on a straight line linking the chromaticity A $(x_A, y_A)$ to the chromaticity B $(x_B, y_B)$ .

Further, it is preferable that the chromaticity X $(x_X, y_X)$ not be located on a straight line linking the chromaticity A $(x_A, y_A)$ to the chromaticity B $(x_B, y_B)$.

The light emitting device is preferably configured having a phosphor layer which is disposed such that, by adjusting a proportion of light which is irradiated onto the area A and the area B from the semiconductor light emitting element, the light emitted by the light emitting device can be adjusted to an optional chromaticity which is located on an optional curve, in the chromaticity diagram, linking a chromaticity A $(x_A, y_A)$ of the light emitted from the area A, a chromaticity X $(x_X, Y_X)$ of the light emitted from the area X, and a chromaticity B $(x_B, y_B)$ of the light emitted from the area B.

The light emitting device is preferably configured such that, by adjusting the proportion of the light which is irradiated onto the area A and the area B from the semiconductor light emitting element, the light emitting device is able to continuously adjust the chromaticity of the light which is emitted by the light emitting device within a range in which a deviation duv from a black body radiation curve is $-0.02 \leq duv \leq 0.02$.

The light emitting device is preferably configured such that the chromaticity of the light emitted by the light emitting device can be continuously adjusted along a black body radiation curve by moving the phosphor layer or the semiconductor light emitting element in a direction perpendicular to the thickness direction of the phosphor layer.

The light emitting device is preferably configured such that a color temperature of the color emitted by the light emitting device can be adjusted from 2800 K to 6500 K by adjusting the proportion of light irradiated onto the area A and the area B from the semiconductor light emitting element.

Further, in order to solve the second problem, the light emitting device is preferably configured such that a distance between the semiconductor light emitting element and the phosphor layer is 1 mm or more and 500 mm or less.

Furthermore, in order to solve the third problem, the light emitting device preferably comprises, on the light emission side of the light emitting device of the phosphor layer, a bandpass filter which reflects at least a portion of the light emitted by the semiconductor light emitting element and transmits at least a portion of the light emitted by the phosphor.

Further, in order to solve the fourth problem, the light emitting device preferably comprises, on the semiconductor light emitting element side of the phosphor layer, a bandpass filter which transmits at least a portion of the light emitted by the semiconductor light emitting element and reflects at least a portion of the light emitted by the phosphor.

The light emitting device preferably comprises:

a substrate on which the semiconductor light emitting element is disposed; and
a cylindrical housing member which houses the substrate,
wherein the phosphor layer is preferably disposed on at least a portion of the housing member;
wherein the housing member is preferably provided turnably about the center axis thereof in a state where the substrate is immobile,
wherein, in the phosphor layer, the area A and the area B are preferably disposed in different positions in a peripheral direction of the housing member, and

wherein the proportion of light irradiated onto the area A and the area B from the semiconductor light emitting element can preferably be adjusted by adjusting a relative turn position of the housing member relative to the substrate.

The area A and the area B preferably divide the phosphor layer in a peripheral direction and are preferably disposed as areas along a center axis direction of the housing member.

The phosphor layer is preferably disposed over the whole circumference of the housing member.

The semiconductor light emitting element is preferably disposed on both faces of the substrate so as to hold the substrate from both sides, and, in the phosphor layer, phosphor layers having mutually identical emission spectra are preferably disposed in symmetrical areas, with the center axis of the housing member between both sides of the symmetrical areas.

A reflective member is preferably provided on the outside of the housing member such that the light emitted from the housing member which corresponds to the semiconductor light emitting element disposed on one face of the substrate is reflected toward the emission area of the emitted light which corresponds to the semiconductor light emitting element disposed on the other face of the substrate.

The semiconductor light emitting element is preferably disposed only on one of the faces of the substrate, and, in a housing space of the housing member, a heat radiation member for radiating the heat of the semiconductor light emitting element is disposed in thermal contact with the other face of the substrate, in a space which the other face of the substrate faces.

The housing member preferably has a cylindrical shape and, in a case where the semiconductor light emitting element disposed on the substrate is disposed eccentric to the center axis of the housing member, the semiconductor light emitting element is provided to reduce an angle formed between a normal direction of a virtual ground plane at a point of intersection between the irradiation center direction of the light emitted by the semiconductor light emitting element and the phosphor layer, and the irradiation center direction.

On the substrate, a cross-section orthogonal to the center axis of the housing member preferably has a bent plate shape or arc shape.

SUMMARY OF THE INVENTION

The present invention makes it possible to provide a light emitting device of a superior emission efficiency which enables straightforward adjustment of an emission spectrum. Further, the present invention makes it possible to provide a light emitting device which obviates the need for complex power control and which enables straightforward color temperature adjustment.

BRIEF DESCRIPTION OF THE DRAWINGS

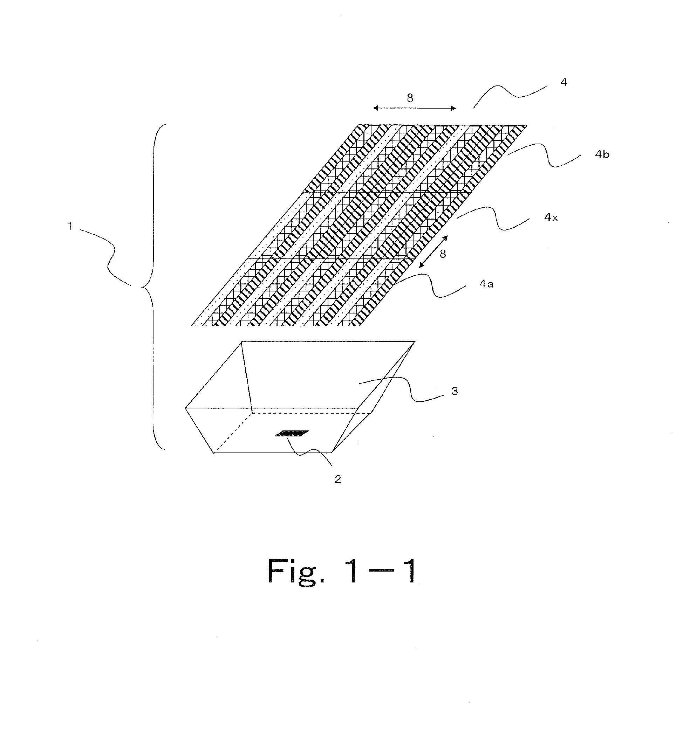

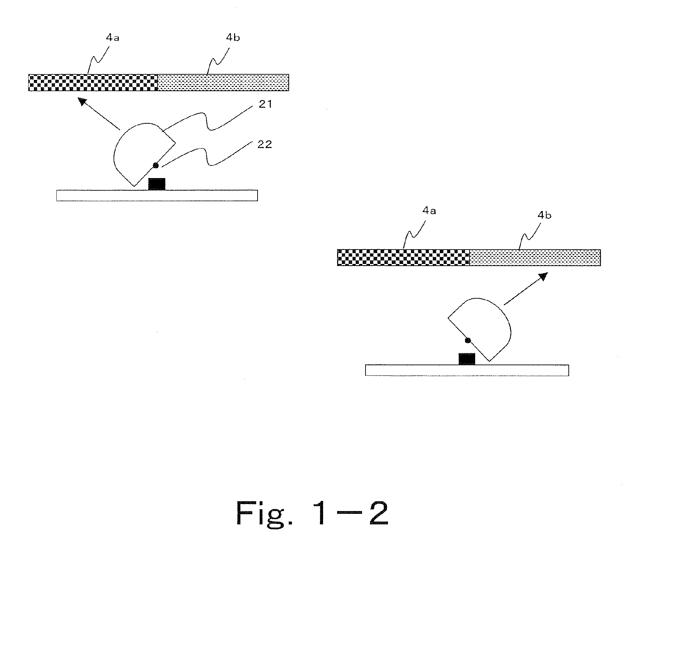

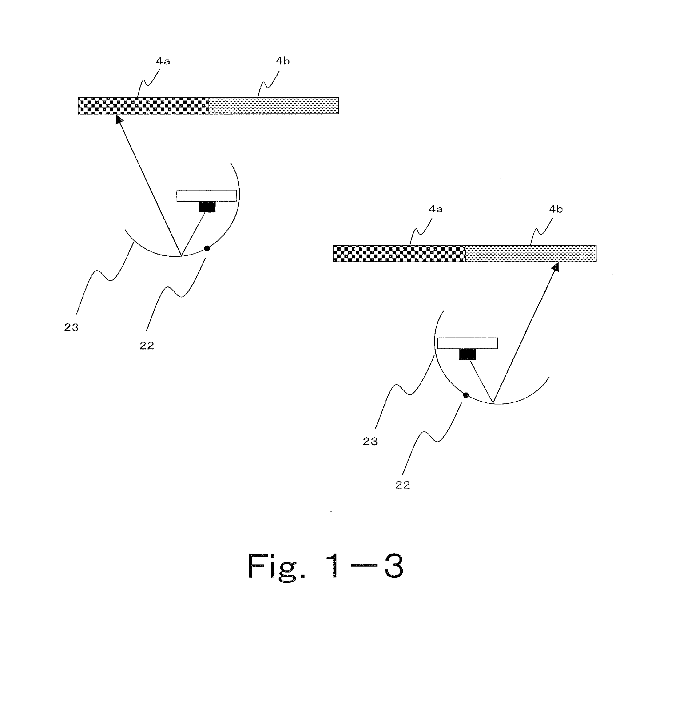

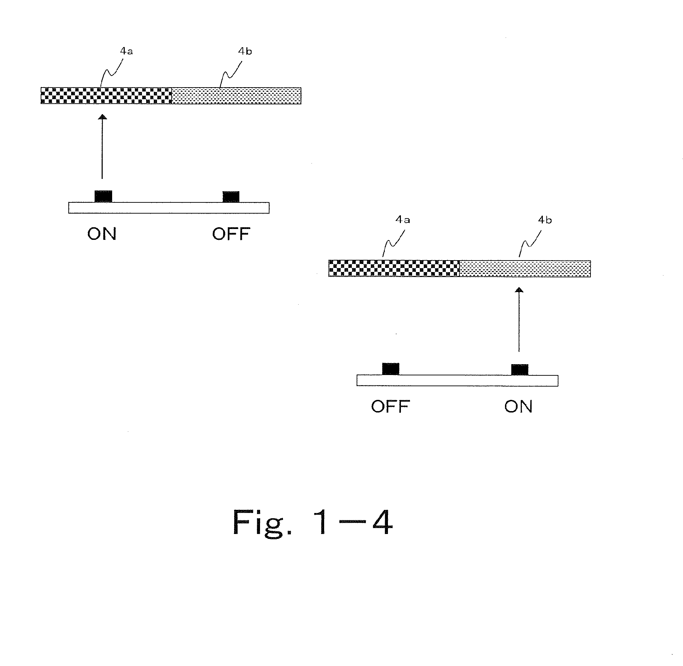

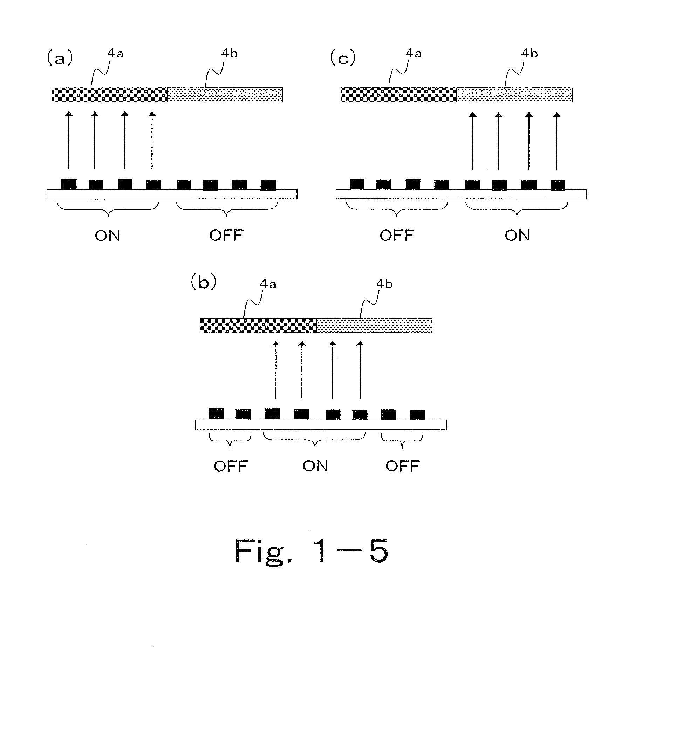

Fig. 1-1 is a conceptual diagram showing an embodiment of a light emitting device of the present invention;
Fig. 1-2 is a conceptual diagram showing an embodiment of the light emitting device of the present invention;
Fig. 1-3 is a conceptual diagram showing an embodiment of the light emitting device of the present invention;
Fig. 1-4 is a conceptual diagram showing an embodiment of the light emitting device of the present invention;
Fig. 1-5 is a conceptual diagram showing an embodiment of the light emitting device of the present invention;
Fig. 2 is a conceptual diagram showing a phosphor layer of the present invention;
Fig. 3 is a conceptual diagram showing an embodiment of the light emitting device of the present invention;
Fig. 4 is a conceptual diagram showing a plurality of embodiments of the light emitting device of the present invention;
Fig. 5-1 is an enlarged view of an interface between phosphor portions present in the phosphor layer of the light emitting device of the present invention;
Fig. 5-2 is an enlarged view of an interface between phosphor portions present in the phosphor layer of the light emitting device of the present invention;
Fig. 5-3 is an enlarged view of an interface between phosphor portions present in the phosphor layer of the light emitting device of the present invention;
Fig. 6 shows a plurality of examples of phosphor layer patterns used in the light emitting device of the present invention;
Fig. 7 shows a plurality of examples of phosphor layer patterns used in the light emitting device of the present invention;
Fig. 8 shows a plurality of examples of phosphor layer patterns used in the light emitting device of the present invention;
Fig. 9 shows a plurality of examples of phosphor layer patterns used in the light emitting device of the present invention;
Fig. 10 shows one example of the pattern of a phosphor layer pattern used in the light emitting device of the present invention;
Fig. 11 shows a plurality of examples of phosphor layer patterns used in the light emitting device of the present invention;

Fig. 12 shows a plurality of examples of phosphor layer patterns used in the light emitting device of the present invention;

Fig. 13-1 is a conceptual diagram of an embodiment of the light emitting device of the present invention;

Fig. 13-2 shows a plurality of examples of phosphor layer patterns used in the light emitting device of the present invention;

Fig. 14 is a chromaticity diagram showing chromaticity of light emitted by the light emitting device of the present invention;

Fig. 15 shows a plurality of examples of phosphor layer patterns used in the light emitting device of the present invention and a chromaticity diagram showing the chromaticity which can be realized by the phosphor layer patterns;

Fig. 16 is a perspective diagram which schematically shows the overall configuration of the light emitting device according to a first embodiment;

Fig. 17 schematically shows an axis orthogonal cross section shown in Fig. 16;

Fig. 18 is a development view of the housing member according to the first embodiment;

Fig. 19 illustrates operating states of the housing member according to the first embodiment;

Fig. 20 is a development view illustrating a modification of the housing member according to the first embodiment;

Fig. 21-1 illustrates a modification of the housing member according to the first embodiment;

Fig. 21-2 illustrates a modification of the housing member according to the first embodiment;

Fig. 21-3 illustrates a modification of the housing member according to the first embodiment;

Fig. 21-4 illustrates a modification of the housing member according to the first embodiment;

Fig. 21-5 illustrates a modification of the housing member according to the first embodiment;

Fig. 22 illustrates another modification of the light emitting device according to the first embodiment;

Fig. 23 schematically shows an axis orthogonal cross section of a light emitting device according to a second embodiment;

Fig. 24 illustrates a modification according to the second embodiment;

Fig. 25-1 schematically shows an axis orthogonal cross section of a light emitting device according to a third embodiment;

Fig. 25-2 schematically shows an axis orthogonal cross section of the light emitting device according to the third embodiment;

Fig. 26 schematically shows an axis orthogonal cross section of the light emitting device according to a fourth embodiment;

Fig. 27 illustrates a modification of the light emitting device according to the fourth embodiment;

Fig. 28 schematically shows an axis orthogonal cross section of a light emitting device according to a fifth embodiment;

Fig. 29 schematically shows an axis orthogonal cross section of the light emitting device according to the fifth embodiment; and

Fig. 30 is a diagram showing the results of measured correlated color temperatures and chromaticity coordinates for light emitting devices 1 to 9 of practical examples.

DESCRIPTION OF THE PREFERRED EMBODIMENTS

The light emitting device of the present invention is a light emitting device which comprises a semiconductor light emitting element and a phosphor layer comprising an area A and an area B of different emission spectra. Further, the area A comprises two or more 1Ath phosphor portions and two or more 2Ath phosphor portions, and the area B comprises two or more 1Bth phosphor portions and two or more 2Bth phosphor portions. The 1Ath phosphor portions comprise a 1Ath phosphor and the 2Ath phosphor portions comprise a 2Ath phosphor, and the 1Bth phosphor portions comprise a 1Bth phosphor and the 2Bth phosphor portions comprise a 2Bth phosphor. Further, a light emitting device normally comprises a package or substrate for holding a semiconductor light emitting element.

<1.1. Configuration of Phosphor layer>

The phosphor layer of the present invention comprises an area A and an area B of different emission spectra, and each area comprises two or more first phosphor portions and second phosphor portions. More specifically, the area A comprises two or more 1Ath phosphor portions and two or more 2Ath phosphor portions, and the area B comprises two or more 1Bth phosphor portions and two or more 2Bth phosphor portions.

The 1Ath phosphor portions comprise the 1Ath phosphor, and the 1Ath phosphor is excited by the light emitted by the semiconductor light emitting element and is thus able to emit light which contains a longer wavelength light than the light emitted by the semiconductor light emitting element.

The 1Bth phosphor portions comprise the 1Bth phosphor, and the 1Bth phosphor is excited by the light emitted by the semiconductor light emitting element and is thus able to emit light which contains a longer wavelength light than the light emitted by the semiconductor light emitting element.

Further, the 2Ath phosphor portions comprise the 2Ath phosphor, and the 2Ath phosphor is excited by the light emitted by the semiconductor light emitting element and is thus able to emit light which contains a longer wavelength light than the light emitted by the first phosphor.

The 2Bth phosphor portions comprise the 2Bth phosphor, and the 2Bth phosphor is excited by the light emitted by the semiconductor light emitting element and is thus able to emit light which contains a longer wavelength light than the light emitted by the first phosphor.

Furthermore, the area A and/or area B may comprise a third phosphor portion which comprises a third phosphor and a fourth phosphor portion which comprises a fourth phosphor which are able to emit light containing light of a different wavelength from the 1Ath phosphor, 1Bth phosphor, 2Ath phosphor, and 2Bth phosphor.

Note that the 1Ath phosphor which is contained in the 1Ath phosphor portion and the 1Bth phosphor which is contained in the 1Bth phosphor portion may be either phosphor of the same type or phosphor of different types. Further, similarly, the 2Ath phosphor which is contained in the 2Ath phosphor portion and the 2Bth phosphor which is contained in the 2Bth phosphor portion may be either phosphor of the same type or phosphor of different types. Hereinafter, the 1Ath phosphor portions and 1Bth phosphor portions are sometimes referred to collectively as the first phosphor portions, and the 2Ath phosphor portions and 2Bth phosphor portions are sometimes referred to collectively as the second phosphor portions. Further, the 1Ath phosphor and 1Bth phosphor are sometimes referred to collectively as the first phosphor, and the 2Ath phosphor and 2Bth phosphor are sometimes referred to collectively as the second phosphor.

Note that, as long as the effects of the invention are exhibited, the first phosphor portions may also comprise the second phosphor, but that the first phosphor portions preferably do not comprise the second phosphor. Likewise, as long as the effects of the invention are exhibited, the second phosphor portions may also comprise the first phosphor, but that the second phosphor portions preferably do not comprise the first phosphor.

The phosphor layers which are used in the light emitting device of the present invention are configured such that, in each area, the foregoing adjoining first phosphor portions and second phosphor portions are formed as separate members in a direction perpendicular to the thickness direction of the phosphor layer at the interface between the first and second phosphor portions. More specifically, in area A, the adjoining 1Ath phosphor portion and 2Ath phosphor portion are formed as separate members in a direction perpendicular to the thickness direction of the phosphor layer at the interface between the 1Ath and 2Ath phosphor portions. Note that "adjoining" indicates the positional relationship between the phosphor portions. Even when a light-shielding portion, referred to subsequently, or the like is disposed between the 1Ath phosphor portion and the 2Ath phosphor portion, the phosphor portions are "adjoining." Further, in cases where a member whereon a phosphor layer is disposed is curved, the phosphor portions are taken to be arranged in a " perpendicular direction at the interface" as long as they are perpendicular at the interface, though some of them are not disposed in a perpendicular direction at points other than at the interface. Note that, in a case where a light-shielding portion or the like is disposed between the phosphor portions and a member whereon the phosphor layer is disposed is curved, the phosphor portions are approximately perpendicular at the interface because the interface of the phosphor portions has a range but, even in this case, the phosphor portions are taken as being disposed in a "perpendicular direction at the interface."

The phosphor layer of the present invention can be created, for example, by arranging and adjoining, on a transparent substrate which transmits near-ultraviolet light and visible light, a plurality of the first phosphor portions which comprise the foregoing 1Ath and 1Bth phosphors and a plurality of the second phosphor portions which comprise the foregoing 2Ath and 2Bth phosphors. "Separate members" indicates a state where, if the first phosphor portions and second phosphor portions are disposed on the foregoing transparent substrate, a separate layer is formed independently for each phosphor portion. That is, the 2Ath and 2Bth phosphors exist in separate spatial areas together with the 1Ath and 1Bth phosphors which are contained in the first phosphor portion and second phosphor portion.

<1-2. Phosphor>

The third phosphor can be suitably selected according to the wavelength of the light emitted by the semiconductor light emitting element together with the 1Ath and 1Bth phosphors (hereinafter also referred to collectively as the first phosphors) and the 2Ath and 2Bth phosphors (hereinafter also referred to collectively as the second phosphors). For example, if the wavelength of the excitation light of the semiconductor light emitting element is in the near ultraviolet or ultraviolet range, that is, if the wavelength is about 350 nm to 430 nm, a blue, green or red phosphor, or the like, can be chosen depending on the targeted emission spectrum. Further, if necessary, a phosphor of an intermediate color such as blue-green, yellow, or orange may be used. Specific examples which can be cited include a configuration in which the first phosphor is blue and the second phosphor is yellow, a configuration where the first phosphor is green, the second phosphor is red, and the third phosphor is blue, a configuration where the first phosphor is blue, the second phosphor is green, and the third phosphor is red, and a configuration in which the first phosphor is blue, the second phosphor is red, and the third phosphor is green.

Furthermore, as a configuration example, if the wavelength of the excitation light of the semiconductor light emitting element is in the blue color range, that is, if the wavelength is about 430 nm to 480 nm, normally, the blue light uses the light emission of the semiconductor light emitting element as is, and hence the first phosphor is green and the second phosphor is red.

The particle size of the phosphor can be suitably chosen depending on the method of applying the phosphor, and so on, but normally the diameter which is preferably used is 2 to 30 $\mu$m as a volumetric basis median diameter. Here, the volumetric basis median diameter measures samples by using a particle distribution measurement apparatus which is based on measuring laser diffraction and scattering, and is defined as the particle diameter for which the volumetric basis relative particle weight when particle distribution (cumulative distribution) is required is 50%.

The first phosphor, second phosphor, and third phosphor which are used in the present invention are excited by the light emitted by the semiconductor light emitting element and are phosphors which are capable of emitting a longer wavelength light than the light emitted by the semiconductor light emitting element.

Furthermore, the first phosphor, second phosphor, and third phosphor which are used in the present invention often have overlapping wavelength ranges between the light emission wavelength range of the emission spectrum and the excitation wavelength range of the excitation spectrum. In this case, the so-called self-absorption phenomenon sometimes arises, whereby the fluorescent light emitted by a certain phosphor particle is absorbed by another phosphor particle of the same type and the other phosphor particle emits fluorescent light by being excited by the absorbed light.

Note that the first phosphor may emit first light of a longer wavelength than the light emitted by the semiconductor light emitting element as a result of being excited by the light emitted by the semiconductor light emitting element, and the second phosphor may emit second light of a longer wavelength than the first light by being excited by the first light. Further, if a third phosphor is included, the third phosphor may emit third light of a longer wavelength than the first light and/or second light by being excited by the first light and/or second light. The types of phosphor used by the present invention may be suitably chosen but the following phosphor types are given as representative phosphors for red, green, blue, and yellow phosphors.

<1-3. Red phosphors>

Examples of red phosphors which can be used include europium-activated alkaline-earth silicon nitride phosphor, expressed as $(Mg, Ca, Sr, Ba)_2Si_5N_8$:Eu, which is configured from fractured particles with a red fractured surface and which performs light emission in the red color range, europium-activated rare-earth oxycarcogenide phosphor, expressed as $(Y, La, Gd, Lu)_2O_2S$:Eu, which is configured from grown particles having a substantially spherical shape as a regular crystal-growth shape and which performs light emission in the red color range, phosphor which contains an oxysulfide and/or an oxynitride containing at least one element selected from the group consisting of Ti, Zr, Hf, Nb, Ta, W, and Mo which is a phosphor containing an oxynitride with an alpha-SiAlON in which some or all of the element Al is substituted for the element Ga, and $Mn^{4+}$-activated fluoro complex phosphor such as $M_2XF_6$:Mn (here, M contains one or more types selected from the group consisting of Li, Na, K, Rb, Cs and $NH_4$ and X contains one or more types selected from the group consisting of Ge, Si, Sn, Ti, Na, Al, and Zr).

Additional phosphors which can be used include Eu-activated oxysulfide phosphors such as $(La, Y)_2O_2S$:Eu, Eu-activated oxide phosphors such as $Y(V, P)O_4$ : Eu and $Y_2O_3$:Eu, Eu- and Mn-activated silicate phosphors such as $(Ba, Sr, Ca, Mg)_2SiO_4$:Eu, Mn, and $(Ba, Mg)_2SiO_4$:Eu, Mn, Eu-activated sulfide phosphors such as $(Ca, Sr)S$:Eu, Eu-activated aluminate phosphors such as $YAlO_3$:Eu, Eu-activated silicate phosphors such as $LiY_9(SiO_4)_6O_2$:Eu, $Ca_2Y_8(SiO_4)_6O_2$:Eu, $(Sr, Ba, Ca)_3SiO_5$:Eu, and $Sr_2BaSiO_5$:Eu, Ce-activated aluminate phosphors such as $(Y, Gd)_3Al_5O_{12}$:Ce and $(Tb, Gd)_3Al_5O_{12}$:Ce, Eu-activated nitride phosphors such as $(Ca, Sr, Ba)_2Si_5N_8$:Eu, $(Mg, Ca, Sr, Ba)SiN_2$:Eu, and $(Mg, Ca, Sr, Ba)AlSiN_3$:Eu, Ce-activated nitride phosphors such as $(Mg, Ca, Sr, Ba)AlSiN_3$:Ce, Eu- and Mn-activated halophosphate phosphors such as $(Sr, Ca, Ba, Mg)_{10}(PO_4)_6C_{12}$:Eu, Mn, Eu- and Mn-activated silicate phosphors such as $Ba_3MgSi_2O_8$:Eu, Mn, $(Ba, Sr, Ca, Mg)_3(Zn, Mg)Si_2O_8$:Eu, Mn, Mn-activated germanium silicate phosphors such as $3.5MgO \cdot 0.5MgF_2 \cdot GeO_2$:Mn, Eu-activated nitride phosphors such as Eu-activated $\alpha$-SiAlON, Eu- and Bi-activated oxide phosphors such as $(Gd, Y, Lu, La)_2O_3$: Eu, Bi, Eu- and Bi-activated sulfide phosphors such as $(Gd, Y, Lu, La)_2O_2S$: Eu, Bi, Eu- and Bi-activated vanadate phosphors such as $(Gd, Y, Lu, La)VO_4$:Eu, Bi, Eu- and Ce-activated sulfide phosphors such as $SrY_2S_4$:Eu, Ce, Ce-activated sulfide phosphors such as $CaLa_2S_4$:Ce, Eu- and Mn-activated phosphate phosphors such as $(Ba, Sr, Ca)MgP_2O_7$:Eu, Mn, and $(Sr, Ca, Ba, Mg, Zn)_2P_2O_7$:Eu, Mn, Eu- and Mo-activated tungstate phosphors such as $(Y, Lu)_2WO_6$:Eu, Mo, Eu- and Ce-activated nitride phosphors such as $(Ba, Sr, Ca)_xSi_yN_2$:Eu, Ce (where x, y, and z are integers of 1 or more), Eu- and Mn-activated halophosphate phosphors such as $(Ca, Sr, Ba, Mg)_{10}(PO_4)_6(F, Cl, Br, OH)_2$:Eu, Mn, and Ce-activated silicate phosphors such as $((Y, Lu, Gd, Tb)_{1-x}Sc_xCe_y)_2(Ca, Mg)_{1-r}(Mg, Zn)_{2+r}Si_{z-q}GeqO_{12+\delta}$. Furthermore, $SrAlSi_4N_7$ which appears in WO 2009/072043 and $Sr_2Al_2Si_9O_2N_{14}$ :Eu which appears in US Patent Specification No. 7524437 can also be used.

Of the foregoing phosphors, Eu-activated nitride phosphors such as $(Mg, Ca, Sr, Ba)AlSiN_3$:Eu and $CaAlSi(N, O)_3$:Eu

(abbreviation:CASON) are preferably used.

<1-4. Green phosphors>

Examples of green phosphors which can be used include europium-activated alkaline-earth silicon oxynitride phosphor, expressed as $(Mg, Ca, Sr, Ba)Si_2O_2N_2:Eu$, which is configured from fractured particles with a fractured surface and which performs light emission in the green color range, europium-activated alkaline-earth silicate phosphor, expressed as $(Ba, Ca, Sr, Mg)_2SiO_4:Eu$, which is configured from fractured particles with a fractured surface and which performs light emission in the green color range, and Eu-activated nitride phosphors such as $M_3Si_6O_{12}N_2:Eu$ (where M represents the alkaline-earth metal) which appears in WO 2007-088966.

Further, additional phosphors which can also be used include Eu-activated aluminate phosphors such as $Sr_4Al_{14}O_{25}:Eu$, $(Ba, Sr, Ca) Al_2O_4:Eu$, Eu-activated silicate phosphors such as $(Sr, Ba) Al_2Si_2O_8:Eu$, $(Ba, Mg)_2SiO_4:Eu$, $(Ba, Sr, Ca, Mg)_2SiO_4:Eu$, $(Ba, Sr, Ca)_2(Mg, Zn) Si_2O_7:Eu$, Ce- and Tb-activated silicate phosphors such as $Y_2SiO_5:Ce, Tb$, Eu-activated boron phosphate phosphors such as $Sr_2P_2O_7-Sr_2B_2O_5:Eu$, Eu-activated halophosphate phosphors such as $Sr_2Si_3O_8-2SrCl_2:Eu$, Mn-activated silicate phosphors such as $Zn_2SiO_4:Mn$, Tb-activated aluminate phosphors such as $CeMgAl_{11}O_{19}:Tb$ and $Y_3Al_5O_{12}:Tb$, Tb-activated silicate phosphors such as $Ca_2Y_8(SiO_4)_6O_2:Tb$, $La_3Ga_5SiO_{14}:Tb$, Eu-, Tb- and Sm-activated thiogallate phosphors such as $(Sr, Ba, Ca) Ga_2S_4:Eu, Tb$, and $Sm$, Ce-activated aluminate phosphors such as $Y_3(Al, Ga)_5O_{12}:Ce$, $(Y, Ga, Tb, La, Sm, Pr, Lu)_3 (Al, Ga)_5O_{12}:Ce$, Ce-activated silicate phosphors such as $Ca_3Sc_2Si_3O_{12}:Ce$, $Ca_3 (Sc, Mg, Na, Li)_2Si_3O_{12}:Ce$, Ce-activated oxide phosphors such as $CaSc_2O_4:Ce$, Eu-activated nitride phosphors such as $SrSi_2O_2N_2:Eu$, $(Sr, Ba, Ca) Si_2O_2N_2:Eu$ and Eu-activated $\beta$-SiAlON, Eu- and Mn-activated aluminate phosphors such as $BaMgAl_{10}O_{17}:Eu, Mn$, Eu-activated aluminate phosphors such as $SrAl_2O_4:Eu$, Tb-activated oxysulfide phosphors such as $(La, Gd, Y)_2O_2Si:Tb$, Ce- and Tb-activated phosphate phosphors such as $LaPO_4:Ce, Tb$, sulfide phosphors such as $ZnS:Cu, Al$, $ZnS:Cu, Au, Al$, Ce- and Tb-activated boronate phosphors such as $(Y, Ga, Lu, Sc, La) BO_3:Ce, Tb$, $Na_2Gd_2B_2O_7:Ce, Tb$, $(Ba, Sr)_2 (Ca, Mg, Zn)B_2O_6:K, Ce, Tb$, Eu- and Mn-activated halosilicate phosphors such as $Ca_8Mg (SiO_4)_4Cl_2:Eu, Mn$, Eu-activated thioaluminate phosphors or thiogallate phosphors such as $(Sr, Ca, Ba) (Al, Ga, In)_2S_4:Eu$, and Eu- and Mn-activated halosilicate phosphors such as $(Ca, Sr)_8 (Mg, Zn) (SiO_4)_4Cl_2:Eu, Mn$. Further, $Sr_5Al_5Si_{21}O_2N_{35}:Eu$ which appears in WO 2009/072043 and $Sr_3Si_{13}Al_3N_{21}O_2:Eu$ which appears in WO 2007/105631 can also be used. Of the foregoing phosphors, $(Ba, Ca, Sr, Mg)_2SiO_4:Eu$, $BaMgAl_{10}O_{17}:Eu, Mn$; Eu-activated $\beta$-SiAlON, and $M_3Si_6O_{12}N_2:Eu$ (where M represents the alkaline-earth metal element) and the like can preferably be used.

<1-5. Blue phosphors>

Examples of blue phosphors which can be used include europium-activated barium magnesium aluminate phosphor, expressed as $BaMgAl_{10}O_{17}:Eu$, which is configured from grown particles having a substantially hexagonal shape as a regular crystal-growth shape and which performs light emission in the blue color range, europium-activated calcium halo phosphate phosphor, expressed as $(Ca, Sr, Ba)_5(PO_4)_3Cl:Eu$, which is configured from grown particles having a substantially spherical shape as a regular crystal-growth shape and which performs light emission in the blue color range, europium-activated alkaline-earth chloroborate phosphor, expressed as $(Ca, Sr, Ba)_2B_5O_9Cl:Eu$, which is configured from grown particles having a substantially cubic shape as a regular crystal-growth shape and which performs light emission in the blue color range, and europium-activated alkaline-earth aluminate phosphor, expressed as $(Sr, Ca, Ba)Al_2O_4:Eu$ or $(Sr, Ca, Ba)_4Al_{14}O_{25}:Eu$, which is configured from fractured particles having a fractured surface and which performs light emission in the blue color range, or the like.

Further, additional phosphors which can be used as blue colors include Sn-activated phosphate phosphors such as $Sr_2P_2O_7:Sn$; Eu-activated aluminate phosphors such as $Sr_9Al_{14}O_{25}:Eu$, $BaMgAl_{10}O_{17}:Eu$, and $BaAl_8O_{13}:Eu$; Ce-activated thiogallate phosphors such as $SrGa_2S_4:Ce$ and $CaGa_2S_4:Ce$; Eu-, Tb-, and Sm-activated aluminate phosphors such as $(Ba, Sr, Ca) MgAl_{10}O_{17}:Eu$ and $BaMgAl_{10}O_{17}:Eu, Tb, Sm$; Eu- and Mn-activated aluminate phosphors such as $(Ba, Sr, Ca) MgAl_{10}O_{17}:Eu, Mn$; Eu-, Tb-, and Sm-activated halophosphate phosphors such as $(Sr, Ca, Ba, Mg)_{10}(PO_4)_6Cl_2:Eu$, $(Ba, Sr, Ca)_5(PO_4)_3 (Cl, F, Br, OH):Eu, Mn, Sb$; Eu-activated silicate phosphors such as $BaAl_2Si_2O_8:Eu$, $(Sr, Ba)_3MgSi_2O_8:Eu$; Eu-activated phosphate phosphors such as $Sr_2P_2O_7:Eu$, sulfide phosphors such as $ZnS:Ag$ and $ZnS:Ag, Al$, Ce-activated silicate phosphors such as $Y_2SiO_5:Ce$; tungstate phosphors such as $CaWO_4$; Eu- and Mn-activated boron phosphate phosphors such as $(Ba, Sr, Ca) BPO_5:Eu, Mn$, $(Sr, Ca)_{10}(PO_4)_6\cdot nB_2O_3:Eu$, $2SrO\cdot0.84P_2O_5\cdot0.16B_2O_3:Eu$, and Eu-activated halophosphate phosphors such as $Sr_2Si_3O_8-2SrCl_2:Eu$.

Of the foregoing phosphors, $(Sr, Ca, Ba)_{10}(PO_4)_6Cl_2:Eu^{2+}$, $BaMgAl_{10}O_{17}:Eu$ can preferably be used. Further, of the phosphors denoted by $(Sr, Ca, Ba)_{10}(PO_4)_6Cl_2:Eu^{2+}$, a phosphor denoted by $Sr_aBa_bEu_x (PO_4)_cCl_d$ can preferably be used (where c, d and x are numbers satisfying $2.7 \leq c \leq 3.3$, $0.9 \leq d \leq 1.1$, and $0.3 \leq x \leq 1.2$, with x preferably being $0.3 \leq x \leq 1.0$. Further, a and b satisfy the conditions $a+b = 5-x$ and $0.05 \leq b/(a+b) \leq 0.6$ and $b/(a+b)$ is preferably $0.1 \leq b/(a+b) \leq 0.6$).

<1-6. Yellow phosphors>

Yellow phosphors include various oxide, nitride, oxynitride, sulfide, and oxysulfide phosphors. In particular, garnet phosphors with a garnet structure denoted by $RE_3M_5O_{12}$:Ce (here, RE represents at least one element selected from the group consisting of Y, Tb, Gd, Lu, and Sm, and M represents at least one element selected from the group consisting of Al, Ga, and Sc), and $Ma_3Mb_2MC_3O_{12}$:Ce (here Ma represents a di-valent metal element, Mb represents a tri-valent metal element, and Mc represents a 4-valent metal element), orthosilicate phosphors, denoted by $AE_2MdO_4$: Eu (here, AE represents at least one element selected from the group consisting of Ba, Sr, Ca, Mg, and Zn, and Md represents Si, and/or Ge), oxynitride phosphors obtained by substituting nitrogen for part of the oxygen of the constituent element of the foregoing phosphors, and phosphors obtained by Ce-activating a nitride phosphor having a $CaAlSiN_3$ structure such as $AEAlSiN_3$:Ce (here AE represents at least one element selected from the group consisting of Ba, Sr, Ca, Mg, and Zn).

Furthermore, additionally, examples of yellow phosphors which can be used include sulfide phosphors such as $CaGa_2S_4$:Eu, (Ca, Sr) $Ga_2S_4$:Eu, (Ca, Sr) $(Ga, Al)_2S_4$:Eu, Eu- activated phosphors such as oxynitride phosphors which have an SiAlON structure such as $Ca_x (Si, Al)_{12} (O, N)_{16}$:Eu, Eu-activated or Eu- and Mn-activated boron halide phosphors such as $(M_{1-A-B}Eu_AMn_B)_2 (BO_3)_{1-P} (PO_4)_P X$ (where M represents at least one element selected from the group consisting of Ca, Sr, and Ba, and X represents at least one element selected from the group consisting of F, Cl, and Br. A, B, and P each represent numbers which satisfy $0.001 \leq A \leq 0.3$, $0 \leq B \leq 0.3$, $0 \leq P \leq 0.2$), and may contain alkaline earth metals, and, for example, Ce-activated oxynitride phosphors having a structure of $La_3Si_3N_{11}$ may be used. Note that the foregoing Ce-activated nitride phosphors may also be partially substituted with Ca and O.

<2-1. Phosphor portions>

The phosphor portions contained in the phosphor layer of the present invention are formed by screen printing a phosphor paste onto a transparent substrate which transmits near-ultraviolet light and visible light or formed using inkjet printing, and can be fabricated using a transfer process or by using an exposure-type coating method which is used to coat a cathode ray tube (CRT), or the like. Otherwise, as long as the method enables distributed coating of phosphors on a substrate, there are no restrictions on the method employed. Further, when performing the distributed coating, printing with a mask to prevent overlap between adjoining phosphor portions may also be given as a preferred method. Arranging a light-shielding portion between the first and second phosphor portions may also be cited. In this case, the light-shielding portion is preferably disposed so as to prevent the light emitted from the first phosphor portion from entering the second phosphor portion, and the light-shielding portion is more preferably formed of a reflective material.

The phosphor portions comprising the phosphor layer of the present invention may be fabricated by mixing a phosphor powder with binder resin and organic solvent to form a paste, applying the paste to a transparent substrate, and performing drying and calcination to remove the organic solvent, or may be fabricated by forming a paste from the phosphor and organic solvent without the use of a binder, and press-molding the dried sinter. If a binder is used, the binder can be used without restrictions on the type: an epoxy resin, a silicone resin, an acrylic resin, or a polycarbonate resin or the like can be used.

Note that, in a case where the phosphor portions are formed using screen printing, same can be fabricated by mixing a phosphor powder with binder resin and organic solvent to form a paste, and using a patterned screen to transfer the paste to the transparent substrate via a squeegee. From the standpoint of facilitating coating in screen printing and leveling, it is preferable to use a silicone resin, an acrylic urethane resin or a polyester urethane resin as the binder resin. Further, when the paste is created by mixing a phosphor powder with a binder resin, mixing may be performed with an organic solvent added. The organic solvent can be used to adjust the viscosity. Further, by removing the organic solvent by heating following the transfer to the substrate, the phosphor can be packed more precisely in the phosphor layer. On the grounds that vaporization is difficult at room temperature and the solvent vaporizes quickly when heat is applied, cyclohexanone or xylene or the like is preferably used as the organic solvent.

Further, with regard to the material for the transparent substrate, there are no particular restrictions as long as the material is transparent to visible light, and glass and plastic and the like can be used. Among plastics, epoxy resin, silicone resin, acrylic resin, polycarbonate resin, PET resin, and PEN resin are preferable, with PET resin, PEN resin, and polycarbonate resin being more preferable and PET being even more preferable.

Note that, as a specific example of a light-shielding portion, a portion obtained by dispersing highly reflective particles in a binder resin or the like may be cited. The highly reflective particles are preferably aluminum particles, titanium particles, silica particles, and zirconium particles are preferable, with aluminum particles, titanium particles, and silica particles being more preferable and aluminum particles being even more preferable.

Otherwise, according to the method which appears in Japanese Patent Application Publication No. 2008-135539, an adhesive layer may be formed by coating an adhesive, whose main component is a resin such as a silicone resin or epoxy resin, on a transparent substrate by means of a dispensing or spraying method or the like, and spraying a phosphor powder onto the adhesive layer using a compressed gas or the like.

<2-2. Phosphor portion assembly>

The area A and area B of the phosphor layer of the present invention are configured such that, in addition to the adjoining 1Ath phosphor portions and 2Ath phosphor portions, 2Ath phosphor portions and 2Bth phosphor portions are disposed as separate members in a direction perpendicular to the thickness direction of the phosphor layer at the interface between the 2Ath phosphor portions and 2Bth phosphor portions; however, various aspects may be considered for the disposition of the phosphor portions.
First, examples of shapes for the 1Ath phosphor portions and 1Bth phosphor portions (hereinafter the 1Ath phosphor portions and 1Bth phosphor portions are also referred to collectively as first phosphor portions) and for the 2Ath phosphor portions and 2Bth phosphor portions (hereinafter the 2Ath phosphor portions and 2Bth phosphor portions are also referred to collectively as second phosphor portions) include a stripe shape, a triangular shape, a square shape, a hexagonal shape, and a circular shape.

Furthermore, the phosphor layer of the present invention is preferably configured such that the first phosphor portions and second phosphor portions are disposed as a pattern and more preferably configured such that the first phosphor portions and second phosphor portions are disposed with a stripe shape. Here, "disposed as a pattern" denotes an arrangement in which at least one or more first phosphor portions and one or more second phosphor portions are included, with no identical phosphor portions adjoining one another and with the first phosphor portions and second phosphor portions being alternately arranged to form a unit which is repeated regularly. Further, "disposed with a stripe shape" denotes an arrangement in which the first phosphor portions and second phosphor portions are of the same size and the same shape, with no identical phosphor portions adjoining one another and the first phosphor portions and second phosphor portions being alternately arranged. As a specific example of a stripe shape, the first phosphor portions and second phosphor portions are square shapes of the same size and shape and identical phosphor portions do not adjoin one another and are arranged alternately. In the case of a stripe shape, the number of members is preferably ten or more in each of areas A and B, described subsequently, and more preferably twenty or more.

Furthermore, the phosphor layer of the present invention preferably significantly improves the design of the light emitting device in any of the following cases:(1) the shape or design or the combination thereof are rendered using the same molding processing, thereby establishing a uniform disposition overall, (2) a uniform disposition overall is established by rendering one single overall shape or design, and (3) a uniform disposition overall is established by providing images which are conceptually related as in a narrative according to each shape, design or a combination thereof. A specific arrangement pattern for the phosphor portions will be described below.

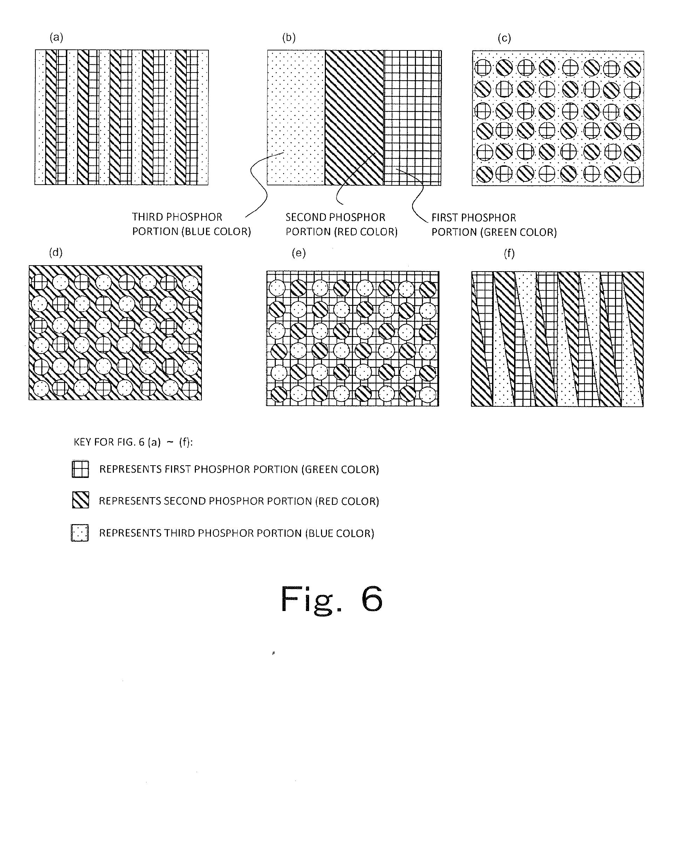

Fig. 6 shows a pattern of a phosphor layer which comprises a first phosphor portion comprising green phosphor, a second phosphor portion comprising red phosphor, and a third phosphor portion comprising blue phosphor, in a case where the semiconductor light emitting element emits light of a wavelength in the near-ultraviolet or ultraviolet light range. Figs. 6A and 6B show patterns of a phosphor layer in which phosphor portions of an oblong shape are disposed in stripes, Figs. 6C to 6E show patterns of a phosphor layer in which circular-shaped phosphor portions are disposed, and Fig. 6F shows a pattern of a phosphor layer in which phosphor portions of a triangular shape are disposed.

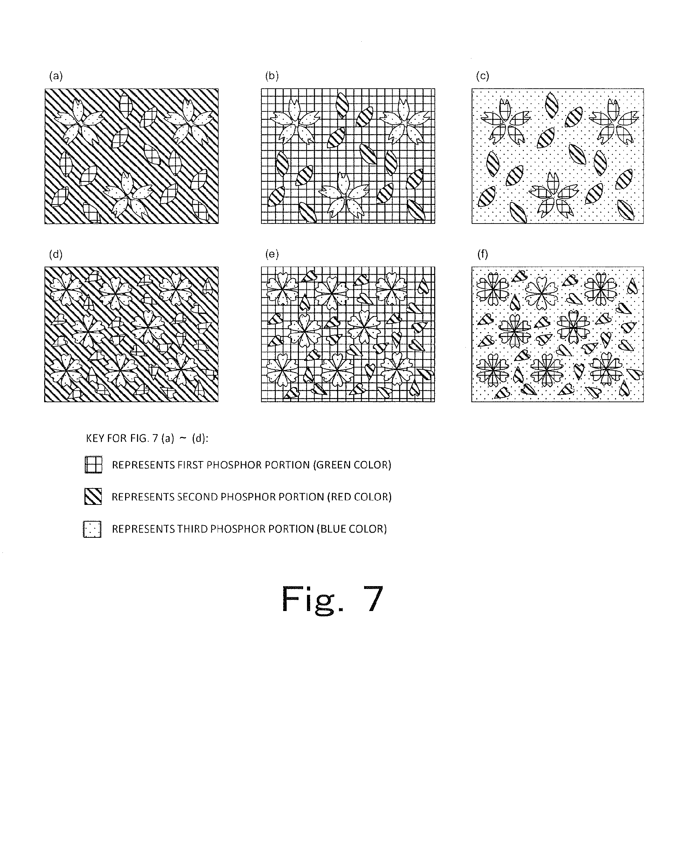

Fig. 7 shows a pattern of a phosphor layer in which flower-shaped phosphor portions and petal-shaped phosphor portions are disposed. All of Figs. 7A to 7F are an aspect which corresponds to case (2) above where a uniform disposition overall is established by rendering one single overall shape or design.

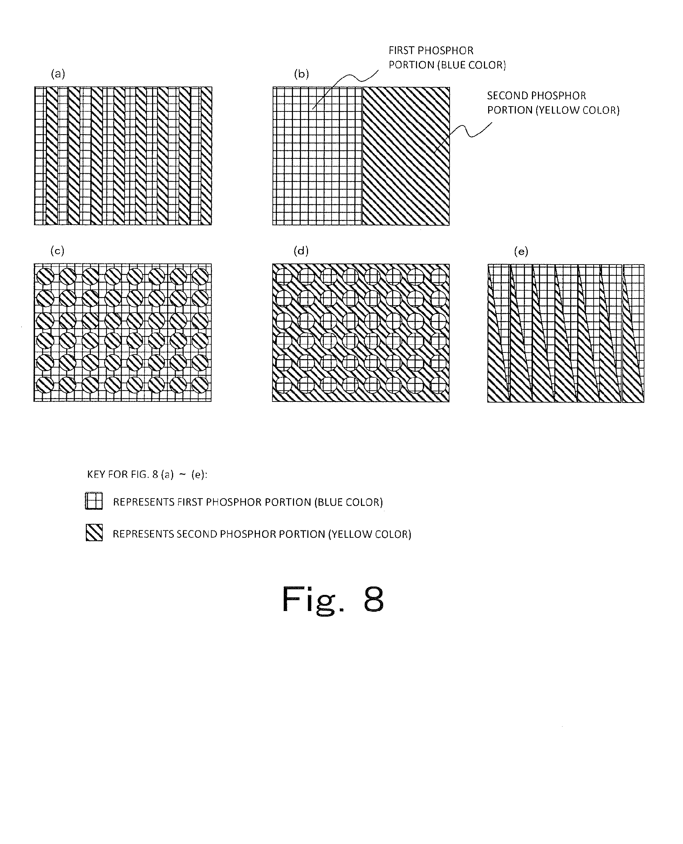

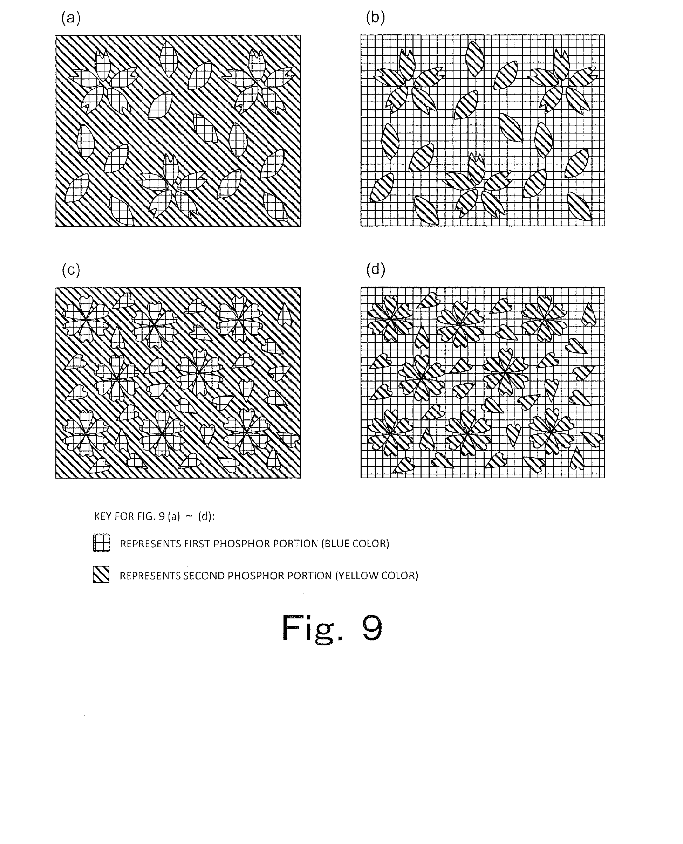

Meanwhile, in a case where the semiconductor light emitting element emits light of a wavelength in the near-ultraviolet or ultraviolet range, the pattern may be a pattern of a phosphor layer which comprises first phosphor portions comprising blue phosphor and second phosphor portions comprising yellow phosphor. Such a phosphor layer pattern is shown in Figs. 8A to 8E and Figs. 9A to 9D.

Further, in a case where the semiconductor light emitting element emits light of a wavelength in the blue color range, a pattern of a phosphor layer which comprises first phosphor portions comprising green phosphor and second phosphor portions comprising red phosphor may be provided for the phosphor layer. As an illustrative example, the patterns shown in Figs. 8 and 9 are patterns in which the first phosphor portions are green and the second phosphor portions are red.

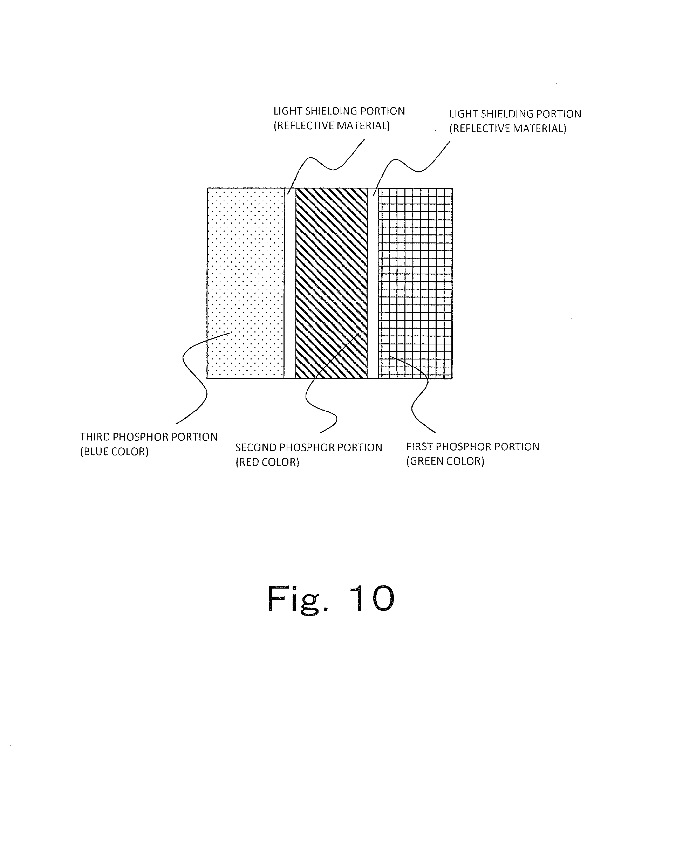

In addition, in a case where a transparent substrate which transmits visible light is used, where the semiconductor light emitting element emits light of a wavelength in the blue color range, an example of a pattern is one in which the blue light emitted from the semiconductor light emitting element is transmitted and used as is without providing third phosphor portions which comprise blue phosphor.
Further, in Figs. 6 to 9, a pattern in which a light-shielding portion is provided at the interface between each of the phosphor portions is also possible. As a specific aspect, the pattern in which a light-shielding portion is provided at the interface between the light-shielding portions in Fig. 6B is shown in Fig. 10.

<2-3. Characteristics of the phosphor layer of the present invention>

The phosphor layer of the present invention is preferably of a layer shape with a thickness of not more than 1 mm. The thickness is more preferably not more than 500 $\mu$m and even more preferably not more than 300 $\mu$m. The foregoing thickness does not include the thickness of the substrate in cases where the phosphor layer is formed on a transparent substrate which transmits near-ultraviolet light and visible light. However, because the thickness of the phosphor layer in the present invention is not more than 1 mm and thin, fabrication is preferably straightforward by means of a method of coating phosphor on a transparent substrate which transmits visible light. The thickness of the phosphor layer can be measured by cutting the phosphor layer in the thickness direction and observing the cross section using an electron microscope such as an SEM. Further, the combined thickness of the substrate coated with the phosphor layer and the phosphor layer is measured using a micrometer, and the thickness of the phosphor layer can be measured by using a micrometer to measure the thickness of the substrate once again after the phosphor layer has been detached from the substrate. Similarly, the thickness can be measured directly by partially detaching the phosphor layer and using a stylus profile measuring system to measure the difference between the part where the phosphor layer remains and the part from which the phosphor layer has been detached part.

In a case where a transparent substrate which transmits ultraviolet light and visible light is used, there are no particular restrictions on the material of the substrate as long as the substrate is transparent to near-ultraviolet light and visible light, and glass and plastic (for example epoxy resin, silicone resin, acrylic resin, and polycarbonate resin or the like) can be used. If excited by wavelengths in the near-ultraviolet range, glass is preferable from the standpoint of durability.

In addition, making the thickness of the phosphor layer at least twice the volumetric basis median diameter of the phosphor contained in the phosphor layer and not more than 10 times this diameter preferably enables the self-absorption of the light of the phosphors and reduces the light scattering caused by the phosphors. If the thickness of the phosphor layer is too thin, since the excitation light from the semiconductor light emitting element is not adequately converted at the light emitting layer, there tends to be a drop in the intensity of the output light. The thickness of the phosphor layer is more preferably three times or more the median diameter of the phosphor and particularly preferably four times or more the median diameter. If, on the other hand, the thickness of the phosphor layer is too thick, because the self-absorption of the light of the phosphors increases and the light scattering by the phosphors increases, there tends to be a drop in the intensity of the output light. The thickness of the phosphor layer is preferably not more than nine times the median diameter of the phosphor, particularly preferably not more than eight times the median diameter, and more preferably not more than seven times the median diameter, and even more preferably not more than six times the median diameter, and most preferably not more than five times the median diameter.

In addition, the volume fill rate of the phosphor in the phosphor layer is preferably at least 20% in order to raise the light emitting efficiency. If the volume fill rate drops below 20%, there is an increase in the light from the semiconductor light emitting element which is not excited by the phosphor at the light emitting layer and a risk of a drop in emission efficiency. The volume fill rate is more preferably at least 40%. Although there are no particular upper limit restrictions, there is normally no increase above the value for the maximum packing rate which is about 74%. Further, the density of the phosphor layer is preferably at least 1.0 g/cm$^3$.

<2-4. Phosphor overlap>

The phosphor layer of the present invention is preferably configured such that separate phosphor portions which are formed in a direction perpendicular to the thickness direction are disposed so as to prevent a reduction in overlapping parts in the thickness direction of the phosphor layer at the interface between the phosphor portions in order to be able to prevent cascade excitation and improve the emission efficiency. More specifically, the phosphor layer is preferably configured such that the proportion of the surface area of the part having phosphors of a plurality of types in the thickness direction of the phosphor layer relative to the light emission surface area of the light emitting device is 0% or more and 20% or less in order to improve the emission efficiency. Here, "light emission surface area of the light emitting device" indicates the surface area of the part passing light emitted by the light emitting device to the outside, of the surface area of the light emitting device. Furthermore, "surface area of the part having phosphors of a plurality of types in the thickness direction of the phosphor layer" means the projection surface area when the part having phosphors of a plurality of types in the thickness direction of the phosphor layer is projected onto the surface on the emission direction side from the thickness direction of the phosphor layer.

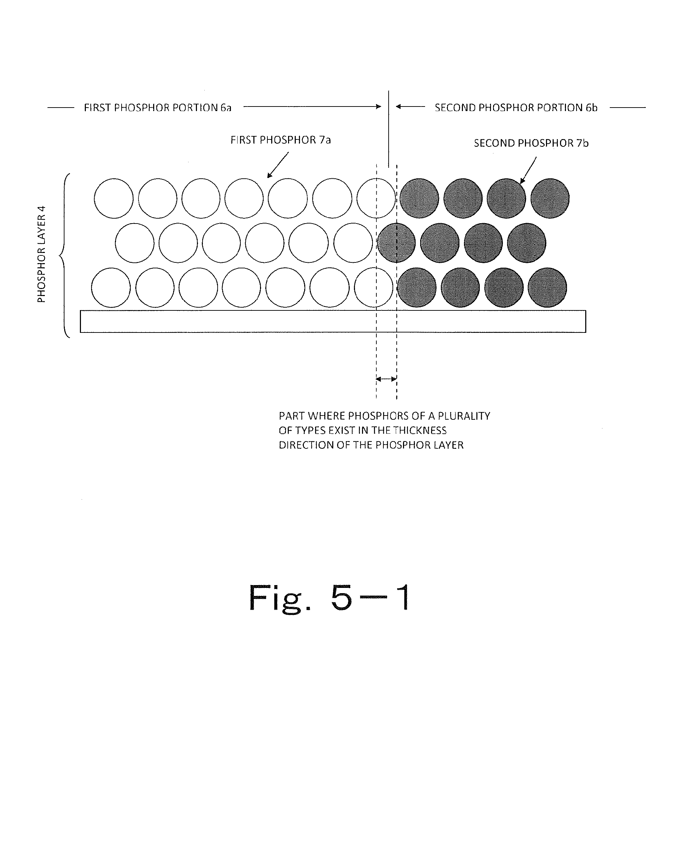

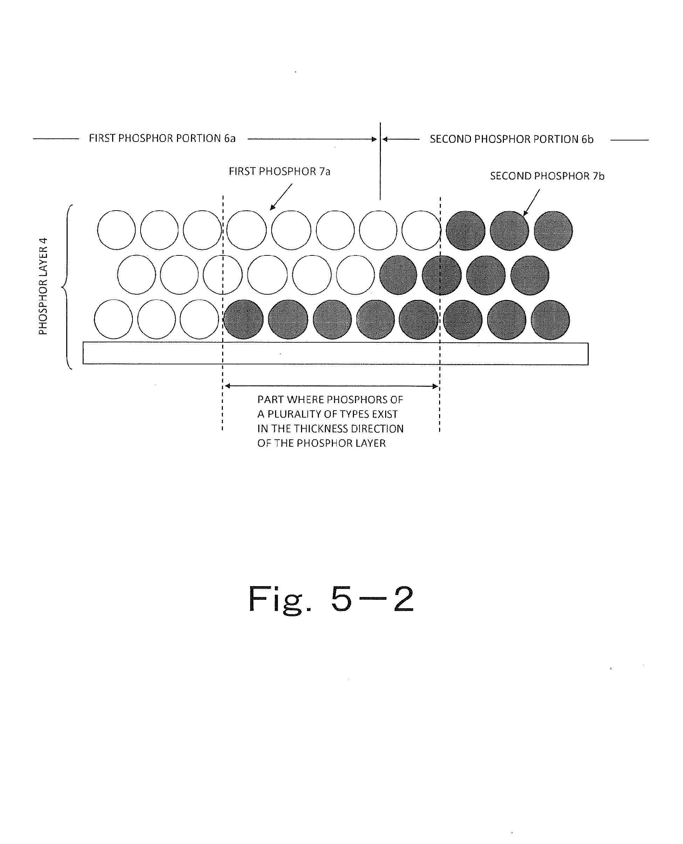

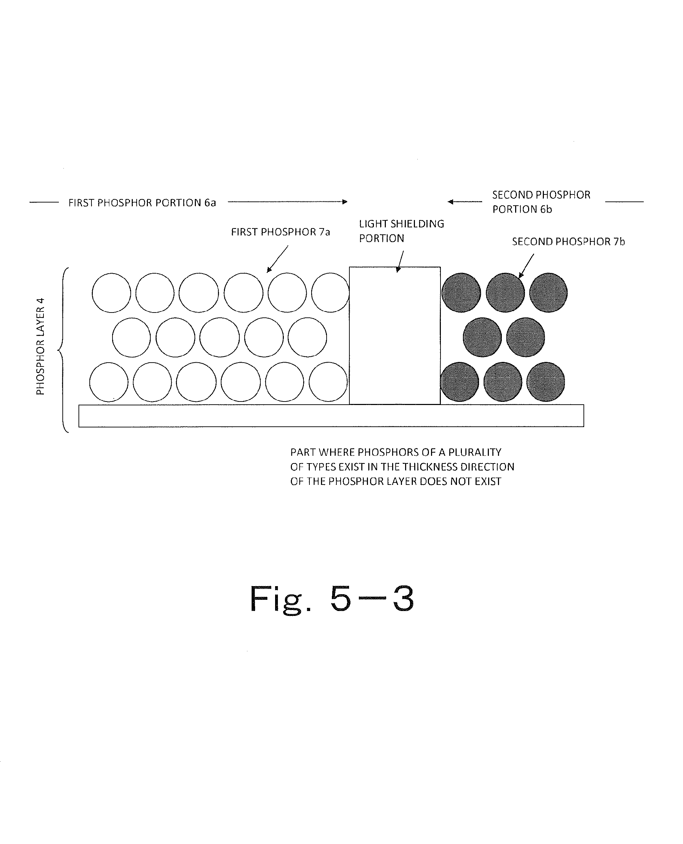

Figs. 5-1 to 5-3 show the contact face of adjoining phosphor portions. At this contact face, there is a part where phosphors of a plurality of types overlap in the thickness direction of the phosphor layer. Cascade excitation occurs extremely readily in this overlap part. For this reason, the state in Fig. 5-1 is preferable over the state in Fig. 5-2 in enabling prevention of cascade excitation. Further, a configuration like that in Fig. 5-3 by means of a method such as providing a light-shielding portion between the phosphor portions is more preferable in enabling prevention of cascade excitation. The proportion of the surface area of the part where a plurality of phosphors exist is preferably not more than 10%, more preferably not more than 5%, and most preferably 0%. The light-shielding portion is preferably disposed so as to prevent the light emitted from the first phosphor portions from entering the second phosphor portions. Further, the light-shielding portion is preferably of a black matrix or reflective material and more preferably a reflective material. Note that, in order that the overlap surface area exceed 0% and be not more than 20%, the desired interface between the first and second phosphor portions can be established to enable the foregoing numerical range for the overlap surface area by, for example, using screen printing, and (1) forming the first phosphor portions of a desired shape by using a screen of a specific shape, and (2) subsequently forming the second phosphor portions so as to contact the first phosphor portions. The desired shape for the interface between the first and second phosphor portions can be established to enable the foregoing numerical range for the overlap surface area by, for example, (1) forming a mask of a specific shape on the substrate by means of photolithography or the like, (2) forming first phosphor portions of the desired shape so as to adjoin the mask, (3) subsequently removing the mask, and (4) forming second phosphor portions, of the same shape as the removed mask, so as to contact the first phosphor portions in order to fill the part from which the mask was removed.

The surface area of the overlap part where phosphors of a plurality of types overlap in the phosphor layer of the present invention can be measured by cutting the phosphor layer in a thickness direction and observing the cross section using an electron microscope such as an SEM. The phosphor layer of the present invention is fabricated by arranging a plurality of phosphor portions and hence there is a contact face formed by adjoining phosphor portions at a plurality of points. Hence, in the phosphor layer the surface area of the overlap part where phosphors of a plurality of types overlap is given by the sum of the surface areas of the overlap parts which exist in the light emission surface area of the light emitting device.

<2-5. Areas A and B>

The phosphor layer of the present invention comprises an area A comprising two or more 1Ath phosphor portions and two or more 2Ath phosphor portions and an area B comprising two or more 1Bth phosphor portions and two or more 2Bth phosphor portions. Further, on the light emission side of the light emitting device, the condition of formula [1] below is satisfied when the sum total of the surface area occupied by the 1Ath phosphor portions in the area A is $S_{A1}$, the sum total of the surface area occupied by the 2Ath phosphor portions is $S_{A2}$, the sum total of the surface area occupied by the 1Bth phosphor portions in the area B is $S_{B1}$, and the sum total of the surface area occupied by the 2Bth phosphor portions is $S_{B2}$.

$$S_{A2}/S_{A1} \neq S_{B2}/S_{B1} \ldots [1]$$

Note that the areas A and B are preferably provided as separate areas in a direction perpendicular to the thickness direction of the phosphor layer and are more preferably provided so as to adjoin one another as separate areas in a direction perpendicular to the thickness direction of the phosphor layer. Note that the 1Ath phosphor contained in the 1Ath phosphor portions and the 1Bth phosphor contained in the 1Bth phosphor portions may be phosphors of the same type or phosphors of different types, but that the types are preferably different from the standpoint of precisely controlling the color temperature of the light emitted by the light emitting device. Furthermore, similarly, the 2Ath phosphor contained in the 2Ath phosphor portions and the 2Bth phosphor contained in the 2Bth phosphor portions may be phosphors of the same type or phosphors of different types.

The second phosphor contained in the second phosphor portions emits light which includes a component of a longer wavelength than the light emitted by the first phosphor contained in the first phosphor portions. That is, there is a difference in wavelength of the fluorescent light emitted by the phosphors contained in the second phosphor portions and first phosphor portions, and the second phosphor portions emit fluorescent light of a longer wavelength.
To provide a specific example, if the semiconductor light emitting element emits light of a wavelength in the violet range, the phosphor contained in the first phosphor portions is blue and the phosphor contained in the second phosphor portions is yellow. Further, the phosphor contained in the first phosphor portions is green, the phosphor contained in the second phosphor portions is red, and the phosphor contained in the third phosphor portions is blue. In addition, the phosphor contained in the first phosphor portions is blue, the phosphor contained in the second phosphor portions is green, and the phosphor contained in the third phosphor portions is red. Further, the phosphor contained in the first phosphor portions is blue, the phosphor contained in the second phosphor portions is red, and the phosphor contained in the third phosphor portions is green.
Additionally, the phosphor contained in the first phosphor portions is green, the phosphor contained in the second phosphor portions is red, the phosphor contained in the third phosphor portions is blue, and the phosphor contained in fourth phosphor portions is yellow. Further, the phosphor contained in the first phosphor portions is blue, the phosphor contained in the second phosphor portions is green, the phosphor contained in the third phosphor portions is red, and the phosphor contained in fourth phosphor portions is yellow. Furthermore, the phosphor contained in the first phosphor portions is blue, the phosphor contained in the second phosphor portions is red, the phosphor contained in the third phosphor portions is green, and the phosphor contained in fourth phosphor portions is yellow.

If, on the other hand, the semiconductor light emitting element emits light of a wavelength in the blue color range, the phosphor contained in the first phosphor portions is green, and the phosphor contained in the second phosphor portions is red. Further, the phosphor contained in the first phosphor portions is green, the phosphor contained in the second phosphor portions is red, and the phosphor contained in the third phosphor portions is yellow. Note that, if the color rendering properties are to be improved, the phosphor contained in the first phosphor portions is green, the phosphor contained in the second phosphor portions is red, the phosphor contained in the third phosphor portions is red, and there is a difference in the type and peak wavelength of the phosphor between the second and third phosphor portions.

Among the foregoing specific examples, when a case is considered where the phosphor contained in the first phosphor portions is green and the phosphor contained in the second phosphor portions is red, the foregoing formula [1] represents different proportions for green phosphor and red phosphor in the areas A and B. That is, different emission spectra, for example, color temperatures of the emitted light color are represented in areas A and B. An area with a larger amount of red phosphor has a lower emitted light color temperature, that is, emits white light like that of a light bulb, and an area with a smaller amount of red phosphor has a higher emitted light color temperature, that is, emits pale white light like that of a fluorescent lamp. Because the phosphor layer comprises two areas of different emitted light color temperature, the color temperature of the emitted light color can be tuned by adjusting the proportion of the light irradiated onto areas A and B from the semiconductor light emitting element, in the phosphor layer.

Accordingly, simply by adjusting the ratio between the surface areas of the first phosphor portions and second phosphor portions contained in areas A and B in the phosphor layer, it is possible to easily adjust the emission spectrum of the light which is a combination of the light emitted from area A and the light emitted from area B. The light emitting device is configured using the phosphors and the semiconductor light emitting element and the emission spectrum of the light emitting device can easily be tuned by adjusting the proportion of the light irradiated onto areas A and B from the semiconductor light emitting element.

Further, the phosphor layer of the present invention further comprises an area X between the area A and the area B,

(i) wherein the area X comprises two or more 1Xth phosphor portions and two or more 2Xth phosphor portions,
(ii) wherein, in the area X, the adjoining first phosphor portions and second phosphor portions are disposed in a direction perpendicular to the thickness direction of the phosphor layer at the interface between the first phosphor portions and second phosphor portions,
(iii) wherein the 1Xth phosphor portions comprise a 1Xth phosphor which is able to emit light comprising a longer wavelength light than the light emitted by the semiconductor light emitting element by being excited by the light emitted by the semiconductor light emitting element,
(iv) wherein the 2Xth phosphor portions comprise a 2Xth phosphor which is able to emit light comprising a longer wavelength light than the light emitted by the first phosphor by being excited by the light emitted by the semiconductor light emitting element, and
(v) wherein the conditions of formulae [3] and [4] are preferably satisfied when the sum total of the surface area occupied by the 1Xth phosphor portions in the area X is $S_{X1}$, and the sum total of the surface area occupied by the 2Xth phosphor portions in the area X is $S_{X2}$.

$$S_{A2}/S_{A1} \neq S_{X2}/S_{X1} \ldots [3]$$

$$S_{B2}/S_{B1} \neq S_{X2}/S_{X1} \ldots [4]$$

Further providing the area X in the phosphor layer in addition to the areas A and B enables the range of the light emitted by the light emitting device to be extended and is preferable. This point is explained hereinbelow.

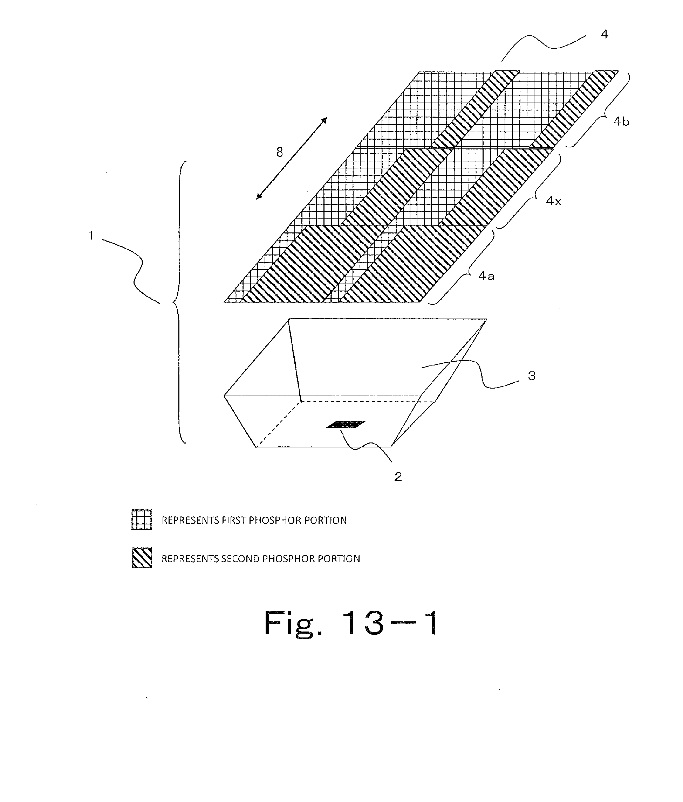

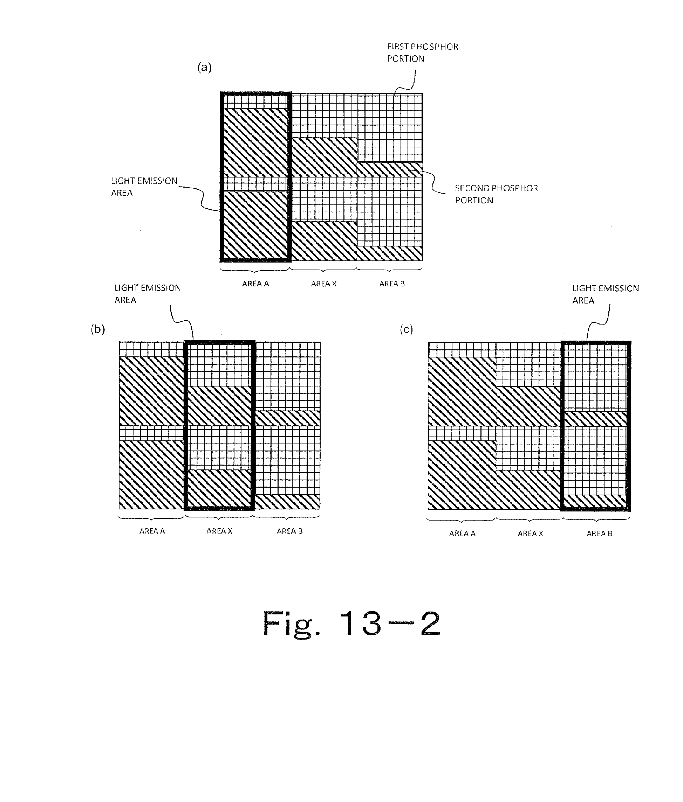

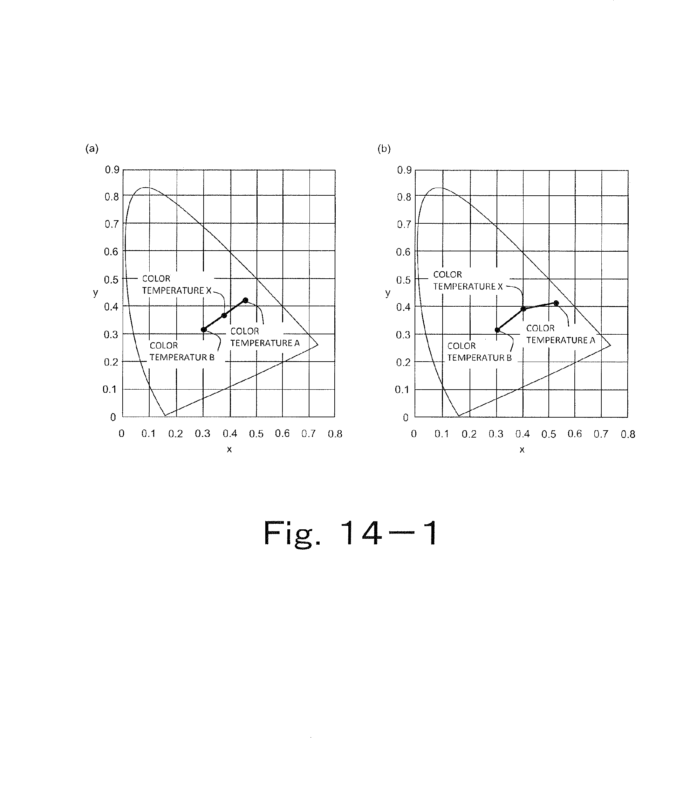

For example, as shown in Fig. 13-1, if the surface areas of areas A, B, and X are the same as the light emission surface area of the light emitting device and the areas are provided so as to adjoin one another, when the phosphor layer or the semiconductor light emitting element is moved, as shown in Fig. 13-2A if the light emission area matches area A, the light emitted from area A is the light emitted by the light emitting device, 13-2B if the light emission area matches area X, only the light emitted from area X is the light emitted by the light emitting device, and 13-2C if the light emission area matches the area B, only the light emitted from area B is the light emitted by the light emitting device. In a case where the phosphor layer is configured as per Fig. 13-1, by moving the phosphor layer or the semiconductor light emitting element, it is possible to continuously adjust the color temperature of the light emitted by the light emitting device to an optional color temperature, in the chromaticity diagram, which lies on a straight line linking a color temperature A $(X_A, y_A)$ of the light emitted from area A and a color temperature X $(X_x, y_x)$ of the light emitted from area X or linking a color temperature B $(X_B, y_B)$ of the light emitted from area B and a color temperature X $(_xX, _yx)$ of the light emitted from area X. In this case, as shown in Fig. 14A, the color temperature X $(X_x, y_x)$ may lie on a straight line linking the color temperature A $(x_A, y_A)$ and the color temperature B$(X_B, y_B)$ and, as shown in Fig. 14-1B, the color temperature X $(X_x, y_x)$ may not lie on a straight line linking the color temperature A $(x_A, y_A)$ and the color temperature B$(X_B, y_B)$.

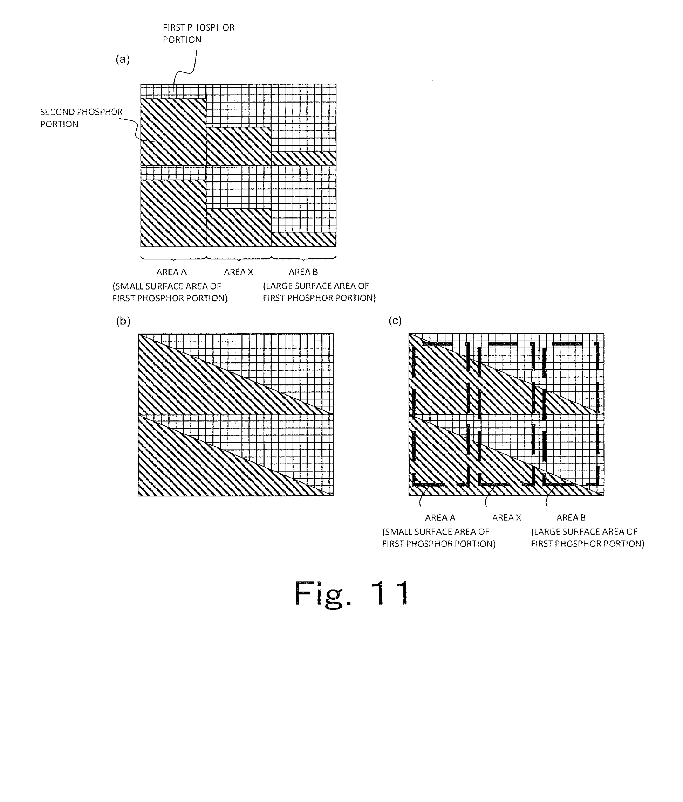

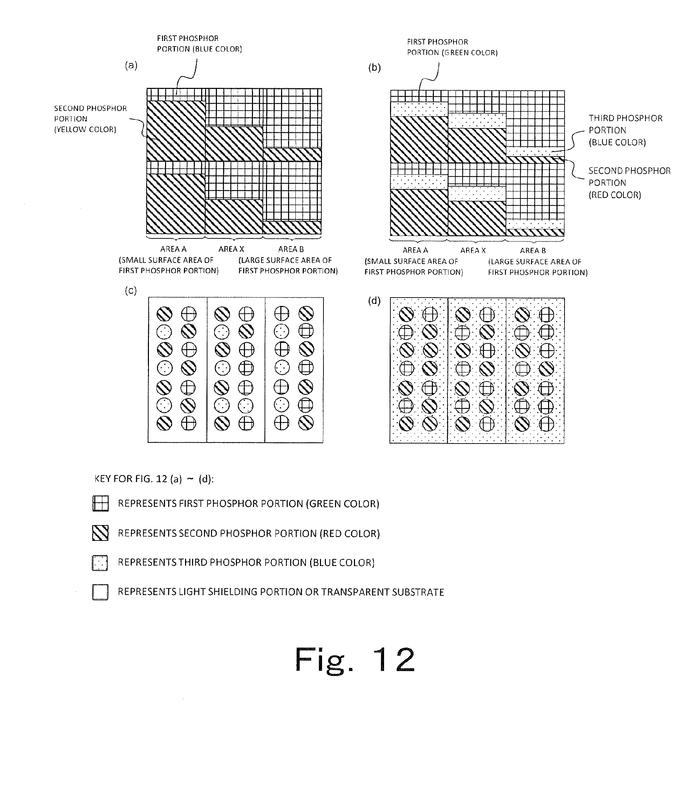

Thus, an example in which the phosphor layer is disposed in order to enable adjustment to an optional color temperature which lies on a straight line linking the color temperature A of the light emitted from area A and the color temperature X of the light emitted from area X or an optional color temperature which lies on a straight line linking the color temperature B of the light emitted from area B and the color temperature X of the light emitted from area X is shown in Figs. 11A to 11C and Figs. 12A to 12D.

The areas A, B, and X in the phosphor layer may be provided clearly marked as per Fig. 11A or may be provided without being clearly marked as per Fig. 11B. In the latter case, as shown in Fig. 11C, optional ranges which comprises two or more first phosphor portions and two or more second phosphor portions can each be assigned to areas A, B, and X. Note that the first phosphor portions and second phosphor portions in the phosphor layer may be provided so as to span the areas A, B, and X as per Fig. 11C.

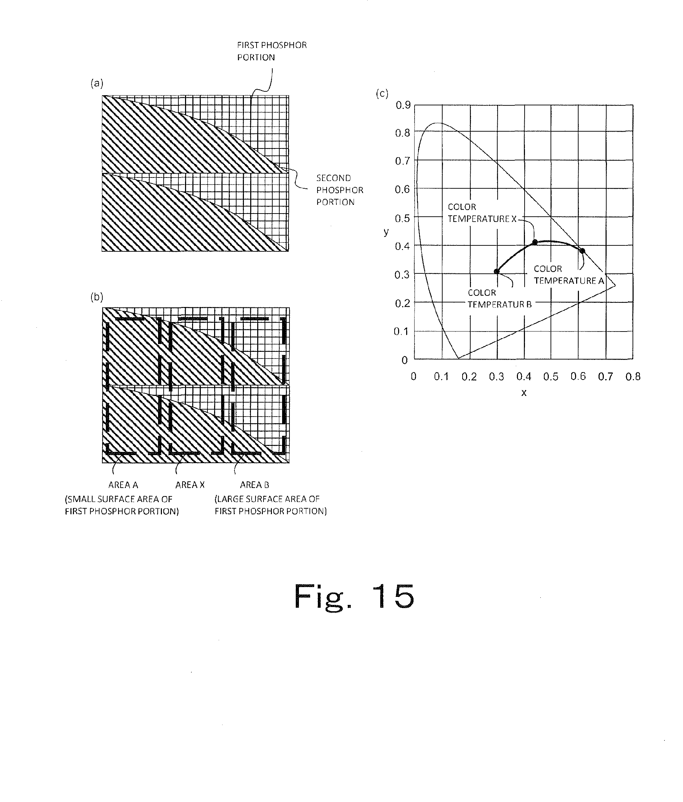

In a case where the phosphor layer is configured as per Figs. 15A and 15B, by moving the phosphor layer or semiconductor light emitting element, it is possible to continuously adjust the color temperature of the light emitted by the light emitting device to an optional color temperature, in the chromaticity diagram, which lies on a curve linking a color temperature A $(X_A, y_A)$ of the light emitted from area A, a color temperature X $(X_x, y_x)$ of the light emitted from area X, and a color temperature B $(X_B, y_A)$ of the light emitted from area B. In this case, as shown in Fig. 15C, for example, the color temperature of the light emitted by the light emitting device can be continuously adjusted along a black-body radiation curve by aligning the color temperature A, color temperature X, and color temperature B on a black-body radiation curve. Further, by setting the color temperatures A, X, and B at a slight displacement from the black-body radiation curve, for example by setting the deviation duv from the black-body radiation curve as -0.02 ≤ duv ≤ 0.02, the color temperature of the light emitted by the light emitting device can be continuously adjusted in a range where the deviation duv from the black-body radiation curve is -0. 02 ≤ duv ≤ 0.02, where duv is a value defined according to JIS Z 8725:1999.

Furthermore, the phosphor layer of the present invention may also be afforded a desirable aspect based on thickness rather than the surface area of the phosphor portions.

More specifically, the phosphor layer of the present invention preferably satisfies the condition of formula [2] below when the sum total of the thickness of the 1Ath phosphor portion of area A is $T_{A1}$, the sum total of the thickness of the 2Ath phosphor portions of area A is $T_{A2}$, the sum total of the thickness of the 1Bth phosphor portions of area B is $T_{B1}$, and the sum total of the thickness of the 2Bth phosphor portions of area B is $T_{B2}$.

$$T_{A2}/T_{A1} \neq T_{B2}/T_{B1} \ldots [2]$$

When considering a case where the phosphor contained in the first phosphor portions is green and the phosphor contained in the second phosphor portions is red, similarly to the case of formula [1] above, formula [2] above represents different proportions for green phosphor and red phosphor in the areas A and B. That is, different emission spectra, for example, color temperatures of the emitted light color are represented in areas A and B. An area with a larger amount of red phosphor has a lower emitted light color temperature, that is, emits white light like that of a light bulb, and an area with a smaller amount of red phosphor has a higher emitted light color temperature, that is, emits pale white light like that of a fluorescent lamp. Because the phosphor layer comprises two areas of different emitted light color temperatures, the color temperature of the emitted light color can be tuned by adjusting the proportion of the light irradiated onto areas A and B from the semiconductor light emitting element, in the phosphor layer.

Accordingly, simply by adjusting the ratio between the thicknesses of the first phosphor portions and second phosphor portions contained in areas A and B in the phosphor layer, it is possible to easily adjust the emission spectrum of the light which is a combination of the light emitted from area A and the light emitted from area B. The light emitting device is configured using the phosphors and the semiconductor light emitting element and the emission spectrum of the light emitting device can easily be tuned by adjusting the proportion of the light irradiated onto areas A and B from the semiconductor light emitting element.

Note that the foregoing $S_{A1}$, $S_{A2}$, $S_{B1}$, and $S_{B2}$, and $T_{A1}$, $T_{A2}$, $T_{B1}$, and $T_{B2}$ can be obtained by using an optical microscope to measure the surface area occupied by each of the phosphor portions in each area of the phosphor layer, on the face on the light-emission side of the light emitting device, or by measuring the cross section of the phosphor layer using an optical microscope.

<3. Semiconductor light emitting element>

The semiconductor light emitting element of the present invention emits the excitation light of the phosphor contained in the first phosphor portions and second phosphor portions. The wavelength of the excitation light is 350 nm or more and 520 nm or less, preferably at least 370 nm, and more preferably at least 380 nm. Further, this wavelength is preferably not more than 500 nm and more preferably not more than 480 nm.
In particular, in a case where the light emitted by the semiconductor light emitting element is light in the near-ultraviolet range or violet range and where a light emitting device is configured which emits white light as a result of a blue phosphor, green phosphor and red phosphor being excited by this light, a light emitting device with superior color rendering properties can preferably be provided.

Specific examples of the semiconductor light emitting element which may be given include semiconductor light emitting elements which use a InGaAlN, GaAlN or InGaAlN semiconductor or similar for which crystal growth is performed using the MOCVD method or the like on a silicon carbide, sapphire, or gallium nitride substrate. In the light emitting device of the present invention, a plurality of semiconductor light emitting elements are preferably used aligned in a planar shape. The present invention is preferably used in a light emitting device which comprises such a large emission surface area.

<4. Further members which may be included in the light emitting device of the present invention>

The light emitting device of the present invention can comprise a package for holding a semiconductor light emitting element and which has an optional shape and material. Specific shapes which can be used are plate shape, cup shape, or any suitable shape depending on the application. Among these shapes, a cup-shaped package is preferable since this shape is able to retain directivity in the light emission direction and is able to effectively use the light emitted by the light emitting device. In a case where a cup-shaped package is adopted, the surface area of the opening for emitting light is preferably 20% or more and 600% or less of the base surface area. Further, possible package materials which can be used include suitable materials depending on the application such as inorganic materials such as metals, glass alloys and carbons, and organic materials such as synthetic resins.

If a package is used in the present invention, a material with a high reflectance across the whole near-ultraviolet and visible light ranges is preferable. Highly reflective packages of this type include packages which are formed of silicone resin and which comprise light scattering particles. Possible examples of light scattering particles include titania and alumina.

The light emitting device of the present invention can also comprise a bandpass filter on the semiconductor light emitting element side of the light emitting device and/or on the light emission direction side of the light emitting device. A bandpass filter possesses the property of passing only light of predetermined wavelengths and enables control of the light emission in the near-ultraviolet and ultraviolet ranges from the light emitting device. Commercial bandpass filters can suitably be used in the present invention, where the type of bandpass filter is suitably selected according to the type of semiconductor light emitting element.

Further, metal wiring for supplying power from the outside to the semiconductor light emitting element and a cap to protect the light emission direction side of the phosphor layer, and so on, can be suitably disposed.

<5. Overview of the light emitting device of the present invention>

The light emitting device of the present invention comprises an area A and an area B with different emission spectra in the phosphor layer, for example different emitted light color temperatures, and the emission spectrum of the light emitted by the light emitting device can be continuously tuned by adjusting the proportion of the light irradiated onto the areas A and B from the semiconductor light emitting element.

In order to adjust the proportion of light irradiated onto the areas A and B, the phosphor layer or semiconductor light emitting element may be moved so as to change the relative positional relationship between the phosphor layer and semiconductor light emitting element, for example, the phosphor layer or semiconductor light emitting element may be moved in a direction perpendicular to the thickness direction of the phosphor layer. Further, the semiconductor light emitting element may comprise a light distribution member such as a light distribution lens and the tilt angle of the optical axis of the light distribution member relative to the thickness direction of the phosphor layer may be adjusted. Furthermore, reflective-type light emitting device may be adopted in which the light emitted by the semiconductor light emitting element falls incident on the reflective member once and the light reflected by the reflective member is introduced to the phosphor layer, and the tilt angle of the optical axis of the light reflected by the reflective member relative to the thickness direction of the phosphor layer may be adjusted. Further, a semiconductor light emitting element A and a semiconductor light emitting element B may be provided in areas A and B respectively and the amount of power fed to the respective semiconductor light emitting elements may be adjusted.

Explained in more specific terms, in Fig. 1-1 the light emission area is adjusted by moving the phosphor layer perpendicularly to the thickness direction of the phosphor layer but, as shown in Fig. 1-2, the light emission area can be adjusted by providing a configuration in which a light distribution member comprising a rotational axis is installed between the semiconductor light emitting element and the phosphor layer so that the light distribution member is able to turn about the rotational axis. Further, as per Fig. 1-3, the light emission area can also be adjusted by providing a configuration in which a semiconductor light emitting element is disposed such that the light from the semiconductor light emitting element does not strike the phosphor layer directly and a reflective member comprising a rotational axis is disposed so that the light emitted by the semiconductor light emitting element can be reflected toward the phosphor layer and the reflective member is able to turn about the rotational axis. In addition, as per Fig. 1-4, a semiconductor light emitting element A and a semiconductor light emitting element B may be provided in areas A and B respectively and the amount of power fed to the respective semiconductor light emitting elements may be adjusted.

Furthermore, as per Fig. 5-1, a plurality of semiconductor light emitting elements can be provided in each of the areas A and B, for example four semiconductor light emitting elements A and four semiconductor light emitting elements B, and the proportion of light irradiated onto the areas A and B can be adjusted by turning on some of the semiconductor light emitting elements and turning off the other semiconductor light emitting elements. For example, as per Fig. 1-5A, in a case where only four semiconductor light emitting elements, provided directly below area A, are turned on, light is emitted from the area A; as per Fig. 1-5C, in a case where only four semiconductor light emitting elements, provided directly below area B are turned on, light is emitted from area B; as per Fig. 1-5B, in a case where only two semiconductor light emitting elements provided directly below area A and two semiconductor light emitting elements provided directly below area B are turned on, light from both area A and area B is emitted. Accordingly, by changing the positions of the turned on semiconductor light emitting elements while maintaining a fixed number of the turned on semiconductor light emitting elements, the color temperature of the light can be adjusted without markedly changing the intensity of the light emitted by the light emitting device.

Area A and area B of the phosphor layer are areas of different emission spectra for the light emitted from the respective areas. Hence, because the emission spectrum of the light emitted from the light emitting device can be continuously adjusted by changing the proportions of the area A and area B which occupy the optical emission area of the light emitting device, a light emitting device which emits light of the desired emission spectrum can be provided.

In order to provide areas A and B of different emission spectra, the phosphor portions may be disposed so as to satisfy general formula [1] above.

Suitable aspects of areas A and B according to the present invention include suitable combinations of the following aspects (a) to (c), for example:

(a) an aspect in which red and green phosphors are coated for use with a semiconductor light emitting element which emits wavelengths in the blue color range.
(b) an aspect in which red, green, and blue phosphors are coated for use with a semiconductor light emitting element which emits wavelengths in the near ultra-violet or violet range.
(c) an aspect in which blue and yellow phosphors are coated for use with a semiconductor light emitting element which emits wavelengths in the near ultra-violet or violet range.

Since the phosphor layer of the present invention which comprises such areas A and B is designed to be larger than the light emission surface area of the light emitting device, by moving the phosphor layer so as to change the relative positions of the phosphor layer and semiconductor light emitting element, it is possible to adjust the proportions of light of two types of different spectra in the light emitted from area A and the light emitted from area B. More specifically, by moving the phosphor layer in a direction perpendicular to the thickness direction of the phosphor layer, it is possible to adjust the proportions of two types of light of different emission spectra in the light emitted from area A and the light emitted from area B. If the phosphor layer is not moved, the emission spectra can also be adjusted by moving the semiconductor light emitting element (the package is a package is provided). Further, in a case where the light emitting device comprises a housing member, described subsequently, the proportion of the light which is irradiated onto areas A and B from the semiconductor light emitting element can be adjusted by rotationally moving the housing member about the semiconductor light emitting element, and this can also be achieved by rotating the semiconductor light emitting element, and so on.

Possible means for moving or rotationally moving the phosphor layer and/or the semiconductor light emitting element include driving by means of a manual operation, an actuator, and a motor, and the like. The movement direction may either be linear motion or rotational motion.

The phosphor layer of the present invention enables continuous adjustment of the color temperature of the white light from 2800 K to 6500 K by means of a relative changing of the positional relationship between the semiconductor light emitting element and the phosphor layer which comprises areas A and B.

The present invention will be described hereinbelow with reference to embodiments of the light emitting device of the present invention. The present invention is not limited to the following embodiments, rather, optional modifications can be carried out without departing from the spirit and scope of the present invention.

Fig. 1-1 shows a schematic diagram of an overall view of a light emitting device 1 of the present invention.

The light emitting device 1 is a light emitting device in which a semiconductor light emitting element 2 is disposed on a flat face, and the semiconductor light emitting element 2 is disposed on the bottom face of a hollow portion of a package 3. Further, a phosphor layer 4 is disposed in an opening in the package 3.

For the semiconductor light emitting element 2, a near-ultraviolet semiconductor light emitting element which emits light of a wavelength in the near-ultraviolet range, a violet semiconductor light emitting element which emits light of a wavelength in the violet color range, or a blue semiconductor light emitting element which emits light of a wavelength in the blue color range can be used, however in this embodiment a violet semiconductor light emitting element will be described by way of example. Furthermore, as per this embodiment, a single semiconductor light emitting element may be installed or a plurality of semiconductor light emitting elements may be disposed in a planar shape. Further, the light emitting device can also be configured by installing a single large-output semiconductor light emitting element. In particular, configuring a light emitting device either by disposing a plurality of semiconductor light emitting elements in a planar shape or by installing a single large-output semiconductor light emitting element permits straight-forward surface lighting and is therefore preferable.

The package 3 holds the semiconductor light emitting elements and phosphor layer and, in this embodiment, is cup-shaped with an opening and a hollow portion, and the semiconductor light emitting element 2 is disposed on the bottom face of the hollow portion. If the package 3 is cup-shaped, the directivity of the light emitted from the light emitting device can be retained and the emitted light can be better used. Note that the specifications of the hollow portion of the package 3 are set as specifications enabling the light emitting device 1 to emit light in a predetermined direction. Further, the bottom portion of the hollow portion of the package 3 comprises electrodes (not shown) for supplying power to the semiconductor light emitting element from the outside of the light emitting device 1. A highly reflective package is preferably used for the package 3, thereby enabling the light striking the wall surface (tapered portion) of the package 3 to be emitted in a predetermined direction and making it possible to prevent a loss of light.

The phosphor layer 4 is disposed at the opening of the package 3. The hollow portion of the package 3 is covered by the phosphor layer 4 and the light from the semiconductor light emitting element 2 does not pass through the phosphor layer 4 and is not emitted from the light emitting device 1.

The phosphor layer 4 comprises three areas, namely an A area 4a, an X area 4x, and a B area 4b which have different emission spectra, and the size of the phosphor layer 4 is designed to be larger than the size of the opening of the package 3. Further, by horizontally sliding the phosphor layer 4 which is of a greater surface area than the opening of the package 3 while covering the opening of the package 3 (the arrow 8 in the drawing is an example of the horizontal sliding direction of the phosphor layer 4), it is possible to adjust the proportion of light irradiated onto area A and area B from the semiconductor light emitting element 2 and to adjust the emission spectra of the light emitted by the light emitting device 1. The package 3 may also be slid horizontally without horizontally sliding the phosphor layer 4.

For example, in a light emitting device 1 in a case where the color temperature of the emitted light of the A area 4a of the phosphor layer is in a 6500 K high color temperature range, the color temperature of the emitted light of the B area 4b is in a 2800 K low color temperature range, and the color temperature of the emitted light of the X area 4x is a middle color temperature range of 4500 K, the surface areas of the areas A, B, and X are each the same as that of the opening of the package, a pale white light with a color temperature of 6500 K is emitted if the opening of the package 3 is completely covered by the A area 4a of the phosphor layer, and a white light with a color temperature of approximately 3700 K which is intermediate between 2800 K and 4500 K is emitted if the opening of the package 3 is covered approximately by a half each by the A area 4a and the X area 4x. Meanwhile, a white light of a color temperature of approximately 5500 K which is intermediate between 4500 K and 6500 K is emitted if the opening is covered approximately by a half each by the X area 4X and the B area 4b. However, a white light like that of a light bulb with a color temperature of 2800 K is emitted if the opening of the package 3 is completely covered by a B area 4b. Thus, because the color temperature of the emitted light can be continuously adjusted by moving the area of the phosphor layer which covers the opening of the package 3, a light emitting device which emits light of the desired color temperature can be provided.

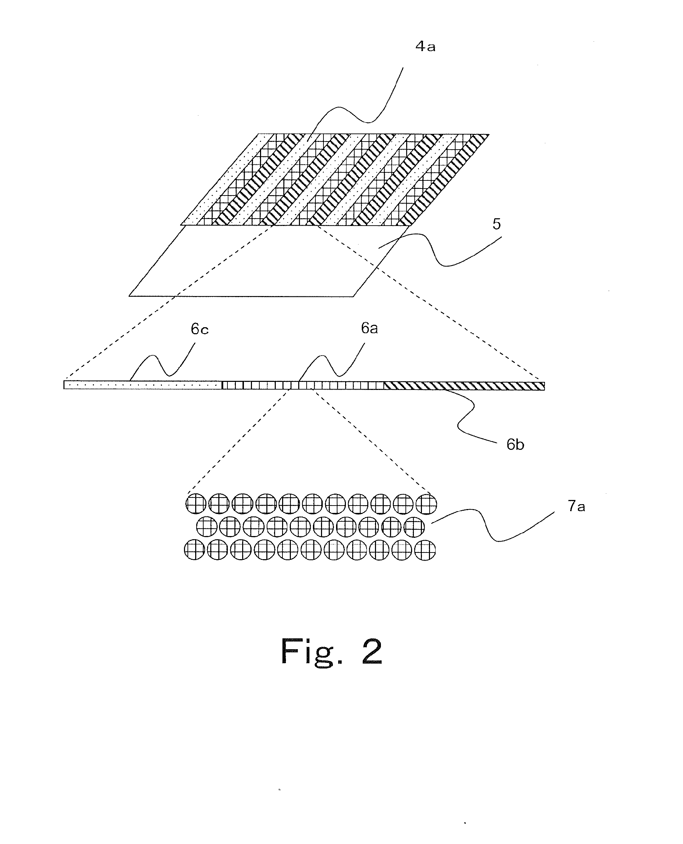

Fig. 2 shows a detailed schematic diagram of the phosphor layer 4. The phosphor layer 4 is formed on a transparent substrate 5 which transmits near-ultraviolet light and visible light. Using the transparent substrate 5 enables screen printing and the formation of the phosphor layer 4 is straightforward. The phosphor layer 4 which is formed on the transparent substrate is a layer with a thickness of not more than 1 mm and comprises the first phosphor portion 6a to the third phosphor portion 6c.

The first phosphor portion 6a is a phosphor portion which comprises a green phosphor 7a in this embodiment, and emits light in the green color range which is a longer component than the light in the violet color range as a result of being excited by the light of the violet semiconductor light emitting element 2.

The second phosphor portion 6b is a phosphor portion which comprises a red phosphor in this embodiment and emits light in the red color range which is a longer component than the light in the green color range emitted by the green phosphor contained in the first phosphor portion as a result of being excited by the light of the violet semiconductor light emitting element 2.

The third phosphor portion 6c is a phosphor portion which comprises a blue phosphor in this embodiment and is provided in order to generate white light.

The phosphor portions are suitably selected according to the types of semiconductor light emitting element used, with the foregoing third phosphor portion being unnecessary in a case where a blue semiconductor light emitting element is used because the light from the blue semiconductor light emitting element can be used as is as blue light for generating white light. Further, the phosphor portions are each provided such that the surface area of the part with a plurality of types of phosphor in the thickness direction of the phosphor layer is 0% or more and 20% or less of the light emission surface area of the light emitting device of the phosphor layer, that is, of the surface area of the opening of the package 3. Since there is a plurality of phosphor portions in the light emission surface area, the surface area of the part with a plurality of types of the foregoing phosphor is calculated as the sum total of the surface areas of the plurality of parts.

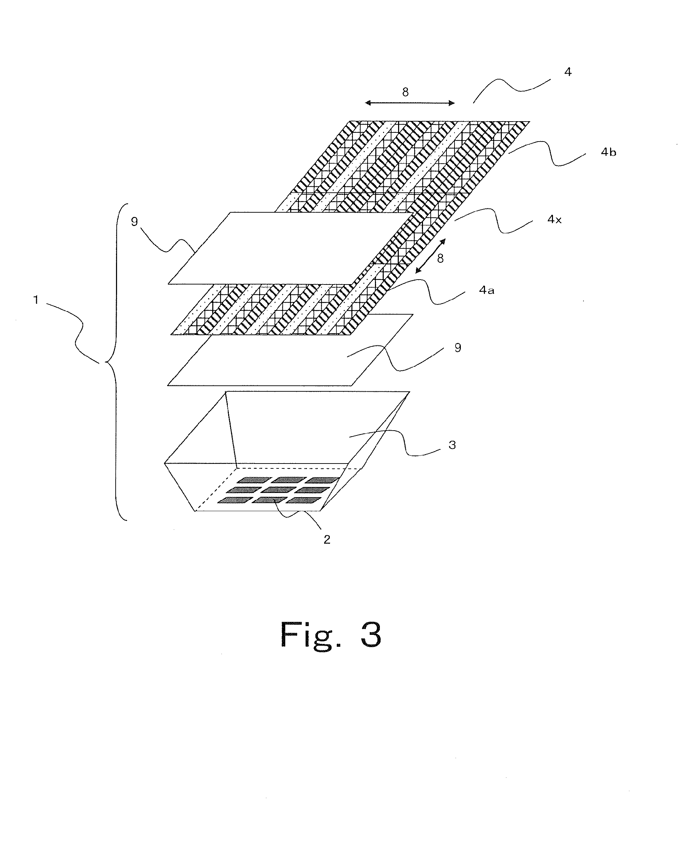

Thus far, the embodiment of Fig. 1 has been described, but other embodiments can also be adopted. More specifically, as shown in Fig. 3, a bandpass filter 9 can be provided on the light emission side and/or the semiconductor light emitting element side of the light emitting device of the phosphor layer 4. Here, the "light emission side of the light emitting device of the phosphor layer 4" indicates, of the surface in a direction perpendicular to the thickness direction of the phosphor layer 4, the side of the surface from which light is emitted to the outside of the light emitting device, that is, using Fig. 3 to illustrate, the upper part of the phosphor layer 4. Further, "the semiconductor light emitting element side of the phosphor layer 4" indicates, of the surface in a direction perpendicular to the thickness direction of the phosphor layer 4, the surface side from which light is emitted to the inside of the light emitting device, that is, using Fig. 3 to illustrate, the lower part of the phosphor layer 4.

The bandpass filter 9 possesses the property of passing only light of predetermined wavelengths, and by providing a bandpass filter, which reflects at least a portion of the light emitted by the semiconductor light emitting element and transmits at least a portion of the light emitted by the phosphor, between the package 3 and the phosphor layer 4, the fluorescent light emitted by the phosphor can be prevented from entering the package once again, thereby raising the emission efficiency of the light emitting device. On the other hand, by providing a bandpass filter which reflects at least a portion of the light emitted by the semiconductor light emitting element and transmits at least a portion of the light emitted by the phosphor, on the light emission side of the light emitting device of the phosphor layer 4, the light emitted by the semiconductor light emitting element which is not absorbed by the phosphor and passes through can be returned once again to the phosphor layer to excite the phosphor, thereby raising the emission efficiency of the light emitting device. The bandpass filter is suitably selected according to the semiconductor light emitting element 2. Further, as per Fig. 3, by installing a plurality of semiconductor light emitting elements in a planar shape, of the light emitted from the semiconductor light emitting element, the proportion of the light which enters in the thickness direction of the bandpass filter can be increased, thereby enabling the bandpass filter to be used more efficiently.

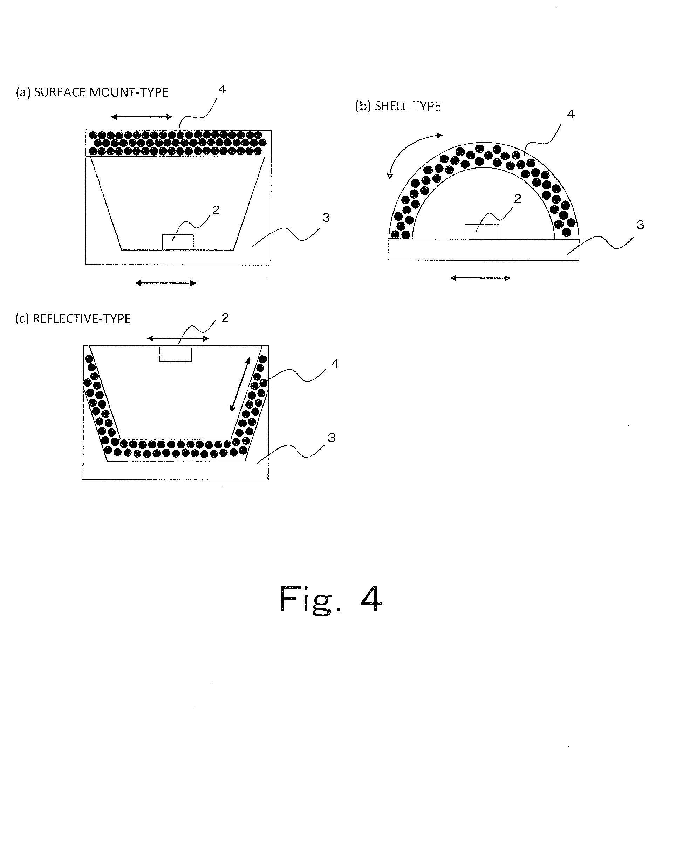

Moreover, further embodiments may be adopted. More specifically, Fig. 4 show a schematic diagram of another embodiment for the installation of the semiconductor light emitting element 2, the package 3, and the phosphor layer 4. Fig. 4A is an embodiment of Fig. 1, and is an embodiment in which the phosphor layer 4 is disposed in the opening of the package 3. The disposition is designed to enable the phosphor layer 4 or the package 3 to move in the arrow direction. The light emitted by the semiconductor light emitting element 2 is converted into fluorescent light of the phosphor layer 4 and is emitted outside the device.

Fig. 4B shows an aspect in which disposition is such that the periphery of the semiconductor light emitting element 2 is covered by the phosphor layer 4. The disposition is such that the phosphor layer 4 can be moved in the arrow direction and the package 3 can be moved in the arrow direction. The light emitted by the semiconductor light emitting element 2 is converted into fluorescent light in the phosphor layer 4 and is emitted outside the device.

Fig. 4C shows an aspect in which the phosphor layer 4 is placed on the surface of the package 3 and the semiconductor light emitting element 2 is held by a transparent member which is provided in the opening so as to emit light in a downward direction in the drawing. Installation is such that the phosphor layer 4 can be moved in the arrow direction along the shape of the hollow portion of the package 3 and such that the semiconductor light emitting element 2 can be moved in the direction of the arrow. The light which is emitted from the semiconductor light emitting element 2 is fluorescent light in the phosphor layer 4, and the fluorescent light is reflected by the package 3 comprising the reflective member and emitted outside the device.

In the embodiments shown in Fig. 4, the semiconductor light emitting element 2 and phosphor layer 4 are a distance apart, and this distance is preferably at least 0.1 mm, more preferably at least 0.3 mm, even more preferably at least 0. 5 mm, and particularly preferably at least 1 mm, and preferably not more than 500 mm, more preferably not more than 300 mm, even more preferably not more than 100 mm, and particularly preferably not more than 10 mm. With this arrangement, it is possible to prevent a weakening of the excitation light for each unit area of the phosphor and degradation of the light of the phosphor, and even if the temperature of the semiconductor light emitting element rises, a rise in the temperature of the phosphor layer can be alleviated.

<First embodiment of light emitting device>

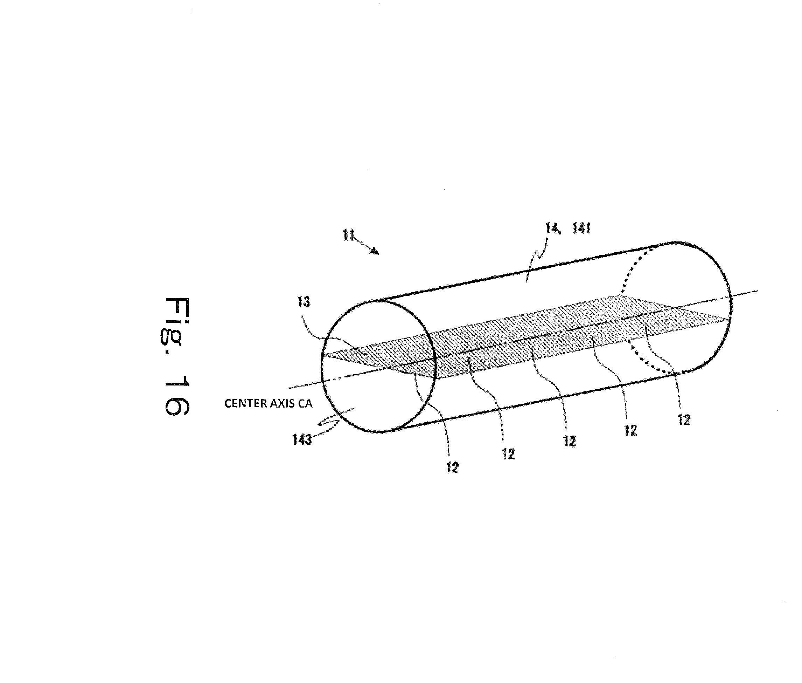

Fig. 16 is a perspective view schematically showing the overall configuration of the light emitting device 1 according to the first embodiment. The light emitting device 11 is a light emitting device which uses a light emitting diode as the light source and enables the color temperature of the output light to be adjusted. For example, the light emitting device 11 is a white light emission device which permits the selective output of daylight color or light bulb color light. The light emitting device 11 comprises, as main members, a light emitting diode (LED) 12, a substrate 13 whereon the light emitting diode 12 is disposed, and a cylindrical housing member 14 in which the substrate 13 is housed. The light emitting diode 12 corresponds to the semiconductor light emitting element of the present invention.

In this embodiment, the housing member 14 comprises a cylindrical shape. However, as long as the housing member 14 has a cylindrical shape, the housing member 14 may also be formed as a polygonal cylindrical shape. In the drawings, the center axis of the housing member 14 is denoted by the reference sign CA. An end face opening 143 is open at both ends of the housing member 14.

As shown in the drawing, the interior of the housing member 14 houses the substrate 13 which comprises a rectangular flat plate shape. The substrate 13 is integrally fixed to a fixed member for fixing the light emitting device 11 to an attachment target such as a ceiling, for example. For example, in a state where the light emitting device 11 is suspended from the ceiling, under normal usage conditions the substrate 13 is fixed to the ceiling and adopts an idle posture.

A plurality (multiplicity) of light emitting diodes 12, which act as light sources, are mounted on the substrate 13. In addition to functioning as a holder for holding the light emitting diodes 12 as mentioned earlier, the substrate 13 is a circuit substrate printed with a circuit for supplying power from the outside to the light emitting diodes 12. In this embodiment, an illustration of the circuit for controlling the power supplied to the light emitting diodes 12 is omitted.

As illustrated, the light emitting diodes 12 are arranged along the longitudinal direction of the substrate 13. The longitudinal direction of the substrate 13 as it is intended here matches the direction along the center axis CA of the housing member 14. However, the disposition example of the light emitting diode 12 shown is for illustrative purposes and the disposition is not limited to this example. Further, normally, although mounting a plurality of light emitting diodes 12 on the substrate 13 is preferable in order to meet requirements from the standpoint of the light emission amount needed, a single light emitting diode 12 may also be mounted on the substrate.

The housing member 14 is formed of phosphor material. More specifically, a phosphor layer 141 which comprises phosphor which is excited by the excitation light emitted by the light emitting diode 12 is formed on the housing member 14. The phosphor layer 141 comprises a phosphor as described earlier and converts the light from the light emitting diode 12 to a longer wavelength light and emits the light to the outside of the housing member 14. The phosphor layer 141 is configured comprising a plurality of phosphor areas of different emission spectra as will be described subsequently.

The housing member 14 is configured by coating various phosphors on a base material which possesses transparency for transmitting near-ultraviolet light and visible light. There are no particular restrictions on the materials which can be used for the transparent base material as long as the material is transparent to near-ultraviolet light and visible light, and glass and plastic (for example epoxy resin, silicone resin, acrylic resin, polycarbonate resin and the like) and so on can be used. Glass is preferable from the standpoint of durability in the case of excitation with wavelengths in the near-ultraviolet range.

The light emitting diode 12 is a semiconductor light emitting element which emits the excitation light of the phosphor contained in the phosphor layer 141. The phosphor coated on the transparent base material of the housing member 14 can be suitably selected according to the wavelength of the light emitted by the light emitting diode 12. The light emitting device 11 according to this embodiment irradiates the excitation light emitted by the light emitting diode 12 onto various phosphors contained in the phosphor layer 141. The light emitting device 11 then emits white light to the outside by emitting light of a longer wavelength than the excitation light from the phosphor.

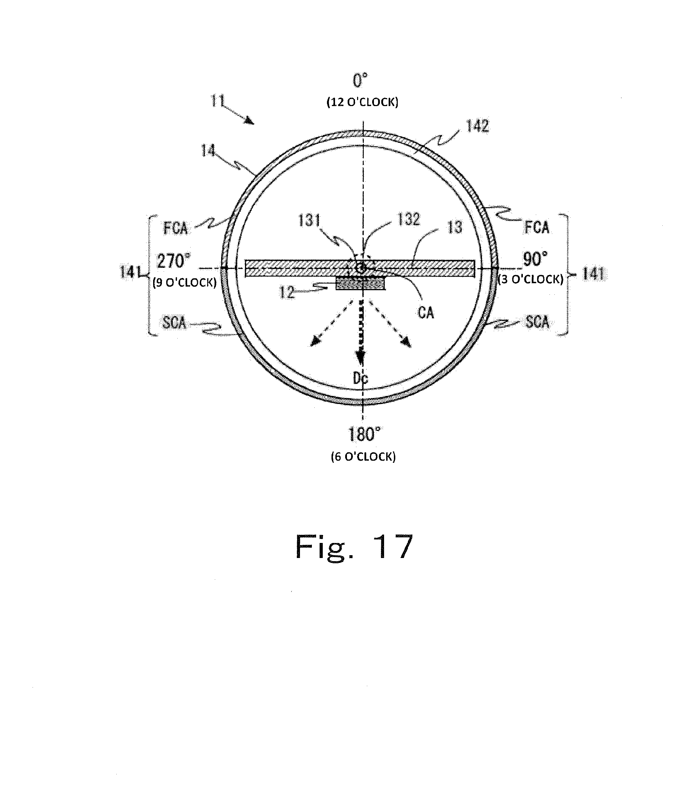

Fig. 17 schematically shows a cross section in a direction orthogonal to the center axis CA shown in Fig. 16 (hereinafter called a "axis orthogonal cross section"). As shown in the drawing, the light emitting diode 12 is provided only on one side of the substrate 13 (on the lower edge of the bottom face in the drawing). In the illustrated example, the substrate 13 is housed in the housing member 14 such that the center position in the thickness direction of the substrate 13 coincides with the center axis CA of the housing member 14.

The arrows indicated by a broken line in the drawing schematically indicate the directions of the light emitted by the light emitting diode 12. Among these broken line arrows, the arrow to which reference sign Dc is assigned represents an irradiation center direction. The irradiation center direction Dc signifies the center direction of the excitation light irradiated with directivity.

The light emitting device 11 described in this embodiment is provided on a ceiling such that the orientation of the substrate 13 in the housing member 14 is parallel to the ceiling. Of the faces of the substrate 13, the face facing the ceiling is called the "upper face" and the other face is called the "lower face." Here, the irradiation target area in this embodiment is below the light emitting device 11 and hence the light emitting diode 12 is disposed on the lower face of the substrate 13. However, as will be described subsequently, the light emitting diode 12 may be disposed on both the upper face and lower face of the substrate 13.

A configuration for modifying the color temperature of the output light in the light emitting device 11 according to the present invention will be described next. Here, an aspect in which daylight color and light bulb color, which have relatively different color temperatures, are suitably selected and output will be described by taking, by way of example, a case where the wavelength of the excitation light of the light emitting diode 12 is in the near-ultraviolet range or violet range.

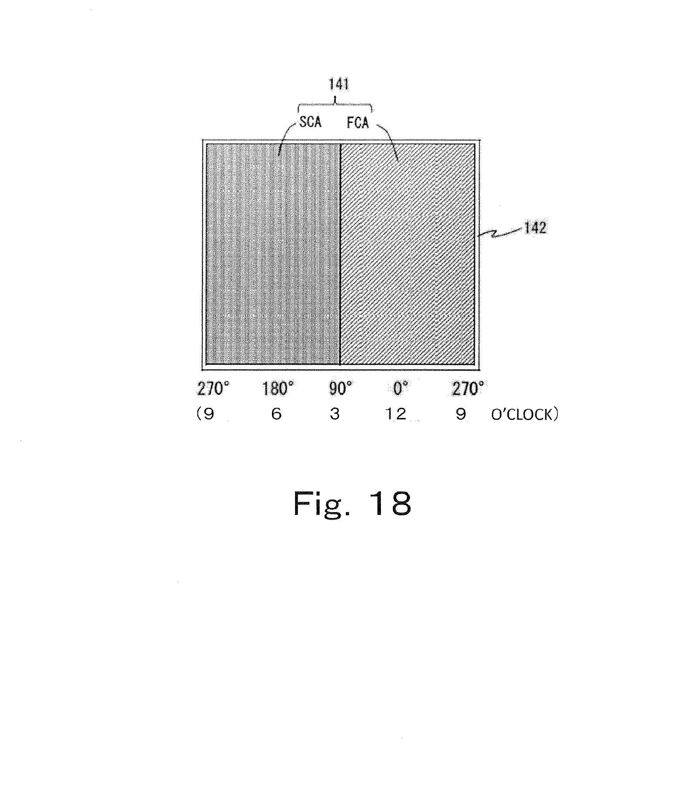

Fig. 18 is a development view of the housing member 14 which has a cylindrical shape. Reference sign 142 represents the transparent base material. The transparent base material forms a rectangular shape in a developed state as shown. The positions 0° (12 o'clock), 90° (3 o'clock), 180° (6 o'clock), and 270° (9 o'clock) of the developed state in Fig. 18 each correspond to the same positions in the cylindrically molded state in Fig. 17.

Phosphor which is excited by the light emitted by the light emitting diode 12 is coated on the surface of the transparent base member. Here, the excitation light emitted by the light emitting diode 12 is near-ultraviolet light or ultraviolet light, and hence blue, green, and red phosphors are mixed together and coated on the transparent base material. The various phosphors may be formed, for example, by forming a phosphor paste on the transparent base material using screen printing or using inkjet printing, or may be formed using a transfer process or by using an exposure-type coating method which is used to coat a Cathode Ray Tube (CRT), or the like. However, the phosphor layer 141 may also be formed on the transparent base material by means of other methods.

The area on the transparent base material is divided into two parts, namely, a first fluorescent area (area A) FCA and a second fluorescent area (area B) SCA. The first fluorescent area (area A) FCA has a high blue phosphor content in comparison with the second fluorescent area (area B) SCA. In other words, the first fluorescent area (area A) FCA has a low red or green phosphor content in comparison with the second fluorescent area (area B) SCA. As a result, the emission spectrum of light emitted by the first fluorescent area (area A) FCA as a result of the excitation light from the light emitting diode 12 is short in comparison with the emission spectrum in the second fluorescent area (area B) SCA. Accordingly, the color temperature of the emission color in the first fluorescent area (area A) FCA can be set high in comparison with the second fluorescent area (area B) SCA.

For example, the color temperature of the emission color of the first fluorescent area (area A) FCA can be made a 6500 K high color temperature area and daylight color white light may be emitted from this area. Further, the color temperature of the emission color of the second fluorescent area (area B) SCA may be in a 2800 K low color temperature area, for example, and light bulb color white light may be emitted from this area.

As a variation of the phosphor layer 141 according to this embodiment, phosphor portions on which blue, green, and red phosphors are individually coated may be disposed on a transparent base material, for example. In this case, the phosphor portions each have a phosphor of a single type and various shapes and layout patterns may be adopted. Further, color mixing is possible by adjusting the ratio between the surface areas of the phosphor portions containing these phosphors. For example, supposing that a phosphor portion comprising a blue phosphor is a blue phosphor portion and a phosphor portion comprising a red phosphor is a red phosphor portion, by affording the first fluorescent area (area A) FCA a blue phosphor portion surface area ratio which is large in comparison with the second fluorescent area (area B) SCA and affording the second fluorescent area (area B) SCA a red phosphor portion surface area ratio which is large in comparison with the first fluorescent area (area A) FCA, the color temperature of the emission color in the first fluorescent area (area A) FCA may be set higher than the second fluorescent area (area B) SCA.

The phosphor layer 141 according to this embodiment comprises a plurality of fluorescent areas of different emission spectra and which are formed in different positions in a peripheral direction of the housing member 14. In the example shown in Fig. 17, the plurality of fluorescent areas divide the phosphor layer 141 in the peripheral direction and are formed as areas along the direction of the center axis CA of the housing member 14.

Here, an example in which the phosphor layer 141 comprises a first fluorescent area (area A) FCA and a second fluorescent area (area B) SCA which have mutually different emission spectra is described. The first fluorescent area (area A) FCA and the second fluorescent area (area B) SCA are disposed so as to divide the phosphor layer 141 into two equal parts in the peripheral direction. In the illustrated example, the first fluorescent area (area A) FCA is formed in an area which corresponds to an angle about the center axis CA of the housing member 14 of 270° to 90°, and the second fluorescent area (area B) SCA is formed in a range corresponding to 90° to 270°.

The housing member 14 is provided turnably about the center axis CA in a state where the substrate 13 is fixed. An axle-like protruding member 131 which is co-axial to the center axis CA is protrudingly provided on the substrate 13 so as to extend from the short edge toward the end face opening 143, and a ring-like axle support member 132 is turnably supported by the axle-like protruding member 131. In Fig. 17, the axle-like protruding member 131 and the axle support member 132 are indicated by broken lines. The axle-like protruding member 131 and axle support member 132 are provided on both the short edges of the substrate 13.

The housing member 14 is connected via a connecting member (not illustrated) to the axle support member 132. Therefore, the housing member 14, which is integrally connected to the axle support member 132, also turns about the axle-like protruding member 131 as a result of the axle support member 132 turning about the axle-like protruding member 131. Here, the axle-like protruding member 131 is provided integral to the substrate 13. Accordingly, the housing member 14 can be made to turn about the center axis CA in a state where the substrate 13 is idle by causing the axle support member 132 to turn about the axle-like protruding member 131. That is, the housing member 14 can be made to turn relative to the substrate 13.

Means which can be suitably adopted as means for causing the axle-like protruding member 131 to turn relative to the axle support member 132, that is, means for causing the housing member 14 to turn relative to the substrate 13, include driving means such as manual operation, an actuator, and a motor. In a case where the housing member 14 is turned manually, a pull (cord) switch system can be adopted, for example. In this case, each time the pull switch is switched by means of a user switching operation, the housing member 14 comes to turn 180° about the center axis CA.

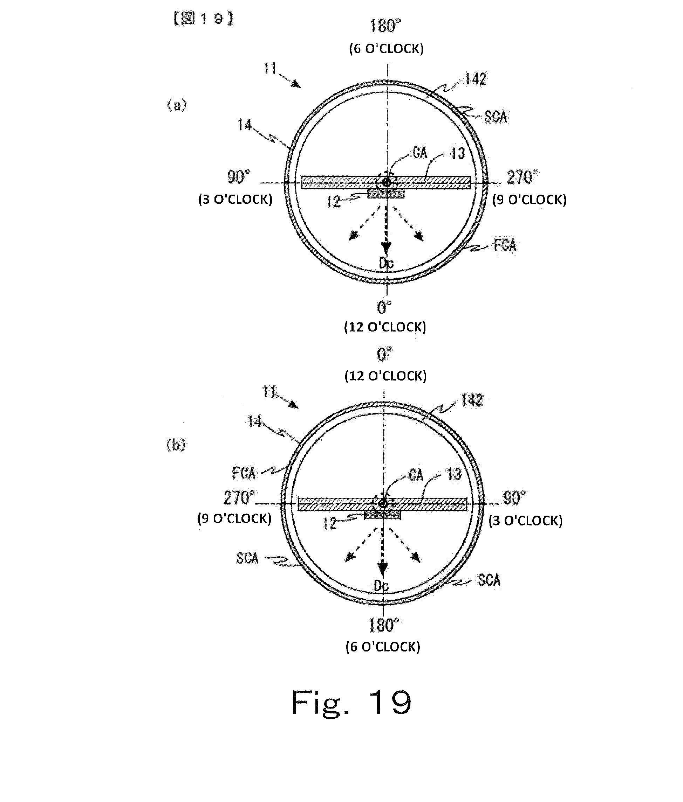

Accordingly, the states in Figs. 19A and 19B are switched each time there is a pull switch operation. Fig. 19A shows a state where the irradiation center direction Dc of the excitation light from the light emitting diode 12 coincides with the 12 o'clock (0°) direction and the first fluorescent area FCA is excited by the excitation light of the light emitting diode 12. Meanwhile, Fig. 19B shows a state where the irradiation center direction Dc coincides with the 6 o'clock (180°) direction, and the second fluorescent area (area B) SCA is excited by the excitation light of the light emitting diode 12. Thus, in the light emitting device 11 according to this embodiment, by adjusting the relative turn position of the housing member 14 relative to the substrate 13, the target fluorescent area which is irradiated with the excitation light emitted by the light emitting diode 12 can be selectively switched between either of the first fluorescent area (area A) FCA and the second fluorescent area (area B) SCA.

Therefore, as per the state shown in Fig. 19A, by irradiating the first fluorescent area (area A) FCA with the excitation light from the light emitting diode 12, the excitation light can be converted to daylight color white light and emitted to the outside from the housing member. On the other hand, as per the state shown in Fig. 19B, light bulb color white light can be emitted by irradiating the second fluorescent area (area B) SCA with the excitation light from the light emitting diode 12.

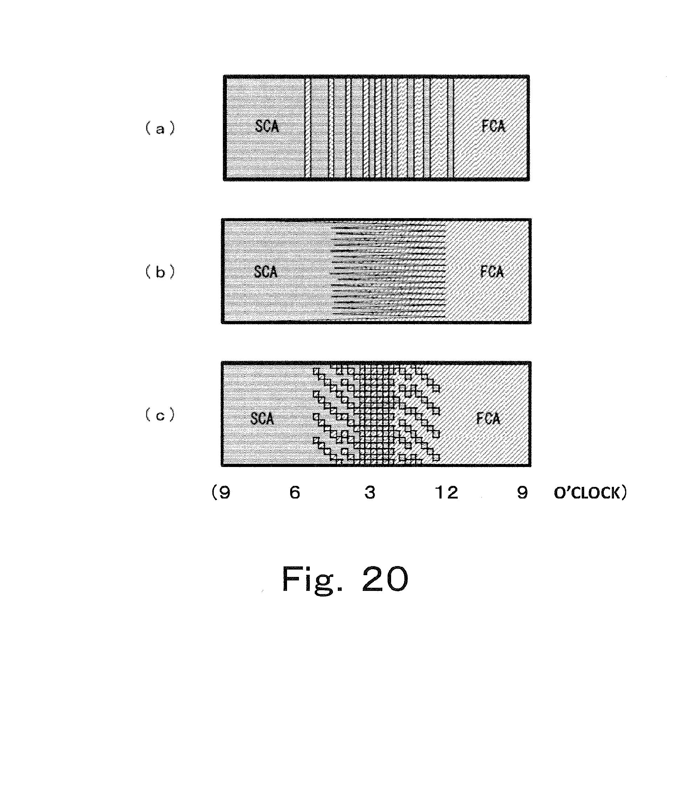

Furthermore, as shown in Figs. 20A to 20C, in an area of a predetermined angle which is centered on the interface portion between the first fluorescent area (area A) FCA and the second fluorescent area (area B) SCA in the phosphor layer 141 may be formed having a gradation pattern of the first fluorescent area (area A) FCA and the second fluorescent area (area B) SCA. In this gradation pattern, the foregoing gradation pattern is formed in an angular range between roughly 6 o'clock and 12 o'clock. In this gradation pattern, the surface area ratio of the first fluorescent area (area A) FCA relative to the second fluorescent area (area B) SCA increases in moving from a 6 o'clock position to a 12 o'clock position.

Fig. 20A is a pattern in which the first fluorescent area (area A) FCA and the second fluorescent area (area B) SCA are arranged alternately in stripes, and the surface area ratio of the first fluorescent area (area A) FCA relative to the second fluorescent area (area B) SCA is gradually changed by changing the angle of the stripes according to the position in the peripheral direction of the housing member 14. Fig. 20B is a pattern in which the first fluorescent area (area A) FCA and the second fluorescent area (area B) SCA are disposed with a triangular distribution, Fig. 20C is a pattern in which the first fluorescent area (area A) FCA and the second fluorescent area (area B) SCA are arranged in dots. In all these patterns, the surface area ratio of the first fluorescent area (area A) FCA relative to the second fluorescent area (area B) SCA is gradually changed according to the position in the peripheral direction of the housing member 14.

In this case, means for turning the housing member 14 about the center axis CA such as a pull switch, actuator, or motor (hereinafter these are referred to as "turning means") are preferable when the turn angle can be adjusted in a single step. In such a case, the color temperature of white light emitted from the light emitting device 11 can be precisely adjusted by fine-tuning the turn angle of the housing member 14.

As described hereinabove, with the light emitting device 11 according to this embodiment, the color temperature of the output light can be easily adjusted. Further, since there is a single power system for supplying power to the light emitting diode 12, there is no need for complex power control and a complex power circuit is also unnecessary. Hence, a light emitting device capable of color temperature adjustment can be manufactured at low cost.

Further, because the phosphor layer 141 of the housing member 14 is formed over the whole circumferential face of the housing member 14, there is superior conversion efficiency of the excitation light emitted by the light emitting diode 12. That is, the aspect of the phosphor layer 141 can be suitably changed as long as the target for irradiation with the excitation light from the light emitting diode 12 can be switched between the first fluorescent area (area A) FCA and the second fluorescent area (area B) SCA by turning the housing member 14 in a peripheral direction. Accordingly, the phosphor layer 141 may also be formed on only part of the housing member 14.

Furthermore, the boundary between the plurality of adjoining fluorescent areas (first fluorescent area (area A) FCA and second fluorescent area (area B) SCA) in the phosphor layer 141 is formed parallel to the center axis CA of the housing member 414. Therefore, when excitation light is emitted from each of the light emitting diodes 12 disposed side by side in the longitudinal direction of the substrate 13, irradiation of a different fluorescent area with the excitation light can be more reliably avoided. It is therefore possible to suppress simultaneous excitation of the first fluorescent area (area A) FCA and the second fluorescent area (area B) SCA which have different emission spectra.

Note that the first fluorescent area (area A) FCA and the second fluorescent area (area B) SC in the phosphor layer 141 may be formed so that the size of the area occupied by each fluorescent area is different. Further, the phosphor layer 141 may be formed on the outer peripheral side of the transparent base material of the housing member 14, or may be formed on the inner peripheral side thereof. Further, the phosphor layer 141 may be formed on the inside of the transparent base material instead of on the surface thereof.

Furthermore, although a chip on board (COB) system in which the light emitting diode 12 is mounted directly on the substrate 13 without a package therebetween has been adopted in this embodiment, a package system in which the light emitting diode 12 is mounted on the substrate 13 via the package may be adopted.

In addition, although an example was described in this embodiment in which a first fluorescent area (area A) FCA and a second fluorescent area (area B) SCA are formed by mixing three types of phosphors, namely, red, blue and green, the present invention is not limited to such an arrangement, rather, phosphors of other types may also be used. For example, phosphors of two types, namely, blue and yellow, may also be mixed together. In this case, the blue phosphor content in the first fluorescent area (area A) FCA may be set relatively high in comparison with the second fluorescent area (area B) SCA and the yellow phosphor content in the first fluorescent area (area A) FCA may be set relatively low in comparison with the second fluorescent area (area B) SCA. Accordingly, in a case where the excitation light is irradiated onto the first fluorescent area (area A) FCA, the color temperature of the light emitted to the outside can be raised in comparison with a case where the excitation light is irradiated onto the second fluorescent area (area B) SCA.

In addition, in a case where the wavelength of the excitation light emitted by the light emitting diode 12 is in the blue color range, the blue color light uses the light emitted by the light emitting diode 12 as is and a red phosphor and green phosphor or the like may be selected for the phosphor layer 141. The blue light component transmits through parts where the green and red phosphors or similar are not applied. In this case, the surface area ratio of the parts where phosphor is not applied in the first fluorescent area (area A) FCA may be set relatively high in comparison with that for the second fluorescent area (area B) SCA. Accordingly, in a case where the first fluorescent area (area A) FCA is irradiated with the excitation light, the color temperature of the light emitted to the outside can be raised in comparison with a case where the excitation light is irradiated onto the second fluorescent area (area B) SCA.

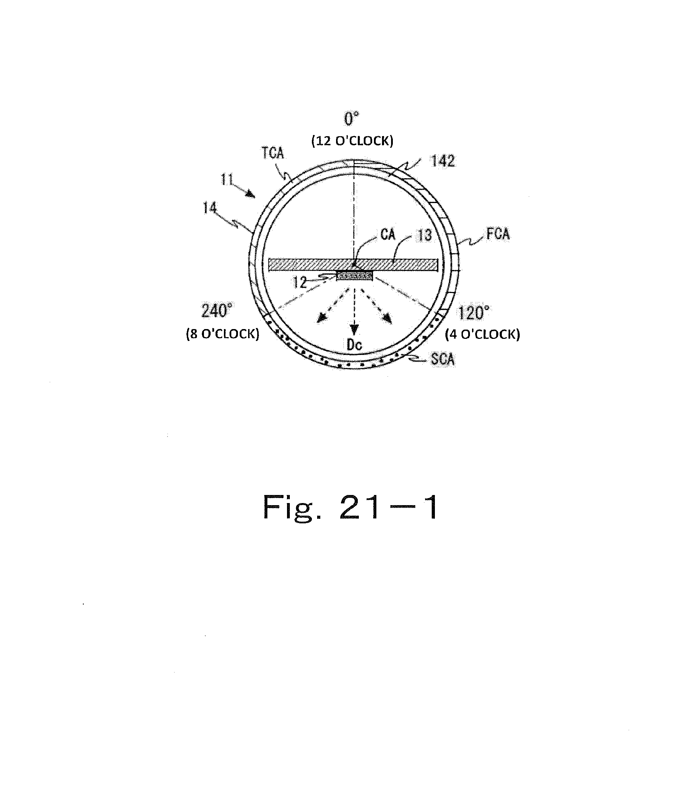

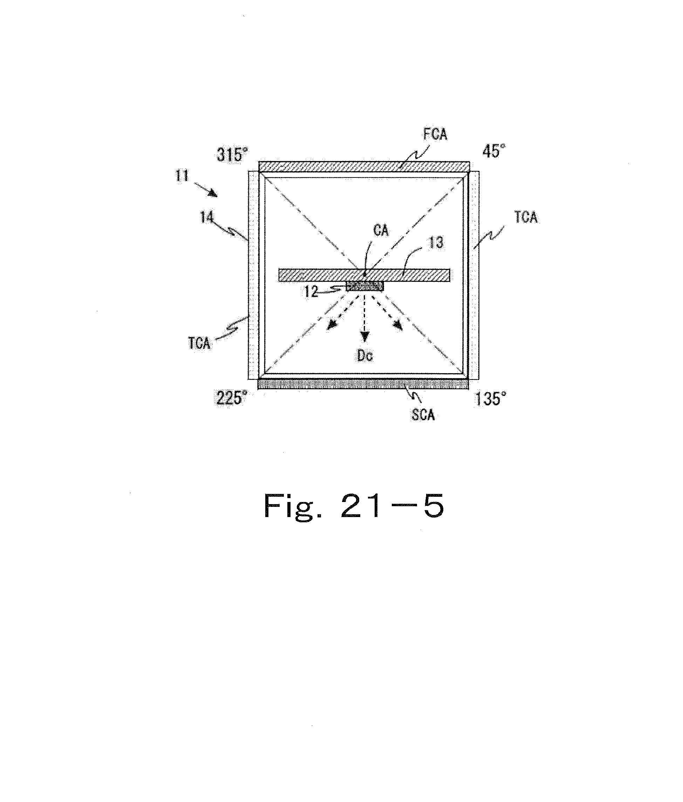

Figs. 21-1 to 21-5 are explanatory diagrams serving to illustrate modifications of the housing member 14 according to this embodiment. Each diagram shows an axis orthogonal cross section of the light emitting device 11 and corresponds to Fig. 17. Note that illustrations of some members such as the axle-like protruding member 131 and axle support member 132 have been omitted from each diagram.

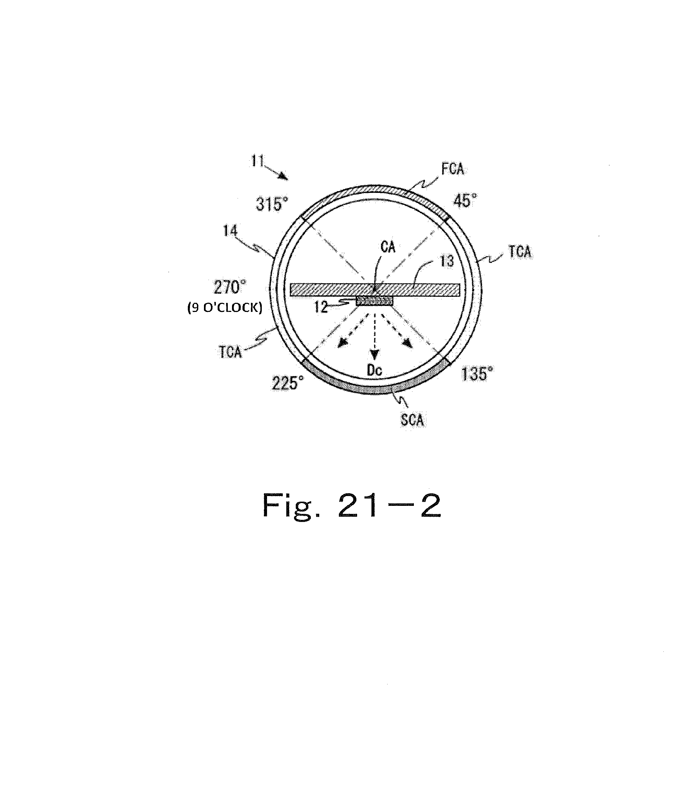

Figs. 21-1 and 21-2 has a cylindrical cross sectional shape similarly to the housing member 14 shown in Fig. 17. In Fig. 21-1, the phosphor layer 141 (housing member 14) is divided into three equal parts (each division spanning 120°) in the peripheral direction and, in each area, the first fluorescent area (area A) FCA, the second fluorescent area (area B) SCA, and a third fluorescent area (area X) TCA are disposed so as to adjoin one another. The first to third fluorescent areas each have mutually different emission spectra which emit light when exposed to the excitation light from the light emitting diode 12. For example, the type of phosphor contained and the content ratio and so on are adjusted so that the emission spectrum in the third fluorescent area (area X) TCA corresponds to wavelengths intermediate between those of the first fluorescent area (area A) FCA and the second fluorescent area (area B) SCA.

If the emission spectra of each of the first to third fluorescent areas are so defined, each time a turning operation of the housing member 14 which employs the foregoing turning means is performed, that is, each time there is an operation to switch the excitation light irradiation target, the housing member 14 may be rotated through a predetermined angle at a time (120° in this example) in one direction about the center axis CA. Furthermore, in accordance with such an operation to rotate the housing member 14, the target of irradiation with the excitation light from the light emitting diode 12 is not directly switched from the first fluorescent area (area A) FCA to the second fluorescent area (area B) SCA or from the second fluorescent area (area B) SCA to the first fluorescent area (area A) FCA, rather, the rotation direction of the housing member 14 may be defined so that switching is temporarily switched to the third fluorescent area (area X) TCA. In the case of Fig. 21-1, in accordance with an operation to switch the excitation light irradiation target which employs turning means, the housing member 14 may be set to rotate in a counterclockwise direction. Accordingly, when the color temperature of the output light from the light emitting device 11 is switched, the color temperature can be gradually modified.

Furthermore, in the example shown in Fig. 21-2, the phosphor layer 141 (housing member 14) is divided into four equal parts in the peripheral direction (where each part spans 90°) and, in each area, a first fluorescent area (area A) FCA, a third fluorescent area (area X) TCA, a second fluorescent area (area B) SCA, and a third fluorescent area (area X) TCA are sequentially arranged in a counterclockwise direction so as to adjoin one another. Accordingly, by placing the third fluorescent area (area X) TCA so as to be held from both sides between the first fluorescent area (area A) FCA and the second fluorescent area (area B) SCA, the color temperature of the output light of the light emitting device 11 can be gradually modified at the time of an operation to switch the excitation light irradiation target using turning means.

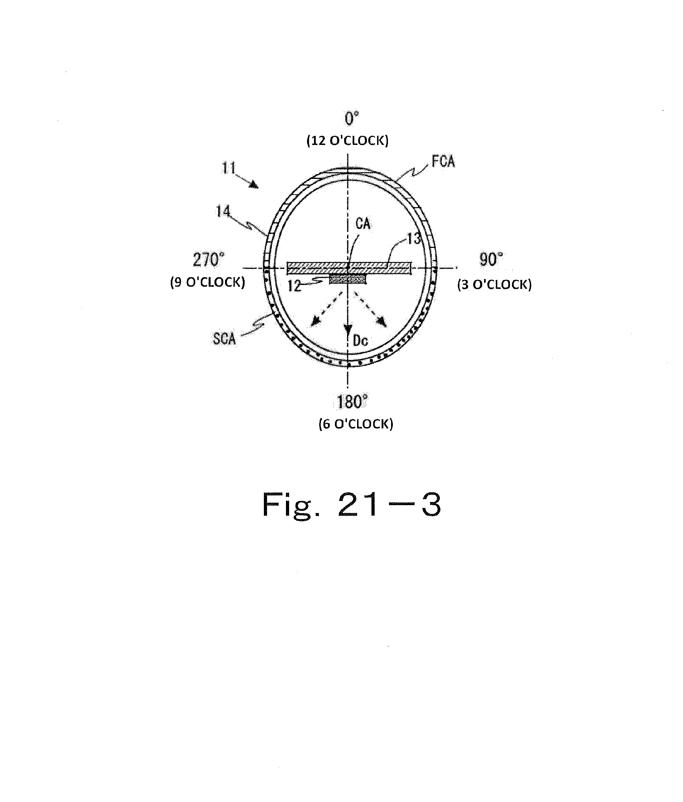

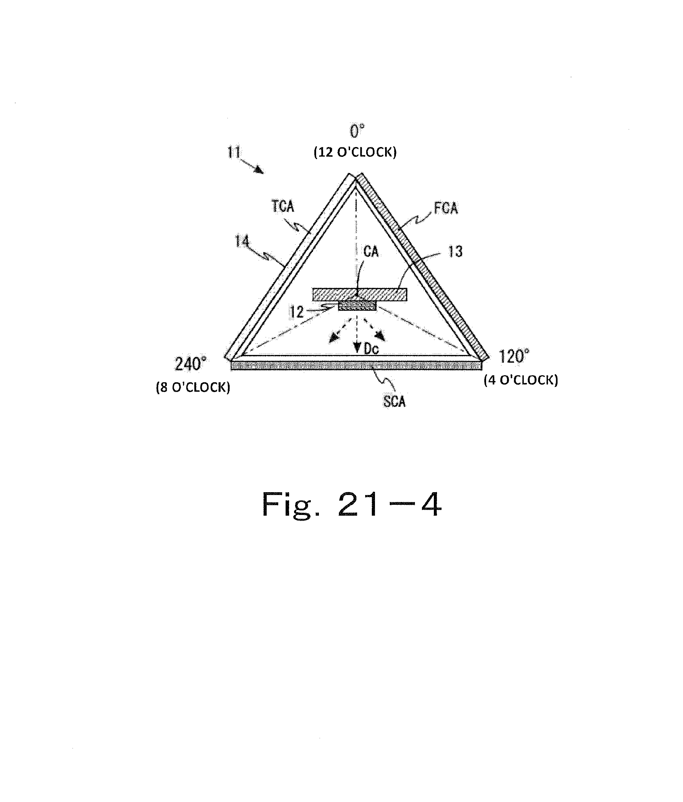

Additionally, as shown in Fig. 21-3, the cross sectional shape of the housing member 14 may be an elliptical cylinder. In this diagram, the first fluorescent area (area A) FCA and the second fluorescent area (area B) SCA are disposed such that the phosphor layer 141 (housing member 14) is divided into two equal parts in the peripheral direction. Further, as shown in Figs. 21-4 and 21-5, the cross section of the housing member 14 may be a polygonal cylindrical shape. A housing member 14 with a triangular cross section is shown by way of example in Fig. 21-4 and a housing member 14 with a square cross section is shown by way of example in Fig. 21-5. Accordingly, if the housing member 14 is afforded a polygonal cylindrical shape, a plurality of fluorescent areas may be patterned in units of the surface comprising the housing member 14.

Here, as the number of types of the plurality of fluorescent areas disposed in the peripheral direction of the phosphor layer 141 is increased, the color temperature of the light output can be more precisely controlled. However, when the surface area which is assigned to the individual fluorescent areas is too small, there is a risk of excitation light being simultaneously irradiated onto a fluorescent area of a different emission spectrum, making it hard to adjust the color temperature of the output light. Therefore, for example, the phosphor layer 141 may be formed such that the interface between the fluorescent areas does not lie in an area contained within the half-value angle range of the excitation light irradiated from the light emitting diode 12. The foregoing problem can thus be avoided.

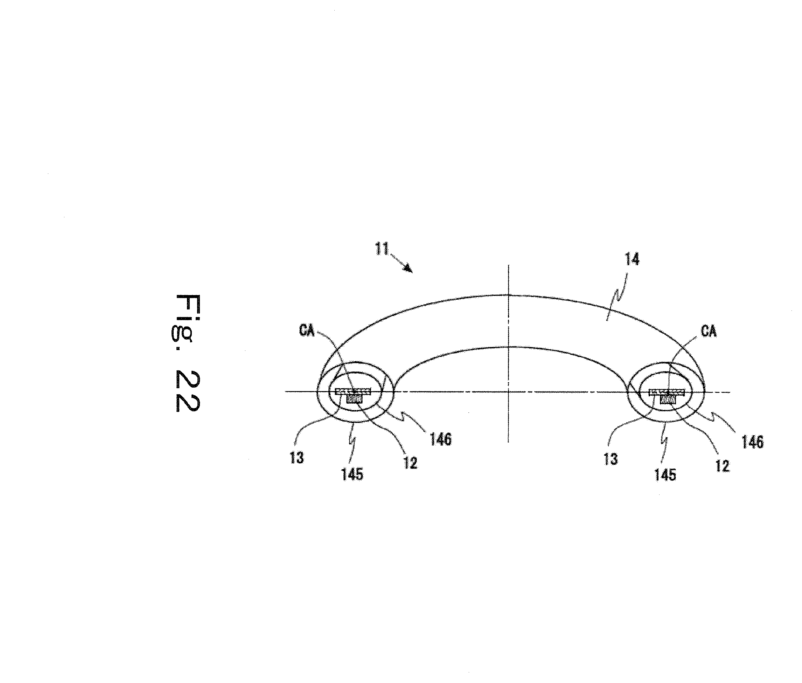

Further, the housing member 14 is not limited to a straight pipe shape, and may instead be formed like a donut (ring-shaped) as shown in Fig. 22, for example. Fig. 22 serves to illustrate another modification of the light emitting device according to the first embodiment. The housing member 14 has a duplex ring-like structure and comprises an outer annular portion 145 and an inner annular portion 146. In this diagram, the phosphor layer 141 is formed on the surface of the outer annular portion 145. Furthermore, the substrate 13 whereon the light emitting diode 12 is mounted is specifically housed within the inner annular portion 146. As can be seen from Fig. 22, this diagram does not show the whole of the light emitting device 11 which is formed in an annular shape and shows a state where the light emitting device 11 is divided into two substantially uniform parts as can be grasped from the state of the axis orthogonal cross section of the light emitting device 1.

The inner annular portion 146 is formed from a transparent member and is formed so as to transmit the excitation light emitted by the light emitting diode 12. Further, the substrate 13 is fixed so as to be integral to the inner annular portion 146. Meanwhile, the outer annular portion 145 is provided so as to turn freely relative to the inner annular portion 146 about the center axis CA. The outer annular portion 145 is formed of a flexible material (a soft, flexible body of silicone or the like, for example) so as to ensure a smooth turning operation. Further, the inner annular portion 146, which is in a state of being fixed to the substrate 13 without turning relative thereto, need not be flexible, and may be formed of a comparatively hard material in order to contribute toward maintaining the cylindrical outer shape of the outer annular portion 145. Further, for the sake of ease of manufacture of the light emitting device 11, a configuration is also possible where the outer annular portion 145 according to this modification is afforded an annular shape which is obtained by assembling a plurality of divided pieces so that there are two or three divisions or the like.

Further, the size and layout position of the substrate 13 which is housed in the housing member 14 can be adjusted so as to not disturb the rotation operation of the housing member 14. Furthermore, by attaching a cap member (not shown) to the end face openings 143 of the housing member 14, the invasion of insects or the like into the interior of the housing member 14 may be prevented.

In the light emitting device 11 according to this embodiment, the housing member 14 may be given a so-called cartridge format. For example, various housing members 14 formed with phosphor layers 141 of different emission spectra are prepared and, if the color temperature of the output light which is output to the light emitting device 11 is modified, the housing member 14 may be replaced with a housing member 14 which comprises a phosphor layer 141 of a different emission spectrum. The color temperature of the output light from the light emitting device 11 can also be suitably modified in this way.

<Second embodiment>

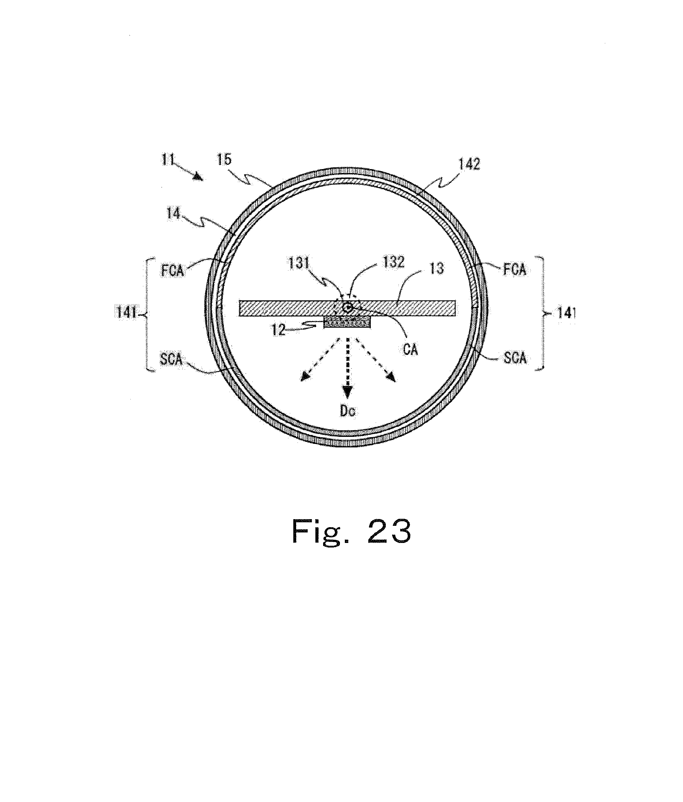

A second embodiment will be described next. Fig. 23 serves to schematically show an axis orthogonal cross section of a light emitting device 11 according to a second embodiment. Here, the focus of the description will be on points of difference from the configuration of the first embodiment (the cross sectional structure shown in Fig. 17 in particular) and points in common will not be described here. In this embodiment, the housing member 14 comprises a phosphor layer 141 formed on the inner peripheral side of the transparent base material. Meanwhile, a bandpass filter (so-called ultraviolet cut filter) 15 which reflects the light (excitation light) emitted by the light emitting diode 12 and transmits the light emitted by each of the phosphors contained in the phosphor layer 141 is provided on the outer peripheral side of the transparent base material. A commercially available bandpass filter can be suitably used as the bandpass filter 15, and the type of the bandpass filter 15 is suitably chosen according to the type of light emitting diode 12.

By placing the bandpass filter 15 on the output light emission side, the excitation light leaking to the outside from the phosphor layer 141 can be reflected toward the inside of the housing member 14. As a result, the excitation light can be irradiated toward the phosphor contained in the phosphor layer 141 once again and the emission efficiency of the light emitting device 11 can be raised. Further, the light emitted by the phosphor in the phosphor layer 141 passes through the bandpass filter 15 and hence the smooth emission of the white light to the outside is not disturbed. Note that the other configurations are similar to the first embodiment described in Figs. 16 to 19.

Furthermore, as a modification of the foregoing, a surface micro asperity structure (a so-called textured structure) which exhibits the same functions as the bandpass filter 15 may be provided on the outer peripheral side of the housing member 14 in place of the bandpass filter 15. The textured shape of the textured structure is adjusted to reflect light of wavelengths corresponding to the excitation light of the light emitting diode 12 and transmit the light of longer wavelengths. Accordingly, the same effects as in the case where the bandpass filter 15 is used can be exhibited. In this embodiment, the bandpass filter 15 and the foregoing surface micro asperity structure each correspond to the excitation light reflective member of the present invention.

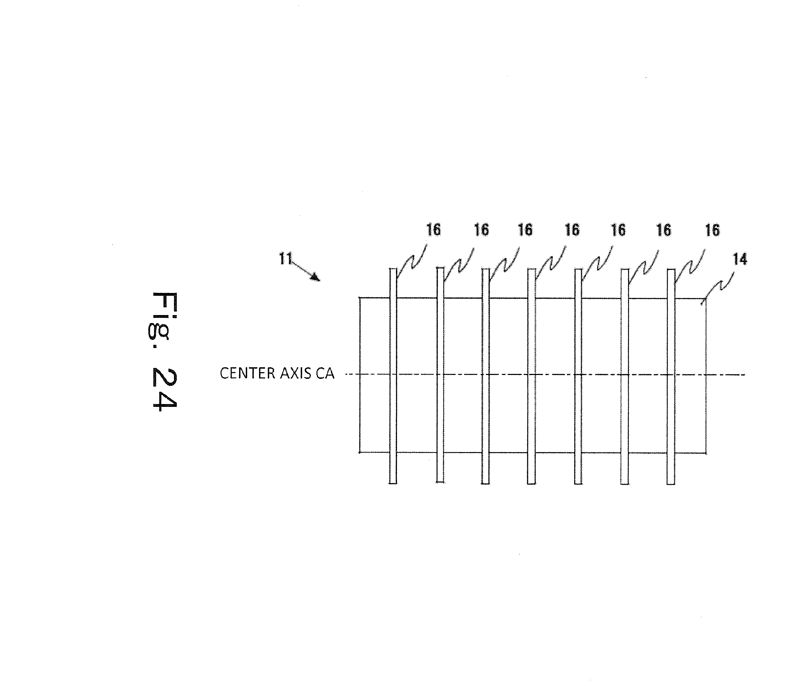

Furthermore, in the modification shown in Fig. 24, an annular fluorescent fin member 16 is provided protrudingly on the outer peripheral face of the housing member 14. Fig. 24 is a lateral view in which the light emitting device 11 is viewed from the side. The fluorescent fin member 16 comprises phosphor which is excited by the light emitted by the light emitting diode 12. Further, as illustrated, a plurality of the fluorescent fin members 16 are provided at each predetermined interval in the center axis CA direction. With this configuration, even when the excitation light emitted by the light emitting diode 12 escapes to the outside without being wavelength-converted in the phosphor layer 141, because the light is converted to white light by the phosphor contained in the fluorescent fin member 16, the emission efficiency of the light emitting device 11 can be suitably raised.

As described hereinabove, with the light emitting device 11 according to this embodiment, the emission efficiency can be raised because the excitation light emitted by the light emitting diode 12 can be converted efficiently into white light.

<Third embodiment>

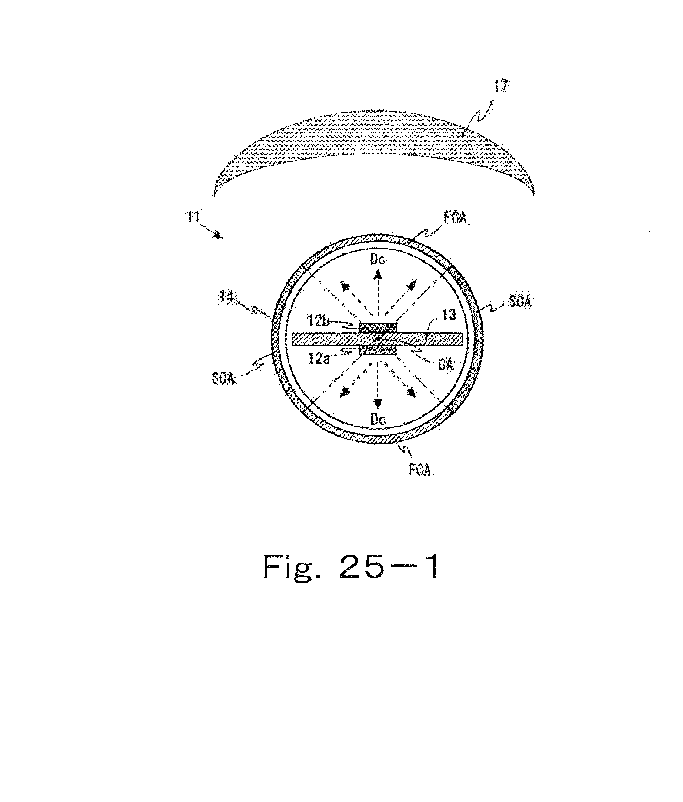

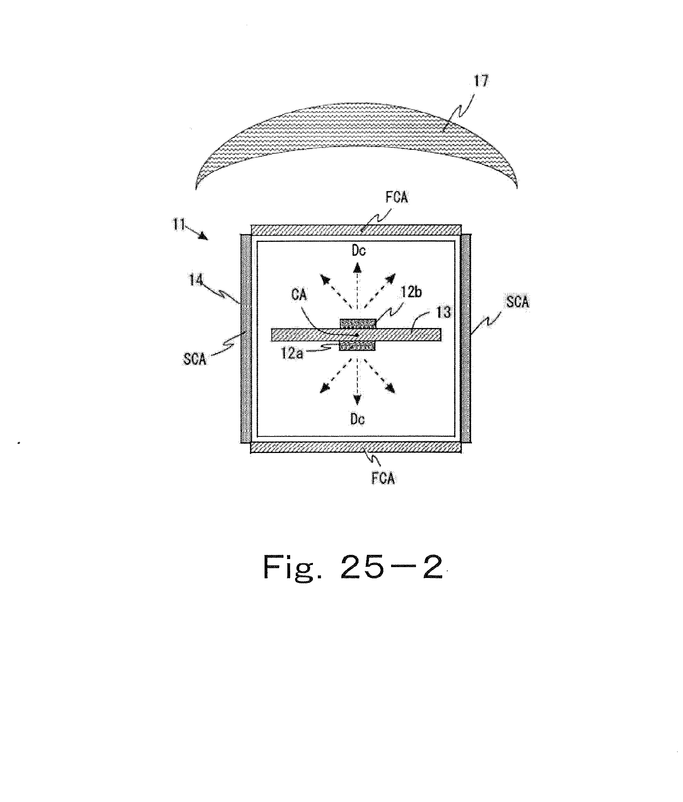

A third embodiment will be described next. Figs. 25A and 25B serves to schematically show an axis orthogonal cross section of the light emitting device 11 according to the third embodiment. Here, the focus of the description will be the characteristics of this embodiment. In this embodiment, the light emitting diode 12 is disposed on both faces of the substrate 13 such that the substrate 13 is held from both sides. Here, the light emitting diode 12 mounted on the lower face of the substrate 13 is called the "first light emitting diode 12a" and the light emitting diode 12 mounted on the upper face is called the "second light emitting diode 12b".

As is illustrated, the first light emitting diode 12a and the second light emitting diode 12b are disposed at the back with the substrate 13 held from both sides. Hence, the irradiation center direction Dc of the first light emitting diode 12a is oriented vertically upward with reference to the substrate 13 and the irradiation center direction Dc of the second light emitting diode 12b is oriented vertically downward with reference to the substrate 13. That is, the irradiation center directions Dc of the first light emitting diode 12a and the second light emitting diode 12b are mutually opposing.

Here, as shown in Figs. 25A and 25B, in the phosphor layer 141, fluorescent areas with mutually equal emission spectra are formed in symmetrical areas (areas 180° apart) which border the center axis CA of the housing member 14 on both sides. As a result, when excitation light of the same type is irradiated from both the first light emitting diode 12a and the second light emitting diode 12b, the excitation light can be irradiated onto only fluorescent areas of an identical emission spectrum. That is, in the example of Figs. 25A and 25B, the excitation light is not irradiated simultaneously in the first fluorescent area (area A) FCA and the second fluorescent area (area B) SCA. Hence, the control of the color temperature of the light emitted from the light emitting device 11 can be accurately performed.

Furthermore, as per the case where the light emitting device 11 is hung horizontally from a ceiling, if the irradiation target area is below the light emitting device 11, a reflective mirror (reflective plate) 17 may be provided outside and above the light emitting device 11 as shown. The reflective mirror 17 functions to reflect the emitted light corresponding to the second light emitting diode 12b which is disposed on the upper face of the substrate 13 toward the emission area of the emitted light corresponding to the first light emitting diode 12a disposed on the lower face of the substrate 13. With this configuration, because the white light emitted from the light emitting device 11 is collected in the irradiation target area, the amount of light reaching the irradiation target area can be increased. Note that the reflective mirror 17 in this embodiment corresponds to the reflective member of the present invention.

<Fourth embodiment>

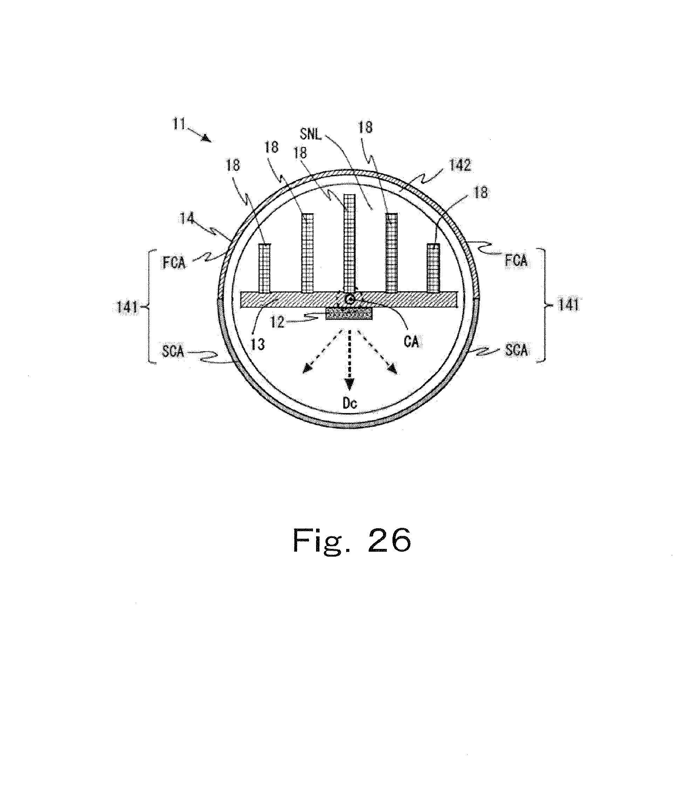

A fourth embodiment will be described next. Fig. 26 schematically shows an axis orthogonal face of the light emitting device 11 according to a fourth embodiment. Here, the description will focus on the characteristics of this embodiment. Similarly to the first embodiment and so on, the light emitting device 11 according to this embodiment has a light emitting diode 12 mounted only on the lower face of the substrate 13. Here, in the space where the housing member 14 is housed, the space opposite the upper face of the substrate 13 is called the "power source back side space."

A heat radiation fin 18 for radiating the heat of the light emitting diode 12 is disposed in thermal contact with the upper face of the substrate 13 in the foregoing light source back side space SNL. The material values of the substrate 13 such as thermal conductivity are adjusted so that the heat emitted by the light emitting diode 12 is efficiently conducted to the heat radiation fin 18. Note that each heat radiation fin 18 extends from one end of the housing member 14 toward the other end so as to follow the center axis CA of the housing member 14.

In this embodiment, the heat generated in the light emitting diode 12 is conducted to the heat radiation fin 18 via the substrate 13. The heat radiation fin 18 performs heat exchange with the outside air via the end face openings 143 of the housing member 14. In this way, because the light emitting diode 12 is cooled due to the heat radiation from the heat radiation fin 18, high emission efficiency can be maintained. Note that the other configurations are the same as in the first embodiment.

Note that the cap member (not shown) which is attached to each end face opening 143 in the housing member 14 may be configured with an aspect which does not interfere with the passage of air into and outside the housing member 14, for example as a net-shaped or mesh-like member. Furthermore, a blower module (a forced air fan, for example) for forcedly expelling air, which has been introduced into the housing member 14 via one of the end face openings 143, from the other end face opening 143 may also be disposed in the light source back side space SNL of the housing member 14. Since the heat radiation via the heat radiation fin 18 is facilitated further in this way, the cooling characteristics of the light emitting diode 12 can be further improved.

Here, although a plurality of heat radiation fins 18 are provided in the light source back side space SNL in the housing member 14 in the example of Fig. 26, the present invention is not limited to this arrangement, for example only one heat radiation fin 18 may be installed. Furthermore, the heat radiation fin 18 may be installed so that the other end of the heat radiation fin 18 is in contact with the housing member 14. In this case, using a material with a comparatively high thermal conductivity also for the housing member 14 is preferable since the heat conducted from the heat radiation fin 18 easily escapes to the outside.

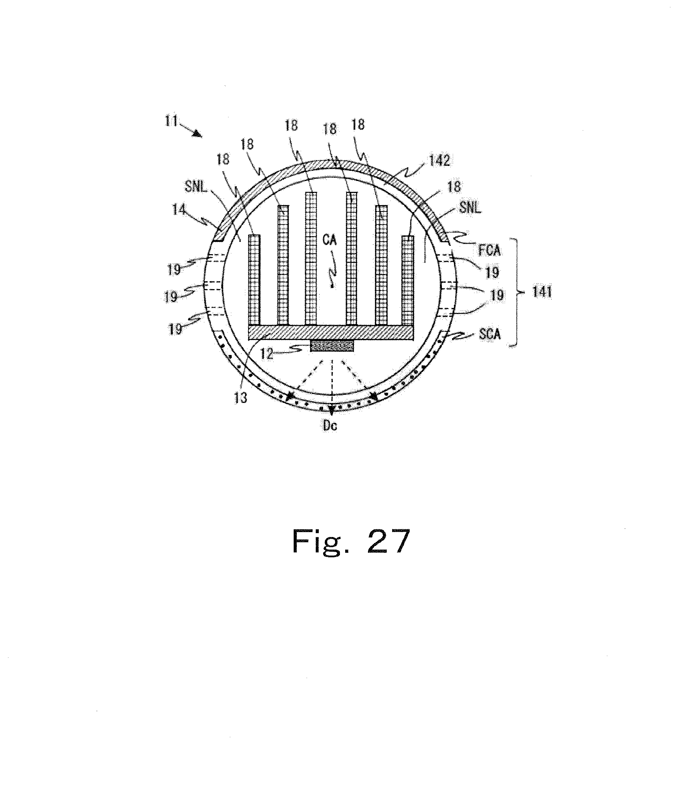

In the configuration example of Fig. 27, the light source rear side space of the housing member 14 is enlarged in comparison with the space (hereinafter called the "light source side space") opposite the lower face of the substrate 13 whereon the light emitting diode 12 is mounted within the space accommodating the housing member 14. Further, the phosphor layer 141 is provided on part of the housing member 14. More specifically, the first fluorescent area (area A) FCA and the second fluorescent area (area B) SCA which the phosphor layer 141 comprises are formed mutually apart in symmetrical areas (areas 180° apart) which border the center axis CA of the housing member 14 on both sides. Further, air holes 19 are formed between the first fluorescent area (area A) FCA and the second fluorescent area (area B) SCA. The air holes 19 are holes through which a transparent base material comprising the housing member 14 passes and which link the light source back side space SNL to an external space. The air holes 19 are provided at predetermined intervals along the center axis CA of the housing member 14.

With the foregoing configuration, because outside air is introduced inside the light source back side space SNL via each of the air holes 19 in addition to the end face openings 143 in the housing member 14, the heat radiation of the heat radiation fin 18 can be further promoted. As a result, the cooling characteristics of the light emitting diode 12 can be further improved and the emission efficiency can be raised.

Note that, in this configuration, the housing member 14 comes to turn through 180° about the center axis CA each time the pull switch is switched by the user and, as a result, the target onto which excitation light is irradiated is switched to either of the first fluorescent area (area A) FCA or the second fluorescent area (area B) SCA. Therefore, the excitation light of the light emitting diode 12 is not irradiated onto the parts where the air holes 19 are formed.

<Fifth embodiment>

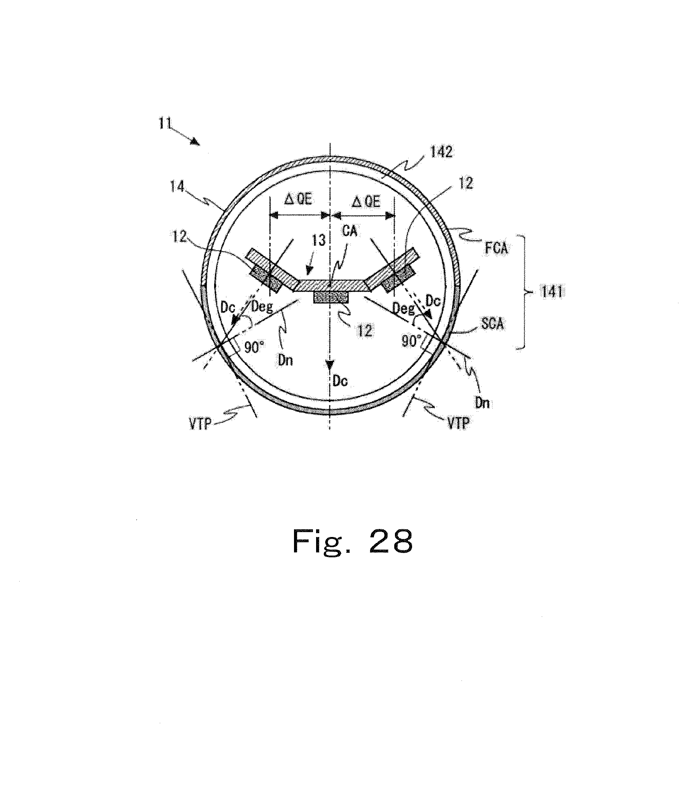

A fifth embodiment will be described next. Fig. 28 schematically shows the axis orthogonal cross section of the light emitting device 11 according to the fifth embodiment. Here, the focus of the description will be on the characteristics of this embodiment. In this embodiment, the housing member 14 is the same as that shown in Fig. 17 and has a cylindrical shape. Further, as shown, in this embodiment, the shape of the substrate and the mounting pattern of the light emitting diode 12 onto the substrate differ from those of the configuration of Fig. 17.

Here, causing the excitation light emitted by the light emitting diode 12 to be introduced to the phosphor layer 141 of the housing member 14 at an angle close to an orthogonal direction is preferable from the standpoint of the emission efficiency. As per the configuration example shown in Fig. 17, in a case where the eccentricity of the light emitting diode 12 from the center axis CA of the housing member 14 is zero or minimal, the eccentricity between the irradiation center direction Dc of the excitation light and the center axis CA of the housing member 14 is also minimal. Hence, under such conditions, the excitation light from the light emitting diode 12 can be easily introduced to the phosphor layer 141 from an orthogonal direction or a nearly orthogonal direction.

However, in order to increase the emission amount from the light emitting device 11, a plurality of light emitting diodes 12 may also be arranged side by side in the short edge direction of the substrate 13. It is accordingly difficult to introduce the excitation light of the light emitting diode 12 which is disposed eccentric to the center axis CA of the housing member 14 to the phosphor layer 141 from an orthogonal direction or nearly orthogonal direction.

As shown, the light emitting diodes 12 stand in triplicate in the short edge direction of the substrate 13. The light emitting diode 12 located in the center has an eccentricity ΔQE to the center axis CA of zero. However, the light emitting diodes 12 located on both sides are disposed eccentric to the center axis CA.

In the light emitting device 1 according to this embodiment, if the light emitting diode 12 disposed on the substrate 13 is disposed eccentric to the center axis CA of the housing member 14, the light emitting diode 12 is provided to establish a smaller angle (represented by the reference sign "Deg" in the drawings) between the irradiation center direction Dc of the light emitted by the light emitting diode 12 and the virtual ground plane (indicated in the drawings by the reference sign VTP) normal direction Dn at the intersection between the phosphor layer 141 of the housing member 14 and the irradiation center direction Dc.

More specifically, in a case where the light emitting diode 12 is disposed eccentric to the center axis CA, the light emitting diode 12 is installed on the substrate 13 with a tilted orientation. Further, the tilt angle of the light emitting diode 12 is set such that the greater the eccentricity ΔQE of the light emitting device 12, the greater the tilt angle. This is because the greater the eccentricity ΔQE of the light emitting diode 12, the greater the tilt angle of the light emitting diode 12 required so that the irradiation center direction Dc is parallel to the normal direction Dn of the virtual ground plane VTP.

The axis orthogonal face of the substrate 13 is defined so as to satisfy the aforementioned tilt angle of the light emitting diode 12. The specific cross sectional shape is determined according to the layout pattern of the light emitting diode 12 in an orthogonal direction to the center axis CA and the eccentricity ΔQE of the light emitting diode 12. However, if the angle Deg formed between the irradiation center direction Dc of the excitation light of the light emitting diode 12 and the normal direction Dn is smaller, suitable modifications to the installation of the light emitting diode 12 and the substrate shape and so on can be added. For example, in the example shown in Fig. 28, the axis orthogonal face of the substrate 13 is a bent plate shape but may also be an arc shape which is an approximation to the bent plate shape.

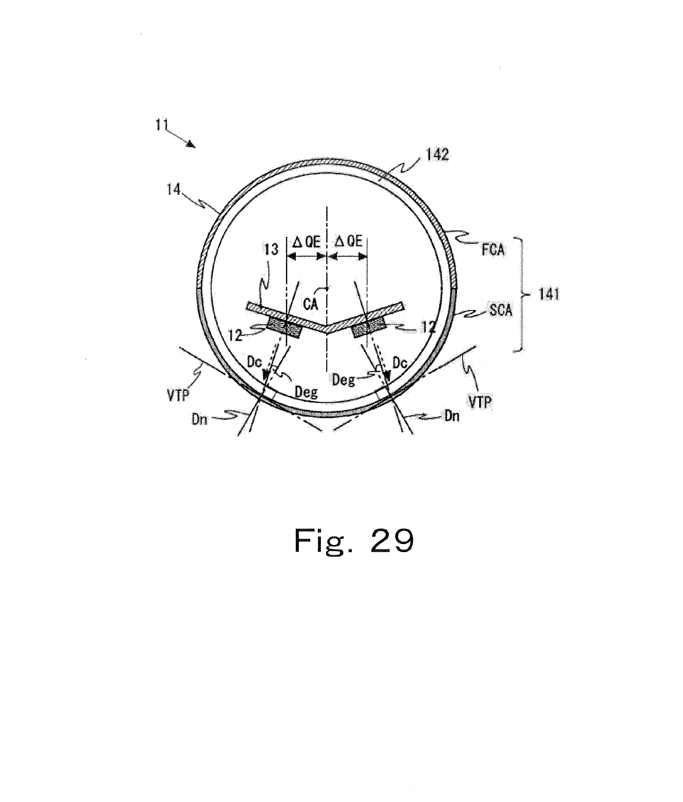

In addition, as shown in Fig. 29, if the light emitting diode 12 is disposed in duplicate in the short edge direction of the substrate 13 and both light emitting diodes 12 are disposed eccentric to the center axis CA, the axis orthogonal cross section of the substrate 13 may be V-shaped as shown. Alternatively, the installation angle of the light emitting diodes 12 relative to the substrate 13 may be adjusted instead of adjusting the tilt angle of the substrate 13 according to the eccentricity ΔQE of the light emitting diode 12 to the center axis CA. Accordingly, even if the light emitting diodes 12 are disposed eccentric to the center axis CA, the cross sectional shape of the substrate 13 can be a flat plate shape as shown in Fig. 17.

As mentioned hereinabove, in the light emitting device 1 according to this embodiment, even if the light emitting diode 12 is disposed eccentric to the center axis CA of the housing member 14, the excitation light emitted by the light emitting diode 12 can be introduced to the phosphor layer 141 of the housing member 14 in an orthogonal direction or at an angle close to the orthogonal direction. The emission efficiency of the light emitting device 1 can therefore be improved and the emission amount can be easily ensured.

The embodiments described hereinabove are examples to illustrate the present invention and various modifications can be added to the foregoing embodiments within the scope and not departing from the spirit of the present invention. Further, the light emitting device according to the present invention is not limited to the foregoing embodiments and, wherever possible, can include combinations of these embodiments.

Examples

The present invention will be described more specifically hereinbelow with reference to experiment examples, but the present invention is not limited to the following experiment examples, rather, the experiment examples can be optionally modified within the scope and not departing from the spirit of the present invention. Note that measurement of the thickness of the phosphor portions and the emission spectra of the light emitting device were performed using the following method.

Measurement of phosphor portion thickness

The thickness of the phosphor portions was calculated by measuring the combined thickness of the substrate coated with the phosphor portions and the phosphor portions using a micrometer and measuring the thickness of the substrate after detaching the phosphor portion from the substrate.

Measurement of the light emitting device emission spectrum

<In the Case of Experiment 1>

A 20mA current was supplied to a semiconductor light emitting device and the emission spectrum was measured using a multichannel spectroscope (Solid Lambda CCD UV-NIR by Carl Zeiss (integrated wavelength range:200 nm to 980 nm, light reception system:integrating sphere (20-inch diameter)).

<In the Case of Experiment 2>

A 20mA current was supplied to a semiconductor light emitting device and the emission spectrum was measured using a fiber multichannel spectroscope (USB2000 by Ocean Optics (integrated wavelength range:200 nm to 1100 nm, light reception system:integrating sphere (1.5-inch diameter)).

<Investigation of surface area ratio and chromaticity coordinates of each phosphor portion>

[Experiment 1]

A light emitting device comprising a semiconductor light emitting element module light source portion and a phosphor layer was fabricated and the emission spectrum thereof was measured.

For the semiconductor light emitting element module, a single InGaN LED chip with a 350 $\mu$m angle and a principal emission peak wavelength of 405 nm which is formed using a sapphire substrate was stuck to the cavity bottom face of a 3528SMD-type PPA resin package by using a transparent diebond paste with a silicone resin base. Following adhesion and after hardening the diebond paste by applying heat for two hours at 150°, an LED chip side electrode and a package side electrode were connected using Au wire with a diameter of 2.5 $\mu$m. Two bonding wires were employed. The semiconductor light emitting element module light source portion was fabricated by series-connecting five of the components thus fabricated and evenly arranging same on a 30 mm square bottom portion opening and creating an opening of 50 mm square, and laying an alumina particle-mixed silicon resin sheet which is 1 mm thick on each of the bottom face portion and side wall inner portion, to a height of 30 mm.

As phosphors, SBCA phosphor of peak wavelength 450 nm and represented by $Sr_{5-b}Ba_b(PO_4)_3Cl:Eu$, BSON phosphor of peak wavelength 535 nm and represented by $Ba_3Si_6O_{12}N_2:Eu$, and CASON phosphor of peak wavelength 630 nm and represented by $CaAlSi(N, O)_3:Eu$ were used, and SCR-1016 (made by Shin-Etsu Silicone) was used as the binder resin.

As the phosphor layer, when a light emitting device is made in combination with the foregoing semiconductor light emitting element module light source portion, phosphor layers of nine types (phosphor layers 1 to 9), designed such that the correlated color temperature of the emitted light is in the range 2600 K to 7100 K and such that the chromaticity coordinates lie on a black body radiation curve, were fabricated. The phosphor layers 1 to 9 all comprise a first phosphor portion which emits blue light, a second phosphor portion which emits green light, and a third phosphor portion which emits red light, and the SBCA phosphor was used as the first phosphor, the BSON phosphor was used as the second phosphor, and the CASON phosphor was used as the third phosphor. Note that, in order to establish the desired correlated color temperature and chromaticity coordinates in the respective phosphor layers 1 to 9, the surface area ratios of the first phosphor portion, the second phosphor portion, and the third phosphor portion were set as per Table 1. Further, the content of the phosphors in each of the phosphor portions were given the volume fill rates of 52%, 48%, and 51% respectively.

Note that the fabrication of each phosphor portion in the phosphor layer was carried out by first introducing a predetermined amount of binder resin and a predetermined amount of phosphor to the same container, mixing and stirring same using a rotation-revolution mixer "Awatori-Rentarou" (by Thinky Co. Ltd.), coating the mixture once on a 100-$\mu$m thick PET resin using a screen printer (the ST-310F1G by Okuhara Electric Co. Ltd.) and then solidifying the resin by means of drying by applying heat at 100°C for one hour and then at 150°C for five hours.

The light emitting devices 1 to 9, in which the phosphor layers 1 to 9 were each made to adhere to the opening in the foregoing semiconductor light emitting element module light source portion such that the upper face of the semiconductor light emitting element and the lower face of the phosphor layer were spaced apart at a distance of approximately 30 mm, were fabricated. Note that the space between the phosphor layer and the semiconductor light emitting element constitutes an air layer.

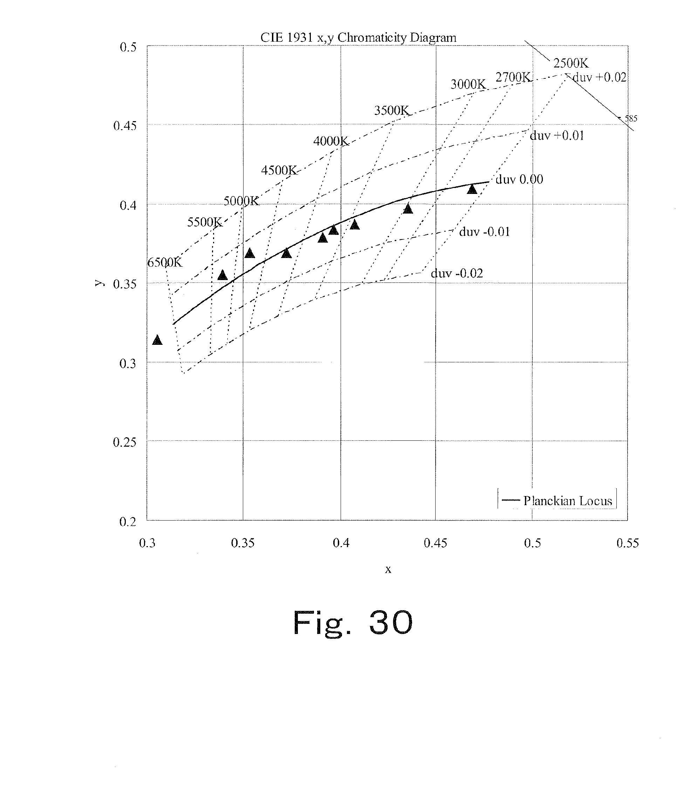

The results for the measured correlated color temperatures and chromaticity coordinates (Cx, Cy) of the light emitting devices 1 to 9 are shown in Table 1 and Fig. 30.

[Table 1]

| | Phosphor Layer | Area Ratio | | | Correlated Color Temperature (K) | Chromaticity Coordinates (Cx, Cy) | |
|---|---|---|---|---|---|---|---|
| | | SBCA(Blue) | BSON(Green) | CASON(Red) | | Cx | Cy |
| Light Emitting Device 1 | Phosphor Layer 1 | 0.38 | 0.20 | 0.42 | 7092 | 0.3055 | 0.3142 |
| Light Emitting Device 2 | Phosphor Layer 2 | 0.26 | 0.25 | 0.49 | 5235 | 0.3395 | 0.3554 |
| Light Emitting Device 3 | Phosphor Layer 3 | 0.27 | 0.23 | 0.50 | 4762 | 0.3536 | 0.369 |
| Light Emitting Device 4 | Phosphor Layer 4 | 0.22 | 0.20 | 0.59 | 4184 | 0.3719 | 0.369 |
| Light Emitting Device 5 | Phosphor Layer 5 | 0.19 | 0.20 | 0.61 | 3745 | 0.3906 | 0.3786 |
| Light Emitting Device 6 | Phosphor Layer 6 | 0.16 | 0.19 | 0.66 | 3653 | 0.3965 | 0.3839 |
| Light Emitting Device 7 | Phosphor Layer 7 | 0.12 | 0.19 | 0.69 | 3424 | 0.4072 | 0.3872 |
| Light Emitting Device 8 | Phosphor Layer 8 | 0.06 | 0.16 | 0.78 | 2967 | 0.4355 | 0.3972 |
| Light Emitting Device 9 | Phosphor Layer 9 | 0.04 | 0.11 | 0.85 | 2577 | 0.4686 | 0.4097 |

As is clear from Table 1 and Fig. 30, when the light emitting devices 1 to 9 were each compared, it was found that the color temperature of the light emitted by the respective light emitting devices 1 to 9 could be changed to an optional color temperature, for example an optional color temperature close to black body radiation, by adjusting the surface area ratios of each of the first phosphor portions, second phosphor portion, and third phosphor portions which the phosphor layers 1 to 9 comprise.

Therefore a single phosphor layer was created by combining the phosphor layers 1 to 9 in the following order, for example: phosphor layer 1, then phosphor layer 2, then phosphor layer 3, then phosphor layer 4, then phosphor layer 5, then phosphor layer 6, then phosphor layer 7, then phosphor layer 8, then phosphor layer 9 and, in a case where a light emitting device is fabricated in combination with the foregoing semiconductor light emitting element module as per Fig. 13-1, by moving the phosphor layer, (1) the light emitted from the phosphor layer 1 is the light emitted from the light emitting device if the phosphor layer 1 is disposed in the light emission area, (2) the light emitted from the phosphor layer 2 is the light emitted from the light emitting device if the phosphor layer 2 is disposed in the light emission area, (3) the light emitted from the phosphor layer 3 is the light emitted from the light emitting device if the phosphor layer 3 is disposed in the light emission area,(4) the light emitted from the phosphor layer 4 is the light emitted from the light emitting device if the phosphor layer 4 is disposed in the light emission area, (5) the light emitted from the phosphor layer 5 is the light emitted from the light emitting device if the phosphor layer 5 is disposed in the light emission area, (6) the light emitted from the phosphor layer 6 is the light emitted from the light emitting device if the phosphor layer 6 is disposed in the light emission area, (7) the light emitted from the phosphor layer 7 is the light emitted from the light emitting device if the phosphor layer 7 is disposed in the light emission area, (8) the light emitted from the phosphor layer 8 is the light emitted from the light emitting device if the phosphor layer 8 is disposed in the light emission area, and (9) the light emitted from the phosphor layer 9 is the light emitted from the light emitting device if the phosphor layer 9 is disposed in the light emission area. In this case, while also keeping the power supplied to the semiconductor light emitting element at a fixed value such that the color temperature of the light emitted by the light emitting device is a color temperature close to the black body radiation curve, the correlated color temperature of this light can be adjusted to an optional correlated color temperature in the range 2600 K to 7000 K.

<Investigation of thickness of each phosphor portion and chromaticity coordinates>

[Experiment 2]

For the semiconductor light emitting element module, a single InGaN LED chip with a 350 $\mu$m angle and a principal emission peak wavelength of 450 nm which is formed using a sapphire substrate was stuck to the cavity bottom face of a 3528SMD-type PPA resin package by using a transparent diebond paste with a silicone resin base. Following adhesion and after hardening the diebond paste by applying heat for two hours at 150°, an LED chip side electrode and a package side electrode were connected using Au wire with a diameter of 25 $\mu$m. Two bonding wires were employed. 4 $\mu$l of a 2-pack silicon resin was then added and, after hardening the silicon resin by applying heat at 100°C for one hour and then at 150°C for five hours, a semiconductor light emitting element module was formed.

As phosphors, CSMS phosphor of peak wavelength 514 nm and represented by $Ca_3 (Sc, Mg)_2Si_3O_{12}$:Ce, and SCASN phosphor of peak wavelength 630 nm and represented by $(Sr, Ca) AlSiN_3$:Eu were used to provide a first phosphor portion which emits green light and a second phosphor portion which emits red light, the CSMS phosphor being used as the first phosphor and the SCASN phosphor (volume fill rate of 37%) being used as the second phosphor, and SCR-1016 (made by Shin-Etsu Silicone) was used as the binder resin.

As the phosphor layer, when a light emitting device is made in combination with the foregoing semiconductor light emitting element module, a phosphor layer, configured such that the color temperature coordinate (Cx, Cy) of the emitted light is (0.389094, 0.341722), was fabricated. Note that the phosphor layer comprises a first phosphor portion which emits green light and a second phosphor portion which emits red light, and the CSMS phosphor was used as the first phosphor, and the SCASN phosphor was used as the second phosphor. Further, the content of the phosphors in each of the phosphor portions were given the volume fill rates of 48% and 37% respectively.

Note that the fabrication of each phosphor portion in the phosphor layer was carried out by first introducing a predetermined amount of binder resin and a predetermined amount of phosphor to the same container, mixing and stirring same using a rotation-revolution mixer (by Thinky Co. Ltd.), coating the mixture once on a 100-$\mu$m thick PET resin using a screen printer (the ST-310F1G by Okuhara Electric Co. Ltd.) and then solidifying the resin by means of drying by applying heat at 100°C for one hour and then at 150°C for five hours.

A light emitting device 10, in which a phosphor layer 10 was made to adhere to the opening in the foregoing semiconductor light emitting element module light source portion such that the upper face of the semiconductor light emitting element and the lower face of the phosphor layer were spaced apart at a distance of 1 mm, was fabricated.

Thereafter, a light emitting device 11 was fabricated in a similar fashion to the light emitting device 10 other than that the number of coatings of the binder resin comprising the SCASN phosphor to the PET resin was three.

Thereafter, a light emitting device 12 was fabricated in a similar fashion to the light emitting device 10 other than that the number of coatings of the binder resin comprising the SCASN phosphor to the PET resin was ten.

The results of the chromaticity coordinates (Cx, Cy) which were calculated from the measured emission spectra for the light emitting devices 10 to 12 are shown in Table 2.

[Table 2]

| | Thickness of Second Phospher Portion (μm) | Chromaticity Coordinates(Cx, Cy) | |
|---|---|---|---|
| | | Cx | Cy |
| Light Emitting Device 10 | 40 | 0.3891 | 0.3417 |
| Light Emitting Device 11 | 80 | 0.3358 | 0.4004 |
| Light Emitting Device 12 | 120 | 0.3081 | 0.4501 |

As is clear from Table 2, when the light emitting devices 10 to 12 are compared, the color temperatures of the light emitted from the respective light emitting devices 10 to 12 can be changed to optional color temperatures by adjusting the thickness of the phosphor portions, for example the second phosphor portion.

INDUSTRIAL APPLICABILITY

The present invention can be employed in fields where light is used, and can suitably be used in indoor and outdoor lighting and so on, for example. Note that, although the present invention was described by taking specific aspects by way of example, it is easily understood by a person skilled in the art that modifications to the embodiments can be made without departing from the scope of the present invention.

EXPLANATION OF REFERENCE NUMERALS

1       Light emitting device
2       Semiconductor light emitting element
21      Light distribution member
22      Rotational axis
23      Reflective member
3       Package
4       Phosphor layer

| 4a | Area A |
|---|---|
| 4b | Area B |
| 4x | Area X |
| 5 | Transparent substrate |
| 6a | First phosphor portion |
| 6b | Second phosphor portion |
| 6c | Third phosphor portion |
| 7a | First phosphor |
| 7b | Second phosphor |
| 8 | Sliding direction |
| 9 | Bandpass filter |
| 11 | Light emitting device |
| 12 | Light emitting diode |
| 12a | First light emitting diode |
| 12b | Second light emitting diode |
| 13 | Substrate |
| 131 | Axle-like protruding member |
| 132 | Axle support member |
| 14 | Housing member |
| 141 | Phosphor layer |
| 142 | Transparent base material |
| 143 | End face opening |
| 145 | Outer ring-like portion |
| 146 | Inner ring-like portion |
| 15 | Bandpass filter |
| 16 | Fluorescent fin member |
| 17 | Reflective mirror |
| 18 | Heat radiation fin |
| 19 | Air hole |
| FCA | First fluorescent area (area A) |
| SCA | Second fluorescent area (area B) |
| TCA | Third fluorescent area (area C) |

**Claims**

1. A light emitting device which is configured having a semiconductor light emitting element and a phosphor layer which has an area A and an area B with different emission spectra, wherein

(i) the semiconductor light emitting element emits light of a wavelength of 350 nm or more and 520 nm or less,
(ii) the area A includes two or more 1Ath phosphor portions and two or more 2Ath phosphor portions, and the area B includes two or more 2Bth phosphor portions and two or more 2Bth phosphor portions,
(iii) the 1Ath phosphor portions and the 2Ath phosphor portions which adjoin one another in the area A are disposed in a direction perpendicular to the thickness direction of the phosphor layer at the interface between the 1Ath and 2Ath phosphor portions, and the 1Ath phosphor portions and the 2Ath phosphor portions which adjoin one another in the area B are disposed in a direction perpendicular to the thickness direction of the phosphor layer at the interface between the 1Ath and 2Ath phosphor portions,
(iv) the 1Ath phosphor portions include a 1Ath phosphor which is able to emit light having a longer wavelength light than the light emitted by the semiconductor light emitting element, by being excited by the light emitted by the semiconductor light emitting element,
(v) the 2Ath phosphor portions include a 2Ath phosphor which is able to emit light having a longer wavelength light than the light emitted by the first phosphor, by being excited by the light emitted by the semiconductor light emitting element,
(vi) the 1Bth phosphor portions include a 1Bth phosphor which is able to emit light having a longer wavelength light than the light emitted by the semiconductor light emitting element, by being excited by the light emitted by the semiconductor light emitting element,
(vii) the 2Bth phosphor portions include a 2Bth phosphor which is able to emit light having a longer wavelength light than the light emitted by the semiconductor light emitting element, by being excited by the light emitted by the semiconductor light emitting element, and

(viii) a proportion of the light which is irradiated onto area A and area B from the semiconductor light emitting element can be adjusted.

2. The light emitting device according to claim 1,
wherein the proportion of the light which is irradiated onto area A and area B from the semiconductor light emitting element can be adjusted by moving the phosphor layer or the semiconductor light emitting element in order to change relative positions of the phosphor layer and the semiconductor light emitting element.

3. The light emitting device according to claim 1 or 2,
wherein the phosphor layer satisfies the condition of formula [1] below when, at a light emission-side face of the light emitting device, the sum total of the surface area occupied by the 1Ath phosphor portions of area A is $S_{A1}$, a sum total of the surface area occupied by the 2Ath phosphor portions of area A is $S_{A2}$, a sum total of the surface area occupied by the 1Bth phosphor portions of area B is $S_{B1}$, and a sum total of the surface area occupied by the 2Bth phosphor portions of area B is $S_{B2}$:

$$S_{A2}/S_{A1} \neq S_{B2}/S_{B1} \ldots [1].$$

4. The light emitting device according to any one of claims 1 to 3,
wherein the phosphor layer satisfies the condition of formula [2] below when a sum total of the thickness of the 1Ath phosphor portions of area A is $T_{A1}$, a sum total of the thickness of the 2Ath phosphor portions of area A is $T_{A2}$, a sum total of the thickness of the 1Bth phosphor portions of area B is $T_{B1}$, and a sum total of the thickness of the 2Bth phosphor portions of area B is $T_{B2}$ :

$$T_{A2}/T_{A1} \neq T_{B2}/T_{B1} \ldots [2].$$

5. The light emitting device according to any one of claims 1 to 4,
wherein, in the phosphor layer, the 1Ath phosphor is of a different type from the 18th phosphor and/or the 2Ath phosphor is of a different type from the 2Bth phosphor.

6. The light emitting device according to any one of claims 1 to 5,
wherein a proportion of the surface area of a part having phosphors of a plurality of types in the thickness direction of the phosphor layer relative to a light emission surface area of the light emitting device is 0% or more and 20% or less.

7. The light emitting device according to any one of claims 1 to 6,
wherein the phosphor layer comprises a light shielding portion and the light shielding portion is disposed between the 1Ath phosphor portion and the 2Ath phosphor portion so as to prevent light, which is emitted from the 1Ath phosphor portion, from entering the 2Ath phosphor portion and/or disposed between the 1Bth phosphor portion and the 2Bth phosphor portion so as to prevent light, which is emitted from the 1Bth phosphor portion, from entering the 2Bth phosphor portion.

8. The light emitting device according to any one of claims 1 to 7,
wherein an area X is further provided between the area A and the area B,

(i) the area X includes two or more 1Xth phosphor portions and two or more 2Xth phosphor portions,
(ii) in the area X, the 1Xth phosphor portions and the 2Xth phosphor portions which adjoin each other are disposed in a direction perpendicular to the thickness direction of the phosphor layer at the interface between the adjoining 1Xth phosphor portions and 2Xth phosphor portions,
(iii) the 1Xth phosphor portions include a 1Xth phosphor which is able to emit light having a longer wavelength light than the light emitted by the semiconductor light emitting element, by being excited by the light emitted by the semiconductor light emitting element,
(iv) the 2Xth phosphor portions include a 2Xth phosphor which is able to emit light having a longer wavelength light than the light emitted by the 1Xth phosphor, by being excited by the light emitted by the semiconductor light emitting element, and

(v) conditions of formulae [3] and [4] below are satisfied when a sum total of the surface area occupied by the 1Xth phosphor portions in the area X is $S_{X1}$, and a sum total of the surface area occupied by the 2Xth phosphor portions in the area X is $S_{X2}$:

$$S_{A2}/S_{A1} \neq S_{X2}/S_{X1} \ldots [3]$$

$$S_{B2}/S_{B1} \neq S_{X2}/S_{X1} \ldots [4].$$

9. The light emitting device according to claim 8,
wherein a phosphor layer is disposed such that, by adjusting a proportion of light which is irradiated onto the area A and the area B from the semiconductor light emitting element, the light emitted by the light emitting device can be adjusted to an optional chromaticity which is located on a straight line, in the chromaticity diagram, linking a chromaticity A ($x_A$, $y_A$) of the light emitted from the area A to a chromaticity X ($x_X$, $y_X$) of the light emitted from the area X, or adjusted to an optional chromaticity which is located on a straight line linking a chromaticity B ($x_B$, $y_B$) of the light emitted from the area B to the chromaticity X ($x_X$, $y_X$) of the light emitted from the area X.

10. The light emitting device according to claim 9,
wherein the chromaticity X ($x_X$, $y_X$) is located on a straight line linking the chromaticity A ($x_A$, $y_A$) to the chromaticity B ($x_B$, $Y_B$).

11. The light emitting device according to claim 9,
wherein the chromaticity X ($x_X$, $y_X$) is not located on a straight line linking the chromaticity A ($x_A$, $y_A$) to the chromaticity B ($X_B$, $Y_B$).

12. The light emitting device according to any one of claims 9 to 11,
wherein the light emitting device is configured having a phosphor layer which is disposed such that, by adjusting a proportion of light which is irradiated onto the area A and the area B from the semiconductor light emitting element, the light emitted by the light emitting device can be adjusted to an optional chromaticity which is located on an optional curve, in the chromaticity diagram, linking a chromaticity A ($x_A$, $y_A$) of the light emitted from the area A, a chromaticity X ($x_X$, $y_X$) of the light emitted from the area X, and a chromaticity B ($x_B$, $y_B$) of the light emitted from the area B.

13. The light emitting device according to claim 12,
wherein, by adjusting the proportion of the light which is irradiated onto the area A and the area B from the semiconductor light emitting element, the chromaticity of the light which is emitted by the light emitting device can be continuously adjusted within a range in which a deviation duv from a black body radiation curve is $-0.02 \leq \text{duv} \leq 0.02$.

14. The light emitting device according to claim 12 or 13,
wherein, by moving the phosphor layer or the semiconductor light emitting element in a direction perpendicular to the thickness direction of the phosphor layer, the chromaticity of the light emitted by the light emitting device can be continuously adjusted along the black body radiation curve.

15. The light emitting device according to any one of claims 1 to 14,
wherein a color temperature of the color emitted by the light emitting device can be adjusted from 2800 K to 6500 K by adjusting the proportion of light irradiated onto the area A and the area B from the semiconductor light emitting element.

16. The light emitting device according to any one of claims 1 to 15,
wherein a distance between the semiconductor light emitting element and the phosphor layer is 1 mm or more and 500 mm or less.

17. The light emitting device according to any one of claims 1 to 16, further comprising:

on the light emission side of the light emitting device of the phosphor layer, a bandpass filter which reflects at least a portion of the light emitted by the semiconductor light emitting element and transmits at least a portion of the light emitted by the phosphor.

18. The light emitting device according to any one of claims 1 to 17, further comprising:

on the semiconductor light emitting element side of the phosphor layer, a bandpass filter which transmits at least a portion of the light emitted by the semiconductor light emitting element and reflects at least a portion of the light emitted by the phosphor.

19. The light emitting device according to any one of claims 1 to 18, further comprising:

a substrate on which the semiconductor light emitting element is disposed; and
a cylindrical housing member which houses the substrate,
wherein
the phosphor layer is disposed on at least a portion of the housing member,
the housing member is provided turnably about the center axis thereof in a state where the substrate is immobile,
in the phosphor layer, the area A and the area B are disposed in different positions in a peripheral direction of the housing member, and
the proportion of light irradiated onto the area A and the area B from the semiconductor light emitting element can be adjusted by adjusting a relative turn position of the housing member relative to the substrate.

20. The light emitting device according to claim 19,
wherein the area A and the area B divide the phosphor layer in a peripheral direction and are disposed as areas along a center axis direction of the housing member.

21. The light emitting device according to claim 19 or 20,
wherein the phosphor layer is disposed over the whole circumference of the housing member.

22. The light emitting device according to any one of claims 19 to 21,
wherein the semiconductor light emitting element is disposed on both faces of the substrate so as to hold the substrate from both sides, and, in the phosphor layer, phosphor layers having mutually identical emission spectra are disposed in symmetrical areas, with the center axis of the housing member between both sides of the symmetrical areas.

23. The light emitting device according to claim 22,
wherein a reflective member is provided on the outside of the housing member such that the light emitted from the housing member which corresponds to the semiconductor light emitting element disposed on one face of the substrate is reflected toward the emission area of the emitted light which corresponds to the semiconductor light emitting element disposed on the other face of the substrate.

24. The light emitting device according to any one of claims 19 to 21,
wherein the semiconductor light emitting element is disposed only on one of the faces of the substrate, and, in a housing space of the housing member, a heat radiation member for radiating the heat of the semiconductor light emitting element is disposed in thermal contact with the other face of the substrate, in a space which the other face of the substrate faces.

25. The light emitting device according to any one of claims 19 to 24, wherein
the housing member has a cylindrical shape, and
in a case where the semiconductor light emitting element disposed on the substrate is disposed eccentric to the center axis of the housing member, the semiconductor light emitting element is provided to reduce an angle formed between a normal direction of a virtual ground plane at a point of intersection between the irradiation center direction of the light emitted by the semiconductor light emitting element and the phosphor layer, and the irradiation center direction.

26. The light emitting device according to claim 25, wherein, on the substrate, a cross-section orthogonal to the center axis of the housing member has a bent plate shape or arc shape.

Fig. 1-1

Fig. 1−2

Fig. 1-3

4a                    4b

ON          OFF

4a              4b

OFF          ON

# Fig. 1−4

(a)

4a  4b

ON  OFF

(c)

4a  4b

OFF  ON

(b)

4a  4b

OFF  ON  OFF

Fig. 1−5

Fig. 2

Fig. 3

(a) SURFACE MOUNT-TYPE

(b) SHELL-TYPE

(c) REFLECTIVE-TYPE

# Fig. 4

FIRST PHOSPHOR PORTION 6a → ← SECOND PHOSPHOR PORTION 6b

FIRST PHOSPHOR 7a

SECOND PHOSPHOR 7b

PHOSPHOR LAYER 4

PART WHERE PHOSPHORS OF A PLURALITY
OF TYPES EXIST IN THE THICKNESS
DIRECTION OF THE PHOSPHOR LAYER

# Fig. 5−1

FIRST PHOSPHOR PORTION 6a ⟶|⟵ SECOND PHOSPHOR PORTION 6b

FIRST PHOSPHOR 7a

SECOND PHOSPHOR 7b

PHOSPHOR LAYER 4

PART WHERE PHOSPHORS OF
A PLURALITY OF TYPES EXIST
IN THE THICKNESS DIRECTION
OF THE PHOSPHOR LAYER

# Fig. 5-2

FIRST PHOSPHOR PORTION 6a ──────────▶

SECOND PHOSPHOR
PORTION 6b

FIRST PHOSPHOR 7a

LIGHT SHIELDING
PORTION

SECOND PHOSPHOR 7b

PHOSPHOR LAYER 4

PART WHERE PHOSPHORS OF A PLURALITY
OF TYPES EXIST IN THE THICKNESS DIRECTION
OF THE PHOSPHOR LAYER DOES NOT EXIST

Fig. 5-3

(a)

(b)

(c)

THIRD PHOSPHOR
PORTION (BLUE COLOR)

SECOND PHOSPHOR
PORTION (RED COLOR)

FIRST PHOSPHOR
PORTION (GREEN COLOR)

(d)

(e)

(f)

KEY FOR FIG. 6 (a) ~ (f):

REPRESENTS FIRST PHOSPHOR PORTION (GREEN COLOR)

REPRESENTS SECOND PHOSPHOR PORTION (RED COLOR)

REPRESENTS THIRD PHOSPHOR PORTION (BLUE COLOR)

# Fig. 6

(a)  (b)  (c)

(d)  (e)  (f)

KEY FOR FIG. 7 (a) ~ (d):

⊞ REPRESENTS FIRST PHOSPHOR PORTION (GREEN COLOR)

◪ REPRESENTS SECOND PHOSPHOR PORTION (RED COLOR)

⬚ REPRESENTS THIRD PHOSPHOR PORTION (BLUE COLOR)

# Fig. 7

(a)

(b)

FIRST PHOSPHOR
PORTION (BLUE COLOR)

SECOND PHOSPHOR
PORTION (YELLOW COLOR)

(c)

(d)

(e)

KEY FOR FIG. 8 (a) ~ (e):

REPRESENTS FIRST PHOSPHOR PORTION (BLUE COLOR)

REPRESENTS SECOND PHOSPHOR PORTION (YELLOW COLOR)

# Fig. 8

(a)

(b)

(c)

(d)

KEY FOR FIG. 9 (a) ~ (d):

REPRESENTS FIRST PHOSPHOR PORTION (BLUE COLOR)

REPRESENTS SECOND PHOSPHOR PORTION (YELLOW COLOR)

# Fig. 9

LIGHT SHIELDING PORTION
(REFLECTIVE MATERIAL)

LIGHT SHIELDING PORTION
(REFLECTIVE MATERIAL)

THIRD PHOSPHOR PORTION
(BLUE COLOR)

SECOND PHOSPHOR PORTION
(RED COLOR)

FIRST PHOSPHOR PORTION
(GREEN COLOR)

# Fig. 10

FIRST PHOSPHOR
PORTION

(a)

SECOND PHOSPHOR
PORTION

AREA A              AREA X         AREA B

(SMALL SURFACE AREA OF         (LARGE SURFACE AREA OF
FIRST PHOSPHOR PORTION)        FIRST PHOSPHOR PORTION)

(b)                                              (c)

AREA A              AREA X         AREA B

(SMALL SURFACE AREA OF         (LARGE SURFACE AREA OF
FIRST PHOSPHOR PORTION)        FIRST PHOSPHOR PORTION)

# Fig. 11

(a)

FIRST PHOSPHOR
PORTION (BLUE COLOR)

SECOND PHOSPHOR
PORTION
(YELLOW COLOR)

AREA A
(SMALL SURFACE AREA OF
FIRST PHOSPHOR PORTION)

AREA X

AREA B
(LARGE SURFACE AREA OF
FIRST PHOSPHOR PORTION)

(b)

FIRST PHOSPHOR
PORTION (GREEN COLOR)

THIRD PHOSPHOR
PORTION
(BLUE COLOR)

SECOND PHOSPHOR
PORTION
(RED COLOR)

AREA A
(SMALL SURFACE AREA OF
FIRST PHOSPHOR PORTION)

AREA X

AREA B
(LARGE SURFACE AREA OF
FIRST PHOSPHOR PORTION)

(c)

(d)

KEY FOR FIG. 12 (a) ~ (d):

REPRESENTS FIRST PHOSPHOR PORTION (GREEN COLOR)

REPRESENTS SECOND PHOSPHOR PORTION (RED COLOR)

REPRESENTS THIRD PHOSPHOR PORTION (BLUE COLOR)

REPRESENTS LIGHT SHIELDING PORTION OR TRANSPARENT SUBSTRATE

# Fig. 12

REPRESENTS FIRST PHOSPHOR PORTION

REPRESENTS SECOND PHOSPHOR PORTION

Fig. 13−1

(a)

FIRST PHOSPHOR PORTION

LIGHT EMISSION AREA

SECOND PHOSPHOR PORTION

AREA A    AREA X    AREA B

(b)

LIGHT EMISSION AREA

AREA A    AREA X    AREA B

(c)

LIGHT EMISSION AREA

AREA A    AREA X    AREA B

Fig. 13−2

Fig. 14-1

Fig. 15

Fig. 16

Fig. 17

Fig. 18

【図１９】

(a)

180°
(6 O'CLOCK)

11

142

SCA

14

CA    13

90°
(3 O'CLOCK)

270°
(9 O'CLOCK)

12

FCA

Dc

0°
(12 O'CLOCK)

(b)

0°
(12 O'CLOCK)

11

142

14

FCA

CA    13

270°
(9 O'CLOCK)

90°
(3 O'CLOCK)

12

SCA

Dc

SCA

180°
(6 O'CLOCK)

Fig. 19

61

Fig. 20

Fig. 21−1

Fig. 21-2

Fig. 21-3

Fig. 21−4

Fig. 21-5

Fig. 22

Fig. 23

Fig. 24

Fig. 25−1

Fig. 25-2

Fig. 26

Fig. 27

Fig. 28

Fig. 29

Fig. 30

## INTERNATIONAL SEARCH REPORT

| | International application No. |
|---|---|
| | PCT/JP2011/057976 |

**A. CLASSIFICATION OF SUBJECT MATTER**
*H01L33/50*(2010.01)i

According to International Patent Classification (IPC) or to both national classification and IPC

**B. FIELDS SEARCHED**

Minimum documentation searched (classification system followed by classification symbols)
H01L33/00-33/64, F21V1/00-15/06

Documentation searched other than minimum documentation to the extent that such documents are included in the fields searched

| Jitsuyo Shinan Koho | 1922-1996 | Jitsuyo Shinan Toroku Koho | 1996-2011 |
|---|---|---|---|
| Kokai Jitsuyo Shinan Koho | 1971-2011 | Toroku Jitsuyo Shinan Koho | 1994-2011 |

Electronic data base consulted during the international search (name of data base and, where practicable, search terms used)

**C. DOCUMENTS CONSIDERED TO BE RELEVANT**

| Category* | Citation of document, with indication, where appropriate, of the relevant passages | Relevant to claim No. |
|---|---|---|
| X | JP 2009-245712 A (Stanley Electric Co., Ltd.), 22 October 2009 (22.10.2009), | 1-3,6,8-12, 15 |
| Y | paragraphs [0020] to [0031]; fig. 4, 5 (Family: none) | 4,5,7,13,14, 16-26 |
| X | JP 2007-026749 A (Mitsubishi Electric Corp.), 01 February 2007 (01.02.2007), | 1,2,5,6,15 |
| Y | paragraphs [0028], [0029]; fig. 5, 6 (Family: none) | 3,4,7-14, 16-26 |
| Y | WO 2009/045922 A2 (INTEMATIX CORP.), 09 April 2009 (09.04.2009), fig. 1 & US 2009/0086475 A1 & CN 101842907 A & KR 10-2010-0099102 A | 4-26 |

☒ Further documents are listed in the continuation of Box C.　　☐ See patent family annex.

| * | Special categories of cited documents: | "T" | later document published after the international filing date or priority date and not in conflict with the application but cited to understand the principle or theory underlying the invention |
|---|---|---|---|
| "A" | document defining the general state of the art which is not considered to be of particular relevance | | |
| "E" | earlier application or patent but published on or after the international filing date | "X" | document of particular relevance; the claimed invention cannot be considered novel or cannot be considered to involve an inventive step when the document is taken alone |
| "L" | document which may throw doubts on priority claim(s) or which is cited to establish the publication date of another citation or other special reason (as specified) | "Y" | document of particular relevance; the claimed invention cannot be considered to involve an inventive step when the document is combined with one or more other such documents, such combination being obvious to a person skilled in the art |
| "O" | document referring to an oral disclosure, use, exhibition or other means | | |
| "P" | document published prior to the international filing date but later than the priority date claimed | "&" | document member of the same patent family |

| Date of the actual completion of the international search | Date of mailing of the international search report |
|---|---|
| 14 April, 2011 (14.04.11) | 26 April, 2011 (26.04.11) |

| Name and mailing address of the ISA/ | Authorized officer |
|---|---|
| Japanese Patent Office | |
| Facsimile No. | Telephone No. |

Form PCT/ISA/210 (second sheet) (July 2009)

**INTERNATIONAL SEARCH REPORT**

| International application No. |
| --- |
| PCT/JP2011/057976 |

C (Continuation).   DOCUMENTS CONSIDERED TO BE RELEVANT

| Category* | Citation of document, with indication, where appropriate, of the relevant passages | Relevant to claim No. |
| --- | --- | --- |
| Y | JP 2009-060094 A  (Toshiba Lighting & Technology Corp.), 19 March 2009 (19.03.2009), paragraphs [0044], [0055], [0056]; fig. 1, 2 (Family: none) | 7-26 |
| Y | JP 2007-066939 A  (Matsushita Electric Industrial Co., Ltd.), 15 March 2007 (15.03.2007), fig. 1 (Family: none) | 16-26 |
| Y | JP 2008-010518 A  (Citizen Holdings Co., Ltd.), 17 January 2008 (17.01.2008), paragraphs [0068] to [0075]; fig. 2 (Family: none) | 17-26 |
| Y | JP 2005-294288 A  (Mitsubishi Cable Industries, Ltd.), 20 October 2005 (20.10.2005), paragraphs [0021], [0022], [0044] to [0047]; fig. 9 (Family: none) | 17-26 |
| Y | JP 2009-016058 A  (Toshiba Lighting & Technology Corp.), 22 January 2009 (22.01.2009), fig. 11; paragraphs [0084] to [0088] (Family: none) | 19-26 |
| Y | JP 11-266035 A  (Sanyo Electric Co., Ltd.), 28 September 1999 (28.09.1999), paragraphs [0082] to [0090]; fig. 8 (Family: none) | 23-26 |
| Y | JP 2006-128562 A  (Nikon Corp.), 18 May 2006 (18.05.2006), paragraphs [0020] to [0022]; fig. 4, 5 & US 2008/0158854 A1     & EP 1808640 A1 & WO 2006/049104 A1     & CN 1993580 A | 23-26 |
| Y | JP 2009-032511 A  (Sharp Corp.), 12 February 2009 (12.02.2009), paragraphs [0034] to [0041]; fig. 7 to 9 & WO 2008/136458 A1 | 26 |

Form PCT/ISA/210 (continuation of second sheet) (July 2009)

**EP 2 555 261 A1**

## REFERENCES CITED IN THE DESCRIPTION

*This list of references cited by the applicant is for the reader's convenience only. It does not form part of the European patent document. Even though great care has been taken in compiling the references, errors or omissions cannot be excluded and the EPO disclaims all liability in this regard.*

**Patent documents cited in the description**

- JP 2009245712 A
- WO 2009072043 A
- US 7524437 B
- WO 2007088966 A
- WO 2007105631 A
- JP 2008135539 A